# EUROPEAN PATENT APPLICATION

(11) **EP 4 624 509 A1**
(43) Date of publication of application: **01.10.2025**
(21) Application number: 25165974.4
(22) Date of filing: 25.03.2025
(51) Int. Cl.: C08G 61/02, H10K 85/00

(54) **POLYMERIC COMPOUND, ELECTROLUMINESCENCE DEVICE MATERILAL AND LIQUID COMPOSITION INCLUDING THE POLYMERIC COMPOUND, AND ELECTROLUMINESCENCE DEVICE INCLUDING THE MATERIAL**

(30) Priority: 26.03.2024 JP 2024049468; 06.01.2025 KR 20250001767
(71) Applicant: Samsung Electronics Co., Ltd., Suwon-si, Gyeonggi-do 16677 (KR)
(72) Inventor: TSUJI, Masashi, 16678 Suwon-si (KR); KATO, Fumiaki, 16678 Suwon-si (KR); SUGANUMA, Naotoshi, 16678 Suwon-si (KR); ISHII, Norihito, 16678 Suwon-si (KR); CHA, SOONMIN, 16678 Suwon-si (KR); FUJIYAMA, Takahiro, 16678 Suwon-si (KR); YOON, Won Sik, 16678 Suwon-si (KR); KONISHI, Yusaku, 16678 Suwon-si (KR); KIKUCHI, Tomoyuki, 16678 Suwon-si (KR)
(74) Representative: Elkington and Fife LLP

(57) **Abstract**

A polymer compound including a structural unit (A) represented by Chemical Formula 1 as described. In Chemical Formula 1, Ar¹, Ar², Ar¹¹, Ar¹², X¹, Y¹, and L¹ are each independently as described in the specification. An electroluminescence device including a first electrode, a second electrode, and at least one layer of an organic film between the first electrode and the second electrode, the at least one layer of an organic film comprises the polymeric compound.

## Description

### FIELD OF THE INVENTION

A polymeric compound, an electroluminescence device material including the polymeric compound, and a liquid composition including the polymeric compound.

### BACKGROUND OF THE INVENTION

Research and development of electroluminescence devices (EL devices) are actively progressing. In particular, EL devices may be expected to be used as a solid light-emitting type large area full color display device or a writing light source array. An EL device is a light emitting device including a thin film having a thickness of several nanometers to several hundred nanometers between an anode and a cathode. The EL devices usually include a hole transport layer, a light emitting layer, an electron transport layer, or the like.

Among these, the light emitting layer includes a fluorescent light emitting material and/or a phosphorescent light emitting material. The phosphorescent light emitting material is a material expected to have a higher luminous efficiency than the fluorescent light emitting material. In addition, for covering a wide color gamut, an RGB light source requires an emission spectrum having a narrow full width at half maximum (FWHM). For example, although deep blue is of particular interest for blue, there are currently no devices found to have a long life-span and satisfy the viewpoint of color purity.

As a method of solving the problems, there is a light emitting device using "quantum dot" which is an inorganic light emitting material as a light emitting material (See, Patent Document 1). Quantum dots (QD) are semiconductor materials having crystal structures of several nanometers in size and are made up of hundreds to thousands of atoms. Because quantum dots are very small in size, a surface area per unit volume is large. For this reason, most of the atoms are present on the surface of the nanocrystals, and exhibit quantum confinement effects. Due to the quantum confinement effect, a quantum dot is able to adjust the emission wavelength by adjusting its size. Quantum dots have gained wide attention because characteristics such as improved color purity and high photoluminescence (PL) luminous efficiency can be achieved. A quantum dot electroluminescence device (QD LED) is a three-layered device including a hole transport layer, a quantum dot light emitting layer, and an electron transport layer.

In order to improve the characteristics of such quantum dot electroluminescence devices, techniques for improving the hole transport properties and hole injection properties of hole transport materials have been proposed. For example, Patent Document 2 proposes arylamine-fluorene alternating copolymer (polymeric compound) having a hydrocarbon group in the side chain as a hole transport material.
[Patent Document 1] Japanese Patent Laid-Open Publication No. 2010-199067
[Patent Document 2] Japanese Patent Laid-Open Publication No. 2021-138915

### SUMMARY OF THE INVENTION

A technology capable of achieving a good balance between durability (e.g., luminescence life-span) and luminous efficiency of an electroluminescence device (e.g., a quantum dot electroluminescence device). The inventors have found that the above problem can be solved by using a polymeric compound having a specific structure.

Accordingly, an embodiment provides a polymeric compound including a structural unit (A) represented by Chemical Formula 1:

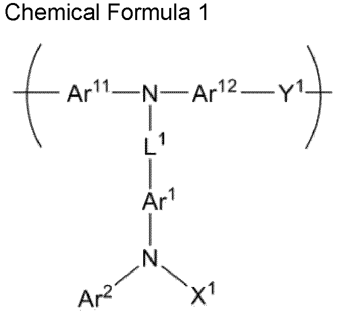

In Chemical Formula 1,
Ar¹¹ and Ar¹² are each independently a substituted or unsubstituted aromatic hydrocarbon group having 6 to 25 ring-forming atoms,
Ar¹¹ and Ar¹² are optionally linked to each other to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
X¹ is a substituted or unsubstituted aromatic hydrocarbon group having 6 to 25 ring-forming atoms, or a substituted or unsubstituted heteroaromatic group having 5 to 25 ring-forming atoms, and
Y' is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms.

An electroluminescence device (e.g., a quantum dot electroluminescence device) can have a good balance of durability (e.g., luminescence life-span) and luminous efficiency. The device according to an embodiment includes at least one layer of an organic film including the polymeric compound of chemical formula 1.

A liquid composition comprising the polymeric compound of chemical formula 1 and a solvent.

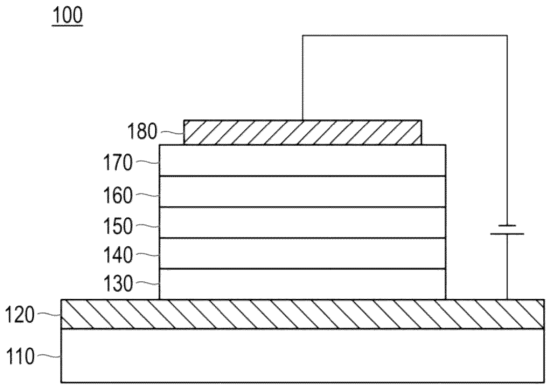

### BRIEF DESCRIPTION OF THE DRAWING

The Figure is a schematic view showing an electroluminescence device according to an embodiment.

### DETAILED DESCRIPTION OF THE EMBODIMENTS

According to the arylamine-fluorene alternating copolymer disclosed in Patent Document 2, the hole injection property of the hole transport material is improved, durability (especially, luminescence life-span) is improved, and sufficient luminous efficiency is also achieved. Yet, there remains a demand for a technology that can further improve durability (especially luminescence life-span), as well as luminous efficiency, with a good balance, compared to the electroluminescence devices (particularly, quantum dot electroluminescence devices) using the hole transport material disclosed in Patent Document 2.

An embodiment provides a polymeric compound including a structural unit (A) represented by Chemical Formula 1:

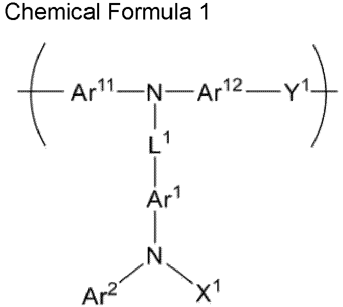

In Chemical Formula 1,
Ar¹¹ and Ar¹² are each independently a substituted or unsubstituted aromatic hydrocarbon group having 6 to 25 ring-forming atoms,
Ar¹¹ and Ar¹² are optionally linked to each other to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
X¹ is a substituted or unsubstituted aromatic hydrocarbon group having 6 to 25 ring-forming atoms, or a substituted or unsubstituted heteroaromatic group having 5 to 25 ring-forming atoms, and
Y' is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms.

In this specification, structural unit (A) represented by Chemical Formula 1 is at times referred to as "structural unit (A)" or "structural unit (A) according to an embodiment."

The structural unit (A) represented by Chemical Formula 1 includes unit portion X represented by the following structure: 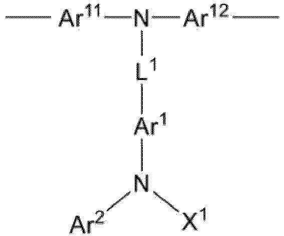 The structural unit (A) represented by Chemical Formula 1 also includes unit portion Y, which corresponds to the structure "-Y¹-" in Chemical Formula 1.

The polymeric compound having structural unit (A) represented by Chemical Formula 1 is at times referred to as "polymeric compound" or "polymeric compound according to an embodiment."

According to another embodiment, an electroluminescence device material including the polymeric compound according to an embodiment is provided.

According to another embodiment, a liquid composition including a polymeric compound according to an embodiment and at least a solvent is provided.

According to another embodiment, an electroluminescence device including a first electrode, a second electrode, and one or more layers of organic film between the first electrode and the second electrode, wherein at least one layer of the organic film includes the polymeric compound according to an embodiment.

As used herein, the electroluminescence device is at times referred to as "LED."

The quantum dot electroluminescence device is at times referred to simply as "QLEDs."

The perovskite electroluminescence devices are at times referred to as "PeLEDs."

By such a configuration, it is possible to provide an electroluminescence device, for example, a quantum dot electroluminescence device, which can achieve a good balance between durability, for example, luminescence life-span-span (for example, LT₅₀), and luminous efficiency, for example, EQEₘₐₓ.

As materials constituting the light emitting layer or carrier transport layer of an electroluminescence device, various low-molecular materials and polymeric materials are used. Among these, low-molecular materials may be superior in terms of device efficiency and life-span. However, when using low-molecular materials, there is a problem of high manufacturing costs because the device needs to be manufactured using a vacuum process. For example, polymeric materials, TFB of Patent Document 1 (e.g., paragraph "0037") and arylamine-fluorene alternating copolymer of Patent Document 2 are known as hole transport materials. However, the TFB of Patent Document 1 cannot be said to have sufficiently long durability (luminescence life-span), and the arylamine-fluorene alternating copolymer of Patent Document 2, though the polymer certainly exhibits excellent durability, the polymer cannot be said to have sufficient luminous efficiency and there are no technical options for improvement. Accordingly, the inventors have conducted careful studies for achieving a good balance between the above-mentioned display device properties, that is, durability (luminescence life-span) as well as luminous efficiency.

Described herein is an electroluminescence device that includes a polymeric compound having a structural unit (A) represented by Chemical Formula 1, for which durability (luminescence life-span) and luminous efficiency are demonstrated to be well balanced compared to a known material (for example, a polymeric material disclosed in Patent Document 2. In addition, by applying the polymeric compound to an electroluminescence device, it was discovered that sufficient luminous efficiency and luminescence life-span can be achieved while maintaining a certain level of low driving voltage.

A structural/electronic mechanism that may explain the-mentioned effect follows. The mechanistic model proposed in no way is to be used to further limit the scope of the claims and is only presented here so that a person of ordinary skill can best understand the technical characteristics or features of the polymeric compounds and the application of such polymers in an electroluminescent device and the demonstrated technical achievements or improvements in the device.

According to an embodiment, the polymeric compound has a thiol group in the unit portion Y, i.e., the structural unit Y' of Chemical Formula 1. In particular, if a polymeric compound according to an embodiment is included in a hole transport layer, it is believed that the thiol group may coordinate or bond to a light emitting material included in a light emitting layer adjacent to the hole transport layer, for example, the thiol group may coordinate or bond to a metal atom included in a quantum dot or a perovskite-type compound. As a result, the arrangement or connectivity of the quantum dots or perovskite-type compounds present at the interface with the hole transport layer may provide an enhancement in hole transport, and the hole injection property is improved by arranging the light emitting material at a high density. Therefore, an electroluminescence device, for example, a quantum dot electroluminescence device, using the polymeric compound according to an embodiment, can be expected to exhibit high durability (luminescence life-span) and also achieve excellent luminescent efficiency.

In addition, because the polymeric compound has excellent film forming properties and solvent solubility, it is possible to deposit an organic film using a wet (coating) method, which in turn makes it possible to enlarge the area of the electroluminescence device and achieve high productivity. The above effect may be effectively exhibited when the polymeric compound is applied to an electroluminescent device, particularly a hole transport layer or a hole injection layer of a QLED.

The present disclosure is not limited to the following embodiments. The drawing is exaggerated for better understanding and ease of description, and the dimensional ratio of each constituent element in the drawing may differ from reality. It will be understood that when an element is referred to as being "on" another element, it can be directly on the other element or intervening elements may be present therebetween. In contrast, when an element is referred to as being "directly on" another element, there are no intervening elements present.

The terminology used herein is for the purpose of describing particular embodiments only and is not intended to be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements.

"At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10% or ±5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In this specification, unless otherwise specified, operation and physical properties are measured under the conditions of room temperature, such as, for example, 20°C or more and 25°C or less, and relative humidity (RH) of 40% or more and 50% or less.

In this specification, the number of ring-forming atoms refers to the number of atoms constituting the corresponding ring itself of the compound (e.g., monocyclic compound, condensed ring compound, crosslinked compound, carbocyclic compound, and heterocyclic compound) having a structure in which atoms are bonded in a ring (e.g., monocycle, condensed ring, ring assembly, etc.). Atoms that do not form a ring (e.g., a hydrogen atom that terminates the bond of the atoms forming a ring) or atoms included in a substituent, e.g., if a ring-forming atom includes a substituent are not included in the number of ring-forming atoms. The number of ring-forming atoms described below is assumed to be the same unless otherwise specified.

For example, a benzene ring has 6 ring-forming atoms, a naphthalene ring has 10 ring-forming atoms, a pyridine ring has 6 ring-forming atoms, and a furan ring has 5 ring-forming atoms.

When the benzene ring is substituted with a substituent, for example, an alkyl group, the number of carbon atoms of the alkyl group is not included in the number of ring-forming atoms of the benzene ring. Accordingly, the number of ring-forming atoms of the benzene ring substituted by the alkyl group is 6. In addition, when the naphthalene ring is substituted with an alkyl group as a substituent, for example, the number of atoms of the alkyl group is not included in the number of ring-forming atoms of the naphthalene ring. Accordingly, the number of ring-forming atoms of the naphthalene ring substituted by the alkyl group is 10.

For example, the number of hydrogen atoms bonded to the pyridine ring or the atoms constituting the substituent is not included in the number of ring-forming atoms of the pyridine ring. Accordingly, the number of ring-forming atoms of the pyridine ring to which the hydrogen atom or substituent is bonded is 6.

In the present specification, "the substituent represents a hydrogen atom" indicates that the structure in which the substituent exists is unsubstituted. For example, in Chemical Formula 1-1, when R¹¹ to R¹⁴ are all hydrogen atoms, it means that the benzene ring having R¹¹ to R¹⁴ is a p-phenylene group.

In the present specification, unless specifically defined, the term "substituted" refers to being substituted with an alkyl group, a cycloalkyl group, a hydroxyalkyl group, an alkoxy group, an alkoxyalkyl group, a cycloalkoxy group, an alkenyl group, an alkynyl group, a primary amino group (-NH₂), a secondary amino group -NH(R¹): R¹ is an alkyl group or an aryl group), a tertiary amino group (-N(R¹)(R²): R¹ and R² are each independently an alkyl group or an aryl group, and in this case, R¹ and R² may form a ring), an aryl group, an aryloxy group, an alkylthio group, a cycloalkylthio group, an arylthio group, an alkoxycarbonyl group, an aryloxycarbonyl group, a hydroxy group (-OH), a carboxyl group (-COOH), a thiol group (-SH), a cyano group (-CN), a halogen atom (a fluorine atom, a chlorine atom, a bromine atom, or an iodine atom), or a combination thereof. On the other hand, when a group is substituted, the form of the group which is included in the definition of a substituent does not include a form which has been further substituted with the group as a substituent. For example, when the substituent is an alkyl group, this alkyl group as a substituent is not further substituted with an alkyl group.

Herein, the alkyl group as the substituent may be either a linear or branched alkyl group, for example a linear alkyl group having 1 to 20 carbon atoms or a branched alkyl group having 3 to 20 carbon atoms. Specifically, the alkyl group may be a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptyl group, a 1,4-dimethylpentyl group, a 3-ethylpentyl group, a 2-methyl-1-isopropylpropyl group, a 1-ethyl-3-methylbutyl group, an n-octyl group, a 2-ethylhexyl group, a 3-methyl-1-isopropylbutyl group, a 2-methyl-1-isopropylbutyl group, a 1-tert-butyl-2-methylpropyl group, an n-nonyl group, a 3,5,5-trimethylhexyl group, an n-decyl group, an isodecyl group, an n-undecyl group, a 1-methyldecyl group, an n-dodecyl group, an n-tridecyl group, an n-tetradecyl group, an n-pentadecyl group, an n-hexadecyl group, an n-heptadecyl group, an n-octadecyl group, an nonadecyl group, an icosyl group, and the like.

As the substituent, the cycloalkyl group may include for example, a cyclopropyl group, a cyclobutyl group, a cyclopentyl group, and a cyclohexyl group.

The hydroxyalkyl group may be, for example, an alkyl group that is substituted with 1 to 3 (e.g., 1 or 2, and for example 1) hydroxy groups (for example, hydroxymethyl group, hydroxyethyl group).

The alkoxy group as the substituent may be either a linear or branched alkoxy group, but desirably a linear alkoxy group having 1 to 20 carbon atoms or a branched alkoxy group having 3 to 20 carbon atoms. For example, the alkoxy group may be, for example, a methoxy group, an ethoxy group, a propoxy group, an isopropoxy group, a butoxy group, a pentyloxy group, a hexyloxy group, a heptyloxy group, an octyloxy group, a nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a 2-ethylhexyloxy group, a 3-ethylpentyloxy group, and the like.

The hydroxyalkyl group may be, for example, an alkyl group that is substituted with 1 to 3 (e.g., 1 or 2, and for example 1) hydroxy groups (for example, hydroxymethyl group, hydroxyethyl group).

The cycloalkoxy group as a substituent may be, for example, a cyclopropyl oxy group, a cyclobutyl oxy group, a cyclopentyl oxy group, a cyclohexyl oxy group, and the like.

The alkenyl group as a substituent may include, for example, a vinyl group, an allyl group, a 1-propenyl group, an isopropenyl group, a 1-butenyl group, a 2-butenyl group, a 3-butenyl group, a 1-pentenyl group, a 2-pentenyl group, a 3-pentenyl group , a 1-hexenyl group, a 2-hexenyl group, a 3-hexenyl group, a 1-heptenyl group, a 2-heptenyl group, a 5-heptenyl group, a 1-octenyl group, a 3-octenyl group, a 5-octenyl group, and the like.

The alkynyl group as a substituent may include, for example, an acetylenyl group, a 1-propynyl group, a 2-propynyl group, a 1-butynyl group, a 2-butynyl group, a 3-butynyl group, a 1-pentetyl group, a 2-pentetyl group, a 3-pentetyl group , 1-hexynyl group, a 2-hexynyl group, a 3-hexynyl group, a 1-heptinyl group, a 2-heptinyl group, a 5-heptinyl group, a 1-octynyl group, a 3-octynyl group, a 5-octynyl group, and the like.

The secondary amino groups as a substituent may include, for example, an alkylamino group having 1 to 10 carbon atoms such as a methylamino group, an ethylamino group, an n-propylamino group, an n-butylamino group, an isobutylamino group, and the like, and a monoarylamino group such as a monophenylamino group, a mononaphthylamino group, and the like.

The tertiary amino group as a substituent may include, for example, a dialkylamino group having 2 to 20 carbon atoms, such as a dimethylamino group, a diethylamino group, a di-n-propylamino group, a di-n-butylamino group, and a methylethylamino group, and a diarylamino group, such as a diphenylamino group and a dinaphthylamino group.

The aryl group as a substituent may be an aryl group having 6 to 30 ring-forming atoms (carbon atoms) may be exemplified. Examples may include a phenyl group, a naphthyl group, a biphenyl group, a fluorenyl group, anthryl group, a pyrenyl group, an azulenyl group, an acenaphthylenyl group, a diphenyl group, and a phenanthryl group.

Examples of the aryloxy group as a substituent may include a phenoxy groups and a naphthyloxy group.

Examples of the alkylthio group as a substituent may include a methylthio group, an ethylthio group, a propylthio group, a pentylthio group, a hexylthio group, an octylthio group, and a dodecylthio group.

Examples of the cycloalkylthio group as a substituent may include a cyclopentylthio group, a cyclohexylthio group, etc.

Examples of the arylthio group as a substituent may include a phenylthio group and a naphthylthio group.

Examples of the alkoxycarbonyl group as a substituent may include a methyloxycarbonyl group, an ethyloxycarbonyl group, a butyloxycarbonyl group, an octyloxycarbonyl group, and a dodecyloxycarbonyl group.

Examples of aryloxycarbonyl groups as a substituent may include a phenyloxycarbonyl group and a naphthyloxycarbonyl group.

The term "aromatic hydrocarbon group" refers to a hydrocarbon having an aromatic ring and includes monocyclic and polycyclic hydrocarbons wherein the additional ring(s) of the polycyclic hydrocarbon may be aromatic or nonaromatic.

The term "heteroaromatic group" refers to an aromatic ring and includes monocyclic and polycyclic ring systems wherein one to three aromatic ring atoms is selected from N, O, S, Si, and P, and additional ring(s) of the polycyclic ring system may be aromatic or nonaromatic.

### Polymeric Compound and Structural unit (A)

A polymeric compound according to an embodiment includes a structural unit (A) represented by Chemical Formula 1. There are two or more structural units (A) in a polymeric compound, that is, the structural unit (A) represented by Chemical Formula 1 may be a repeating unit. A polymeric compound having a structural unit (A) has excellent hole injection properties into quantum dots, etc., and may improve the durability (luminescence life-span) of an electroluminescence device. In addition, high current efficiency and low driving voltage may be achieved, and/or luminous efficiency may be improved. The polymeric compound according to an embodiment may include only one type of structural unit (A) or may include two or more different types of structural units (A). The plurality of structural units (A) may exist in a block form, a random form, an alternating form, or a periodic form.

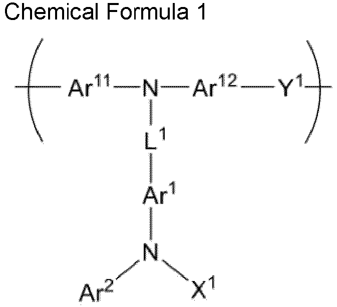

The structural unit A of Chemical Formula 1, includes a unit portion X formed by a nitrogen atom being sandwiched between the two aromatic hydrocarbon groups Ar¹¹ and Ar¹², and a unit portion Y represented by Y¹. In other words, the polymeric compound according to an embodiment may be referred to as a copolymer including a portion unit X and a portion unit Y.

In Chemical Formula 1, Y' may be a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms.

In structural unit (A) according to an embodiment, Y¹ may have a thiol group-containing alkyl group having 1 to 14 carbon atoms (an alkyl group having 1 to 14 carbon atoms having a thiol group), or a thiol group-containing alkoxyalkyl group having 2 to 14 carbon atoms (an alkoxyalkyl group having 2 to 14 carbon atoms having a thiol group). In addition, Y¹ may have both a thiol group-containing alkyl group having 1 to 14 carbon atoms and a thiol group-containing alkoxyalkyl group having 2 to 14 carbon atoms. It is believed that if the polymeric compound is used as a hole transport material of an electroluminescence device, the polymeric compound can strongly coordinate or bond to a light emitting material such as a quantum dot or a perovskite-type compound in the light emitting layer, and thereby, effectively increase the concentration of the light emitting material included in the light emitting layer at or near the interface with the hole transport layer. Because the light emitting material may be present at a relatively higher density (concentration) in the light emitting layer at the interface adjacent to the hole transport layer, it is believed that durability (luminescence life-span) and luminous efficiency can be well balanced.

A thiol group-containing alkyl group having 1 to 14 carbon atoms is at times referred to as a "thiol group-containing alkyl group" or simply as a "substituent (a)."

A thiol group-containing alkoxyalkyl group having 2 to 14 carbon atoms is at times referred to as a "thiol group-containing alkoxyalkyl group" or simply as a "substituent (b)."

Y¹ may have at least one of thiol group-containing alkyl group (substituent (a)) and thiol group-containing alkoxyalkyl group (substituent (b)) or may have at least two of them. Y' may have both a thiol group-containing alkyl group (substituent (a)) and a thiol group-containing alkoxyalkyl group (substituent (b)). Y¹ may have two or more substituents (a) or may have two or more substituents (b). If only a substituent (a) is included in one Y¹, and if only a substituent (b) is included in one Y¹, the upper limit of the number of substituents (a) or substituents (b) included in one Y¹ is not particularly limited, but may be, for example, 6 or less, and for example, 4 or less. If both substituent (a) and substituent (b) are included in one Y¹, the sum of the numbers of substituents (a) and substituents (b) included in one Y' may be 2 or more. Moreover, the upper limit of the sum of the numbers of substituents (a) and substituents (b) is not particularly limited, but may be, for example, 6 or less, and for example, 4 or less.

If Y' has two or more substituents (a), the structures of the substituents (a) may be the same or different. Similarly, If Y' has two or more substituents (b), the structures of the substituents (b) may be the same or different.

According to an embodiment, the alkyl group having 1 to 14 carbon atoms included in the thiol group-containing alkyl group (substituent (a)) may be a linear or branched alkyl group, and examples thereof may include a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptylbutyl group, a 1,4-dimethylpentyl group, a 3-ethylpentyl group, a 2-methyl-1-isopropylpropyl group, a 1-ethyl-3-methylbutyl group, an n-octyl group, a 2-ethylhexyl group, a 3-methyl-1-isopropylbutyl group, a 2-methyl-1-isopropylbutyl group, a 1-tert-butyl-2-methylpropyl group, an n-nonyl group, a 3,5,5-trimethylhexyl group, an n-decyl group, an isodecyl group, an n-undecyl group, a 1-methyldecyl group, an n-dodecyl group, an n-tridecyl group, an n-tetradecyl group, etc.

The alkoxyalkyl group having 2 to 14 carbon atoms included in the thiol group-containing alkoxyalkyl group (substituent (b)) is a linear or branched alkyl group alkoxyalkyl group. As a substituent (b), an alkyl group having 1 to 13 carbon atoms may be a group substituted with 1 to 3 (for example, 1 to 2, for example, 1) alkoxy groups having 1 to 13 carbon atoms (at this time, the sum of the carbon numbers of the alkyl group and the carbon numbers of the alkoxy group is 2 to 14). Specific examples of the alkyl group include those of the substituent (a) having 13 or fewer carbon atoms. Specific examples of the alkoxy group include those having 1 to 13 carbon atoms among the specific examples of the alkoxy group as the substituent.

Accordingly, examples of the alkoxyalkyl group having 2 to 14 carbon atoms included in the substituent (b) may include a methoxymethyl group, an ethoxymethyl group, a methoxyethyl group, an ethoxyethyl group, a propoxyethyl group, a butoxyethyl group, a methoxypropyl group, an ethoxypropyl group, a propoxypropyl group, a butoxypropyl group, a methoxybutyl group, an ethoxybutyl group, a propoxybutyl group, a butoxybutyl group, a methoxypentyl group, an ethoxypentyl group, a propoxypentyl group, a butoxypentyl group, a methoxyhexyl group, an ethoxyhexyl group, a propoxyhexyl group, a butoxyhexyl group, a methoxyheptyl group, an ethoxyheptyl group, a propoxyheptyl group, a butoxyheptyl group, and the like.

In addition, to further improve device durability (e.g., luminescence life-span), Y' in Chemical Formula 1 may include a substituent (b). For example, Y' in Chemical Formula 1 may be an aromatic hydrocarbon group having 6 to 25 ring-forming atoms, substituted with a thiol group-containing alkoxyalkyl group including 2 to 14 carbon atoms. Y¹ may be an aromatic hydrocarbon group having 6 to 25 ring-forming atoms substituted with a thiol group-containing alkoxyalkyl group including 2 to 10 carbon atoms. The number of carbon atoms in the thiol group-containing alkoxyalkyl group means the sum of the number of carbon atoms constituting the alkoxy group and the alkyl group constituting the group. In a form where Y' includes a substituent (b), the number of thiol groups included in the substituent (b) may be 1 or more, e.g., may be 2 or more. Accordingly, in an embodiment, the substituent (b) (thiol group-containing alkoxyalkyl group) may have one or more thiol groups. For example, substituent (b) may have two or more thiol groups. The upper limit of the number of thiol groups included in the substituent (b) is not particularly limited and may be 4 or less.

To further improve upon luminous efficiency, Y' in Chemical Formula 1 may include a substituent (a). Accordingly, Y¹ in Chemical Formula 1 may be an aromatic hydrocarbon group having 6 to 25 ring-forming atoms substituted with a thiol group-containing alkyl group having 1 to 14 carbon atoms. Y¹ may be an aromatic hydrocarbon group having 6 to 25 ring-forming atoms substituted with a thiol group-containing alkyl group having 1 to 10 carbon atoms. In a form where Y' includes a substituent (a), the number of thiol groups included in the substituent (a) may be 1 or more, e.g., may be 2 or more. Accordingly, in an embodiment, the substituent (a) (thiol group-containing alkyl group) may have one thiol group. In another embodiment, substituent (a) may have two or more thiol groups. The upper limit of the number of thiol groups included in the substituent (a) is not particularly limited but may be 4 or less.

To further improve the balance between durability and luminous efficiency in a device, or ensuring that the glass transition temperature (Tg) of the polymeric compound is within an appropriate range or that good thermal stability can be maintained, the alkyl group (in the case of the substituent (b), an alkyl group moiety bonded to an aromatic hydrocarbon group excluding an alkoxy group (-OR)) included in each of the substituent (a) or the substituent (b) may have 1 or more and 12 or less carbon atoms, for example, 1 or more and 10 or less, for example, 2 or more and 8 or less, or 4 or more and 8 or less, for example, 6. By setting the carbon number of the alkyl group constituting the substituent (a) or the alkyl group constituting the substituent (b) within the above ranges, the solvent solubility may be excellent and the film-forming property may be improved when forming a film using a wet (coating) method.

The alkoxy group included in the substituent (b) may have 1 to 10 carbon atoms, for example, 1 to 8 carbon atoms, 1 to 6 carbon atoms, 2 to 4 carbon atoms, for example, 3 carbon atoms. According to the above form, durability and luminous efficiency may be improved with a better balance.

The alkyl group included in the substituent (a) or the substituent (b) (the alkyl group constituting the substituent (a) or the substituent (b)) may be linear from the viewpoint of improving durability and luminous efficiency in a better balance. Moreover, the alkoxy group included in the substituent (b) (the alkoxy group constituting the substituent (b)) may be linear.

In substituent (a) or substituent (b), the substitution position of the thiol group is not particularly limited, but, for example, substituent (a) or substituent (b) may have a thiol group at the terminal end of the substituent. If a polymeric compound according to an embodiment is used as a hole transport material, the thiol group is more likely to be present near or on the surface of the hole transport layer, and thus, the compound is likely to interact with a light emitting material (such as a quantum dot or perovskite compound) in the light emitting layer. As a result, the positional arrangement of the light emitting material included in the luminescent layer may be improved so that durability (luminescence life-span) and luminous efficiency may be improved with a better balance.

The thiol group-containing alkyl group (substituent (a)) or the thiol group-containing alkoxyalkyl group (substituent (b)) according to an embodiment may have a structure represented by Chemical Formula i:

Chemical Formula i *-Z¹-(O-Z²)n-SH

In Chemical Formula i, Z¹ represents an alkylene group having 1 to 14 carbon atoms, which is unsubstituted or substituted with a thiol group, n is 0 or 1, and when n is 1, Z² represents an alkylene group having 1 to 13 carbon atoms, which is unsubstituted or substituted with a thiol group, and the sum of the carbon numbers of the alkylene group represented by Z¹ and the carbon numbers of the alkylene group represented by Z² is an integer of 14 or less (in other words, n is 0 or 1, and when n is 0, Z¹ represents an alkylene group having 1 to 14 carbon atoms, which is substituted or unsubstituted with a thiol group; and when n is 1, Z¹ represents an alkylene group having 1 to 13 carbon atoms, which is substituted or unsubstituted with a thiol group, Z² represents an alkylene group having 1 to 13 carbon atoms, which is substituted or unsubstituted with a thiol group, and the sum of the carbon numbers of the alkylene group represented by Z¹ and the carbon numbers of the alkylene group represented by Z2 is an integer of 14 or less), and * is bonded to the aromatic hydrocarbon group having 6 to 25 ring-forming atoms. In some instances, a group having a structure represented by Chemical Formula i is simply referred to as a "substituent (i)."

To improve durability (e.g., luminescence life-span) and luminous efficiency with a better balance, the alkylene group having 1 to 14 carbon atoms as Z¹ is a linear or branched alkylene group, and may be substituted with a thiol group. Examples of alkylene groups as Z¹ include a methylene group, an ethylene group, an n-propylene group (a trimethylene group), an iso-propylene group (a 1,1-dimethylmethylene group), an n-butylene group, an isobutylene group, a sec-butylene group, a tert-butylene group, an n-pentylene group, an isopentylene group, a tert-pentylene group, a neopentylene group, a 1,2-dimethylpropylene group, an n-hexylene group, an isohexylene group, a 1,3-dimethylbutylene group, a 1-isopropylpropylene group, a 1,2-dimethylbutylene group, an n-heptylene group, a 1,4-dimethylpentylene group, a 3-ethylpentylene group, a 2-methyl-1-isopropylpropylene group, a 1-ethyl-3-methylbutylene group, an n-octylene group, a 2-ethylhexylene group, a 3-methyl-1-isopropylbutylene group, a 2-methyl-1-isopropylbutylene group, a 1-tert-butyl-2-methylpropylene group, an n-nonylene group, a 3,5,5-trimethylhexylene group, an n-decylene group, an isodecylene group, an n-undecylene group, a 1-methyldecylene group, an n-dodecylene group, an n-tridecylene group, and an n-tetradecylene group.

The carbon number of the alkylene group as Z¹ may be 1 or more and 12 or less, for example, 1 or more and 10 or less, 2 or more and 8 or less, 4 or more and 8 or less, for example, 6 carbons.

The alkylene group as Z¹ may be linear, and thus provide improved durability and luminous efficiency with a better balance.

As described in detail below, the polymeric compound according to an embodiment may be formed into a film by a coating method. However, to further improve the film-forming properties and form a uniform film, thereby improving durability (e.g., luminescence life-span), the alkylene group constituting Z¹ may be unsubstituted.

Moreover, to further improve durability (e.g., luminescence life-span), in Chemical Formula i, n may be 1, i.e., [O-Z²] is present. Accordingly, in an embodiment, the thiol group-containing alkoxyalkyl group may have a structure represented by Chemical Formula i-1:

Chemical Formula i-1 *-Z¹-O-Z²-SH

In Chemical Formula i-1, Z¹ represents an alkylene group having 1 to 13 carbon atoms, substituted or unsubstituted with a thiol group, Z² represents an alkylene group unsubstituted or substituted with a thiol group and having 1 to 13 carbon atoms, the sum of the carbon numbers of the alkylene group represented by Z¹ and the carbon numbers of the alkylene group represented by Z² is an integer of 14 or less, and * is bonded to an aromatic hydrocarbon group having 6 to 25 ring-forming atoms. A group having a structure represented by Chemical Formula i-1 may be simply referred to as a "substituent (i-1)."

In Chemical Formula i, when n is 1 (the substituent (b) has a structure represented by Chemical Formula i-1), the alkylene group having 1 to 13 carbon atoms as Z² may be a linear or branched alkylene group, and may be substituted with a thiol group. Examples of alkylene groups as Z², are among the specific examples of alkylene groups as Z¹, those having 1 to 13 carbon atoms may be cited.

The carbon number of the alkylene group as Z² may be 1 or more and 10 or less, for example, 1 or more and 8 or less, for example, 1 or more and 6 or less, 2 or more and 4 or less, for example, 3.

The sum of the carbon number of the alkylene group represented by Z¹ and the carbon number of the alkylene group represented by Z² may be 2 or more and 12 or less, for example, 2 or more and 10 or less, 4 or more and 10 or less, for example, 6 or more and 9 or less.

The alkylene group as Z² may be linear from the viewpoint of improving durability and luminous efficiency with a better balance.

To further improve durability, the alkylene group as Z² may be substituted with a thiol group, that is, in Chemical Formula i, when n is 1 (the substituent (b) has a structure represented by Chemical Formula i-1), the substituent (i-1) may have two or more thiol groups. The upper limit of the number of thiol groups included in the above substituent (i-1) is not particularly limited but may be 4 or less.

In Chemical Formula i-1, an exemplary form of Z¹ may be referred to from the description of Z¹ in Chemical Formula i.

To further improve luminous efficiency, n in Chemical Formula i may be 0, i.e., [O-Z²] may be absent. That is, in an embodiment, the thiol group-containing alkyl group may have a structure represented by Chemical Formula i-2:

Chemical Formula i-2 *-Z¹-SH

In Chemical Formula i-2, Z¹ represents an alkylene group having 1 to 14 carbon atoms, unsubstituted or substituted with a thiol group, and * is bonded to an aromatic hydrocarbon group having 6 to 25 ring-forming atoms constituting Y¹. A group having a structure represented by Chemical Formula i-2 may be simply referred to as a "substituent (i-2)."

In Chemical Formula i-2, an exemplary form of Z¹ may be referred to from the description of Z¹ in Chemical Formula i.

The thiol group-containing alkyl group (substituent (a)) or the thiol group-containing alkoxyalkyl group (substituent (b)), i.e., substituent (i), according to an embodiment may be in the following form: in Chemical Formula i-1, Z¹ represents an alkylene group unsubstituted or substituted with a thiol group and having 1 to 10 carbon atoms, Z² represents an alkylene group unsubstituted or substituted with a thiol group and having 1 to 8 carbon atoms, and the sum of the carbon numbers of the alkylene group represented by Z¹ and the carbon numbers of the alkylene group represented by Z² is an integer of 2 to 12, or, in Chemical Formula i-2, Z¹ is an alkylene group unsubstituted or substituted with a thiol group and having 1 to 10 carbon atoms;

in another embodiment, in Chemical Formula i-1, Z¹ represents an alkylene group having 2 to 8 carbon atoms which is unsubstituted or substituted with a thiol group, Z² represents an alkylene group having 1 to 6 carbon atoms which is unsubstituted or substituted with a thiol group, and the sum of the carbon numbers of the alkylene group represented by Z¹ and the carbon numbers of the alkylene group represented by Z² is an integer of 3 to 10, or, in Chemical Formula i-2, Z¹ represents an alkylene group having 2 to 8 carbon atoms which is unsubstituted or substituted with a thiol group; and

in another embodiment, in Chemical Formula i-1, Z¹ represents an alkylene group having 4 to 8 carbon atoms which is unsubstituted or substituted with a thiol group, Z² represents an alkylene group having 2 to 4 carbon atoms which is unsubstituted or substituted with a thiol group, and the sum of the carbon numbers of the alkylene group represented by Z¹ and the carbon numbers of the alkylene group represented by Z² is an integer of 6 to 10, or, in Chemical Formula i-2, Z¹ represents an alkylene group having 4 to 8 carbon atoms which is unsubstituted or substituted with a thiol group.

In each of the above embodiments, both the alkylene group represented by Z¹ and the alkylene group represented by Z² may be linear.

One or more, or two or more, substituent (i) may be included in Y¹ and, the upper limit of the number of substituents (i) included in Y' is not particularly limited, but may be, for example, 6 or less, for example, 4 or less. If having two or more substituents (i), the structures of the substituents (i) may be the same or different. Therefore, in an embodiment, Y¹ has 2 or more and 6 or less (e.g., 4 or less) substituents (i-1), and the structures of the substituents (i-1) may be the same as each other. In another embodiment, Y¹ has 2 or more and 6 or less (e.g., 4 or less) substituents (i-2), and the structures of the substituents (i-2) may be the same as each other.

In Chemical Formula 1, Y' represents a group selected from an aromatic hydrocarbon group having 6 to 25 ring-forming atoms substituted with the substituent (a), an aromatic hydrocarbon group having 6 to 25 ring-forming atoms substituted with the substituent (b), and an aromatic hydrocarbon group having 6 to 25 ring-forming atoms substituted with the substituent (a) and the substituent (b).

Here, as an aromatic hydrocarbon group having 6 to 25 ring-forming atoms, examples thereof may include groups derived from aromatic hydrocarbons such as benzene, naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene.

Among these, the aromatic hydrocarbon group included in Y' may be a group derived from benzene or fluorene (e.g., a phenylene group or a fluorenylene group).

In an embodiment, in Formula 1, Y' may be any one of the groups represented by Chemical Formulas (Y-1) to (Y-3).

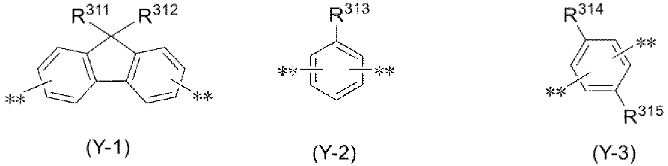

In Chemical Formulas (Y-1) to (Y-3), R³¹¹ to R³¹⁵ are each independently a group having a structure represented by Chemical Formula i (substituent (i)), and ** represents a bonding site. Exemplary forms of the substituent (i) included in Chemical Formulas (Y-1) to (Y-3) refer to the description of the substituent (i), and for example, the substituent (i) may be a substituent (i-1) or a substituent (i-2). In Chemical Formulas (Y-1) and (Y-3), R³¹¹ and R³¹², or R³¹⁴ and R³¹⁵ may be the same or different, respectively, but R³¹¹ and R³¹², and R³¹⁴ and R³¹⁵ may be the same as each other. For example, Y' may be a group represented by Chemical Formula (Y-1).

In another embodiment, from the viewpoint of improving durability (e.g., luminescence life-span) and luminous efficiency with a better balance, in Chemical Formula 1, Y' may be any one of the groups represented by Chemical Formulas (3-1) to (3-6):

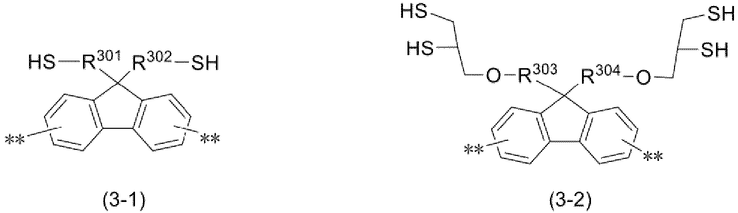

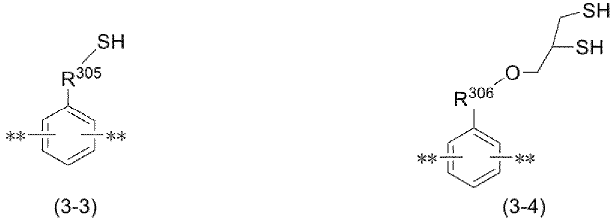

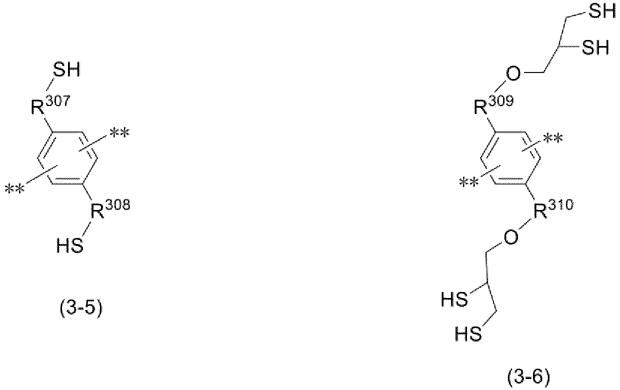

In Chemical Formulas (3-1) to (3-6), R³⁰¹, R³⁰², R³⁰⁵, R³⁰⁷ and R³⁰⁸ are each independently a substituted or unsubstituted alkylene group having 1 to 14 carbon atoms, R³⁰³, R³⁰⁴, R³⁰⁶, R³⁰⁹ and R³¹⁰ are each independently a substituted or unsubstituted alkylene group having 1 to 11 carbon atoms, and ** represents a bonding site.

In addition, in Chemical Formulas (3-1), (3-2), (3-5), and (3-6), R³⁰¹ and R³⁰², R³⁰³ and R³⁰⁴, R³⁰⁷ and R³⁰⁸, or R³⁰⁹ and R³¹⁰ may be the same or different, respectively. R³⁰¹ and R³⁰², R³⁰³ and R³⁰⁴, R³⁰⁷ and R³⁰⁸, and R³⁰⁹ and R³¹⁰ may be the same as each other.

The alkylene group having 1 to 14 carbon atoms (or 1 to 11 carbon atoms) as R³⁰¹ to R³¹⁰ is not particularly limited, but is a linear or branched alkylene group, and specific examples thereof include the same alkylene groups having 1 to 14 carbon atoms, for example, 11 or less carbon atoms, as described for Z¹ in Chemical Formula i.

The alkylene group as R³⁰¹ to R³¹⁰ may have 1 to 10 carbon atoms, for example, 1 to 8 carbon atoms, for example, 2 to 8 carbon atoms, for example, 4 to 8 carbon atoms, for example, 6 carbon atoms, from the viewpoint of improving durability (e.g., luminescence life-span) and luminous efficiency with a better balance.

Additionally, from the same viewpoint as above, the alkylene groups as R³⁰¹ to R³¹⁰ may be linear.

In Chemical Formula 1, Y' may be a group represented by Chemical Formula (3-1) or (3-2). For further improving durability (e.g., luminescence life-span), Y' may be a group represented by Chemical Formula (3-2). For further improving luminous efficiency, Y' may be a group represented by Chemical Formula (3-1).

In Chemical Formula 1, Ar¹¹ and Ar¹² may each independently represent a substituted or unsubstituted aromatic hydrocarbon group having 6 to 25 ring-forming atoms. Ar¹¹ and Ar¹² may be the same or different. Examples thereof include a group derived from aromatic hydrocarbons such as benzene, naphthalene, anthracene, pyrene, pentalene, indene, azulene, heptarene, acenaphthene, phenalene, phenanthrene, biphenyl, terphenyl, tetraphenyl, fluorene, or 9,9'-spirobi[fluorene].

The aromatic hydrocarbon group Ar¹¹ and Ar¹² may be a group derived from a compound selected from benzene, biphenyl, terphenyl, and fluorene (for example, a group selected from a phenylene group, a biphenylene group, a terphenylene group, and a fluorenylene group), a group derived from a compound selected from benzene and fluorene (for example, a group selected from a phenylene group and a fluorenylene group), or, for example, a group derived from benzene (for example, a phenylene group).

In a polymeric compound according to an embodiment, the structural unit (A) may be represented by Chemical Formula 1-1:

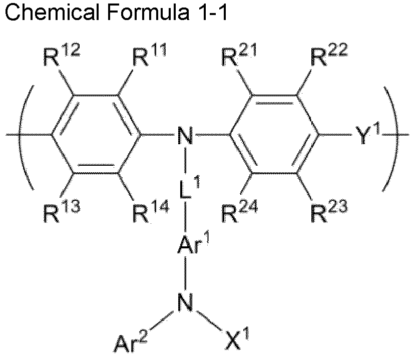

In Chemical Formula 1-1,
R¹¹ to R¹⁴ and R²¹ to R²⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be joined to form a ring,
L¹ may be a substituted or unsubstituted aromatic hydrocarbon group having 6 to 25 ring-forming atoms, or a substituted or unsubstituted heteroaromatic group having 5 to 25 ring-forming atoms,
Ar¹ may be a substituted or unsubstituted aromatic hydrocarbon group having 6 to 25 ring-forming atoms,
Ar² may be a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
X¹ may be a substituted or unsubstituted aromatic hydrocarbon group having 6 to 25 ring-forming atoms, or a substituted or unsubstituted heteroaromatic group having 5 to 25 ring-forming atoms, and
Y' may be a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms.

In Chemical Formula 1-1, Y' may be the same as defined in Chemical Formula 1, and the exemplary form of Y' in Chemical Formula 1-1 may also be referred to as the description of Y' in Chemical Formula 1. In Chemical Formula 1-1, Y¹ may have the same meaning as Y' in Chemical Formula 1, and may be an exemplary form thereof or a combination of these forms.

In Chemical Formula 1 (or Chemical Formula 1-1), X¹ may represent a substituted or unsubstituted aromatic hydrocarbon group having 6 to 25 ring-forming atoms; or a substituted or unsubstituted heteroaromatic group having 5 to 25 ring-forming atoms.

The "substituted or unsubstituted aromatic hydrocarbon group having 6 to 25 ring-forming atoms" refers to any one of (I) an aromatic hydrocarbon group having 6 to 25 ring-forming atoms substituted with a substituent (a), an aromatic hydrocarbon group having 6 to 25 ring-forming atoms substituted with a substituent (b), and an aromatic hydrocarbon group having 6 to 25 ring-forming atoms substituted with a substituent (a) and a substituent (b); (II) an aromatic hydrocarbon group having 6 to 25 ring-forming atoms substituted with a substituent other than a substituent (a) and a substituent (b); or (III) an unsubstituted aromatic hydrocarbon group having 6 to 25 ring-forming atoms.

In the above (I) and (II), a substituent other than the substituent (a) and the substituent (b) may be further included. In addition, the "substituted or unsubstituted heteroaromatic group having 5 to 25 ring-forming atoms" may represent any one of (I') a heteroaromatic group having 5 to 25 ring-forming atoms substituted with a substituent (a), a heteroaromatic group having 5 to 25 ring-forming atoms substituted with a substituent (b), and a heteroaromatic group having 5 to 25 ring-forming atoms substituted with a substituent (a) and a substituent (b); (II') a heteroaromatic group having 5 to 25 ring-forming atoms substituted with a substituent other than a substituent (a) and a substituent (b); or (III') an unsubstituted heeroaromatic group having 5 to 25 ring-forming atoms. In the above (I') and (II'), a substituent other than the substituent (a) and the substituent (b) may be further included. In the specification of this application, "a substituent other than substituent (a) and substituent (b)" refers to a substituent other than an alkyl group substituted by a thiol group (-SH) and an alkoxyalkyl group substituted by a thiol group (-SH), among the substituents described for the above "substituted."

As an aromatic hydrocarbon group having 6 to 25 ring-forming atoms, examples thereof may include, for example, benzene, naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene].

In addition, the heteroaromatic group having 5 to 25 ring-forming atoms may be, for example, acridine, phenazine, benzoquinoline, benzisoquinoline, phenanthridine, phenanthroline, anthraquinone, fluorenone, dibenzofuran, dibenzothiophene, carbazole, imidazophenanthridine, benzimidazophenanthridine, azadibenzofuran, azacarbazole, azadibenzothiophene, diazadibenzofuran, diazacarbazole, diazadibenzothiophene, xanthone, thioxanthone, pyridine, quinoline, or anthraquinoline.

X¹ may be a group derived from a compound selected from benzene, biphenyl, terphenyl, fluorene, and carbazole (for example, a group selected from a phenyl group, a biphenyl group, a terphenyl group, a fluorenyl group, and a carbazolyl group), for example, a group derived from a compound selected from benzene, biphenyl, terphenyl, or fluorene (for example, a group selected from a phenyl group, a biphenyl group, a terphenyl group, and a fluorenyl group), or for example, a group derived from benzene (for example, a phenyl group).

Additionally, X¹ may not be substituted with a substituent (a) or a substituent (b). X¹ may be a group derived from a compound selected from benzene, biphenyl, terphenyl, fluorene, or carbazole, which is unsubstituted or substituted with a substituent other than substituent (a) and substituent (b). For example, X¹ may be a group derived from a compound selected from benzene, biphenyl, terphenyl, or fluorene, which is unsubstituted or substituted with a substituent other than substituent (a) and substituent (b). For example, X¹ may be a benzene-derived group (e.g., a phenyl group) that is unsubstituted or substituted with a substituent other than substituent (a) and substituent (b). For example, X¹ may be a benzene-derived group (e.g., a phenyl group) substituted or unsubstituted with an alkyl group having 1 to 14 carbon atoms.

In addition, from the viewpoint of improving durability, in Chemical Formula 1 (or Chemical Formula 1-1), X¹ may be a group represented by Chemical Formula 6-1.

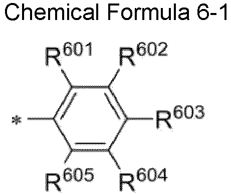

In Chemical Formula 6-1,
R⁶⁰¹ to R⁶⁰⁵ are each independently a hydrogen atom or an alkyl group having 1 to 14 carbon atoms which is unsubstituted or substituted with a substituent other than a thiol group (-SH), and * is bonded to a nitrogen atom (the nitrogen atom bonded to Ar¹).

Among R⁶⁰¹ to R⁶⁰⁵, at least one is an alkyl group having 1 to 14 carbon atoms, which is unsubstituted or substituted with a substituent other than a thiol group (-SH), and the remainder may be hydrogen atoms. Among R⁶⁰¹ to R⁶⁰⁵, at least one is an unsubstituted alkyl group having 1 to 14 carbon atoms, and the remainder may be hydrogen atoms. Among R⁶⁰¹ to R⁶⁰⁵, one may be an unsubstituted alkyl group having 1 to 14 carbon atoms, and the remaining four may be hydrogen atoms. R⁶⁰³ may be an unsubstituted alkyl group having 1 to 14 carbon atoms, and R⁶⁰¹, R⁶⁰², R⁶⁰⁴, and R⁶⁰⁵ may be hydrogen atoms, that is, the alkyl group may be in the para position (p position or 4 position) with respect to the bond (*) to the nitrogen atom (the nitrogen atom bonded to Ar¹).

The alkyl group having 1 to 14 carbon atoms as R⁶⁰¹ to R⁶⁰⁵ is not particularly limited, but is a linear or branched alkyl group, and examples thereof include the same alkyl groups having 1 to 14 carbon atoms as described for the substituent (a).

The alkyl group as R⁶⁰¹ to R⁶⁰⁵ may have 1 to 12 carbon atoms, for example, 2 to 10 carbon atoms, 4 to 8 carbon atoms, for example, an n-hexyl group, from the viewpoint of improving durability (e.g., luminescence life-span) and luminous efficiency with a better balance. Additionally, R⁶⁰³ may be an alkyl group having a carbon number within the above range.

The alkyl groups as R⁶⁰¹ to R⁶⁰⁵ may be linear from the viewpoint of improving durability.

In another embodiment, in Chemical Formula 1 (or Chemical Formula 1-1), X¹ may be any one of the groups represented by Chemical Formulas (8-1) to (8-3):

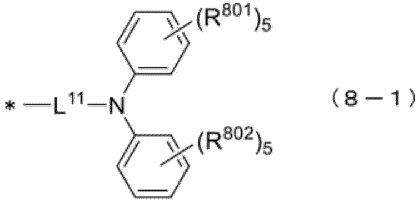

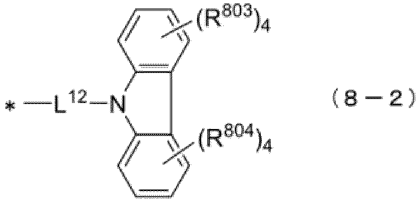

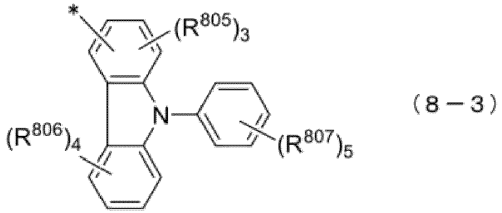

In Chemical Formulas (8-1), (8-2), and (8-3),
L¹¹ and L¹² each independently represents a substituted or unsubstituted aromatic hydrocarbon group having 6 to 12 ring-forming atoms,
R⁸⁰¹ to R⁸⁰⁷ each independently represents a hydrogen atom, a halogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aromatic hydrocarbon group having 6 to 30 ring-forming atoms, or a substituted or unsubstituted heteroaromatic group having 5 to 25 ring-forming atoms, and
* binds to a nitrogen atom (a nitrogen atom bonded to Ar¹).

R⁸⁰¹ to R⁸⁰⁷ present in one benzene ring may be the same or different. R⁸⁰¹ to R⁸⁰⁷ present in different benzene rings may be the same or different.

Examples of aromatic hydrocarbon groups as L¹¹ and L¹² include aromatic hydrocarbon groups having 6 to 12 ring-forming atoms among those exemplified for the aromatic hydrocarbon groups described for X¹.

Examples of halogen atoms as R⁸⁰¹ to R⁸⁰⁷ may include a fluorine atom, a chlorine atom, a bromine atom, or an iodine atom.

The alkyl group as R⁸⁰¹ to R⁸⁰⁷ may be either linear or branched, and examples thereof include a linear alkyl group having 1 to 20 carbon atoms and a branched alkyl group having 3 to 20 carbon atoms. As a specific example, among the substituents described for the above "substituted," the same specific examples as those given for the alkyl group may be exemplified.

As the cycloalkyl group as R⁸⁰¹ to R⁸⁰⁷, for example, a cycloalkyl group having 3 to 16 carbon atoms may be mentioned. As a specific example, among the substituents described for the above "substituted," the same specific examples as those given for the cycloalkyl group may be exemplified.

The alkoxy group as R⁸⁰¹ to R⁸⁰⁷ may be either linear or branched, and examples thereof include linear alkoxy groups having 1 to 20 carbon atoms or branched alkoxy groups having 3 to 20 carbon atoms. As a specific example, among the substituents described for the above "substituted," the same specific examples as those given for the alkoxy group may be exemplified.

As the cycloalkoxy group as R⁸⁰¹ to R⁸⁰⁷, for example, a cycloalkoxy group having 3 to 16 carbon atoms may be exemplified. As a specific example, the same specific examples as those given for the cycloalkoxy group among the substituents described for the above "substituted" may be exemplified.

As the aromatic hydrocarbon group as R⁸⁰¹ to R⁸⁰⁷, examples thereof include an aromatic hydrocarbon group having 6 to 30 ring-forming atoms. As a specific example, among the substituents described for the above "substituted," the same specific examples as those given for the aryl group may be exemplified.

As the heteroaromatic group as R⁸⁰¹ to R⁸⁰⁷, examples thereof include an heteroaromatic group having 5 to 25 ring-forming atoms. As a specific example, the same specific example as that given for the heteroaromatic group described for X¹ may be exemplified.

In Chemical Formula 1 (or Chemical Formula 1-1), the thiol group-containing alkyl group (substituent (a)) or the thiol group-containing alkoxyalkyl group (substituent (b)) may be in either a form included in both X¹ and Y' or a form included only in Y¹. From the viewpoint of improving durability (e.g., luminescence life-span) and luminous efficiency with a better balance, the substituent (a) or the substituent (b) may be in a form that is included only in Y¹. That is, in Chemical Formula 1 (or Chemical Formula 1-1), X¹ may be an aromatic hydrocarbon group having 6 to 25 ring-forming atoms which is unsubstituted or substituted with a substituent other than substituent (a) and substituent (b), or a heteroaromatic group having 5 to 25 ring-forming atoms which is unsubstituted or substituted with a substituent other than substituent (a) and substituent (b), and Y' may be a group selected from an aromatic hydrocarbon group having 6 to 25 ring-forming atoms which is substituted with a substituent (a), an aromatic hydrocarbon group having 6 to 25 ring-forming atoms which is substituted with a substituent (b), or an aromatic hydrocarbon group having 6 to 25 ring-forming atoms which is substituted with a substituent (a) and a substituent (b). In Chemical Formula 1 (or Chemical Formula 1-1), X¹ may be an aromatic hydrocarbon group having 6 to 25 ring-forming atoms substituted by a substituent other than substituent (a) and substituent (b), or an unsubstituted aromatic hydrocarbon group having 6 to 25 ring-forming atoms, and Y' may be a group selected from an aromatic hydrocarbon group having 6 to 25 ring-forming atoms substituted by substituent (a), an aromatic hydrocarbon group having 6 to 25 ring-forming atoms substituted by substituent (b), or an aromatic hydrocarbon group having 6 to 25 ring-forming atoms substituted by substituent (a) and substituent (b). Also, Ar¹¹, Ar¹², L¹, Ar¹, and Ar² in Chemical Formula 1 may not have a substituent (a) and a substituent (b). In addition, R¹¹ to R¹⁴, R²¹ to R²⁴, L', Ar¹, and Ar² in Chemical Formula 1-1 may not have a substituent (a) and a substituent (b).

In Chemical Formula 1 (or Chemical Formula 1-1), L¹ may represent a substituted or unsubstituted aromatic hydrocarbon group having 6 to 25 ring-forming atoms; or a substituted or unsubstituted heteroaromatic group having 5 to 25 ring-forming atoms.

Examples of the aromatic hydrocarbon group include a group derived from aromatic hydrocarbons such as benzene (e.g., phenylene group), naphthalene, anthracene, pyrene, pentalene, indene, azulene, heptarene, acenaphthene, phenalene, phenanthrene, biphenyl, terphenyl, tetraphenyl, fluorene, or 9,9'-spirobi[fluorene]. In addition, the heteroaromatic group may include, for example, a group derived from heteroaromatic compounds, such as, for example, acridine, phenazine, benzoquinoline, benzisoquinoline, phenanthridine, phenanthroline, anthraquinone, fluorenone, dibenzofuran, dibenzothiophene, carbazole, imidazophenanthridine, benzimidazophenanthridine, azadibenzofuran, azacarbazole, azadibenzothiophene, diazadibenzofuran, diazacarbazole, diazadibenzothiophene, xanthone, thioxanthone, pyridine, quinoline, or anthraquinoline.

Among these, L¹ may be a group derived from a compound selected from substituted or unsubstituted benzene, biphenyl, terphenyl, tetraphenyl and fluorene, and may be a group derived from substituted or unsubstituted benzene or biphenyl (a substituted or unsubstituted phenylene group or biphenylene group).

In addition, when L¹ may be a substituted aromatic hydrocarbon group, the substituent may be an alkyl group or a phenyl group, for example, an alkyl group, a methyl group, an ethyl group, an n-propyl group, an isopropyl group, or a methyl group or an ethyl group, for example, a methyl group. That is, L¹ may be a group derived from benzene or biphenyl, which is unsubstituted or substituted with a methyl group, an ethyl group, an n-propyl group, or an isopropyl group. For example, L¹ may be a group derived from benzene or biphenyl, substituted or unsubstituted with a methyl group or an ethyl group. For example, L¹ may be a group derived from benzene, which is unsubstituted or substituted with one or two methyl groups, or a group derived from biphenyl, which is unsubstituted or substituted with one or two methyl groups. For example, L¹ may be a benzene-derived group, unsubstituted or substituted with one or two methyl groups. For example, L¹ may be an unsubstituted benzene-derived group (o, m, or p-phenylene group). For example, L¹ may be a p-phenylene group. With such L¹s, the durability (e.g., luminescence life-span) and luminous efficiency of LED (e.g., QLED) may be improved with a better balance.

In Chemical Formula 1 (Chemical Formula 1-1), L¹ may be any one of the groups represented by Chemical Formulas (4-1) to (4-24):

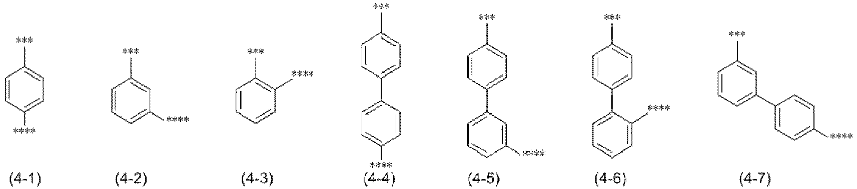

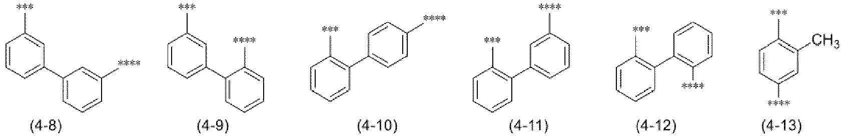

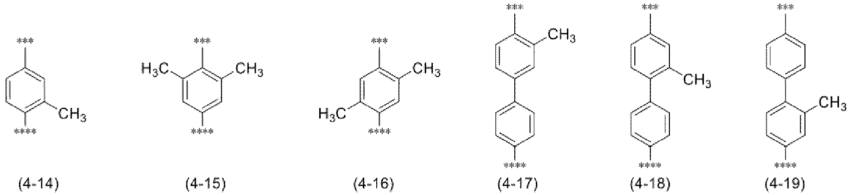

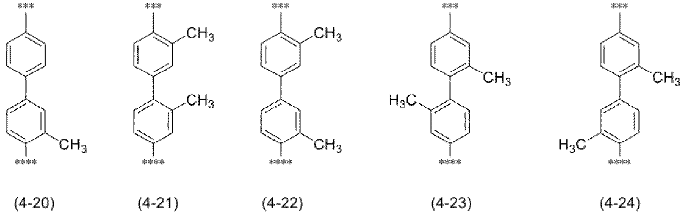

In Chemical Formulas (4-1) to (4-24), *** bonds to a nitrogen atom, and **** bonds to Ar¹.
L¹ may be any one of the groups represented by Chemical Formulas (4-1) to (4-3) and (4-13) to (4-16) (i.e., a substituted or unsubstituted phenylene group), or L¹ may be any one of the groups represented by Chemical Formulas (4-1) and (4-13) to (4-16) (i.e., a substituted or unsubstituted p-phenylene group). For example, L¹ may be a group represented by Chemical Formula (4-1) (i.e., an unsubstituted p-phenylene group). Such L¹ may achieve higher hole injection (and consequently higher durability) or better luminous efficiency.

In Chemical Formula 1 (or Chemical Formula 1-1), Ar¹ may represent a substituted or unsubstituted aromatic hydrocarbon group having 6 to 25 ring-forming atoms. Ar¹ may also form a ring with Ar².

Here, the aromatic hydrocarbon group as Ar¹ is not particularly limited. Specific examples of Ar¹ include the same ones as those derived from aromatic hydrocarbons having 6 to 25 ring-forming atoms described for the above L¹.

Ar¹ may be a group derived from a compound selected from substituted or unsubstituted benzene, biphenyl and fluorene, may be a substituted or unsubstituted group derived from benzene or biphenyl, or may be a substituted or unsubstituted group derived from benzene (for example, when Ar¹ and Ar² do not form a ring, Ar¹ may be, for example, an o-, *m-,* or p-phenylene group, and when Ar¹ and Ar² form a ring, Ar¹ may be, for example, a 1,3,4-phenylylene group). Additionally, Ar¹ may form a ring with Ar² and may be a substituted or unsubstituted 1,3,4-phenylylene group. With such Ar¹, durability and luminous efficiency may be improved with a better balance.

The substituent that may exist when any one of the hydrogen atoms of Ar¹ is substituted is not particularly limited, and the same substituents as those described for the above "substituted" may be applied. In an embodiment, Ar¹ may be unsubstituted.

In Chemical Formula 1 (or Chemical Formula 1-1), Ar² may represent a substituted or unsubstituted aromatic hydrocarbon group having 6 to 25 ring-forming atoms; or a substituted or unsubstituted heteroaromatic group having 5 to 25 ring-forming atoms. Ar² may also form a ring with Ar¹.

The aromatic hydrocarbon group and heteroaromatic group as Ar² are not particularly limited. Specific examples of the aromatic hydrocarbon group as Ar² may include a group derived from an aromatic hydrocarbon having 6 to 25 ring-forming atoms as described for L¹. Likewise, specific examples of the heteroaromatic group as Ar² may include a group derived from a heteroaromatic compound having 5 to 25 ring-forming atoms as described for L¹.

Ar² may be a group derived from a compound selected from substituted or unsubstituted benzene, biphenyl or fluorene, may be a substituted or unsubstituted group derived from benzene or biphenyl, may be a substituted or unsubstituted group derived from benzene (for example, when Ar¹ and Ar² do not form a ring, Ar² may be, for example, a phenyl group, and when Ar¹ and Ar² form a ring, Ar² may be, for example, an o-, *m-,* or p-phenylene group), or may be, for example, a substituted or unsubstituted o-phenylene group. Ar² may form a ring with Ar¹. With such Ar², durability and luminous efficiency may be improved with a better balance.

The substituent that may exist when any one of the hydrogen atoms of Ar² is substituted is not particularly limited, and the same substituents as those described for the above "substituted" may be applied. As an example, Ar² may be unsubstituted.

As described above, Ar¹ and Ar² may be joined to form a ring. In this way, by forming a ring between Ar¹ and Ar², higher hole injection properties may be obtained, durability (e.g., luminescence life-span) may be further improved, and good film-forming properties may be achieved.

When Ar¹ and Ar² form a ring, the ring structure formed by Ar¹ and Ar² is not particularly limited, but Ar¹ and Ar² may be bonded with each other to form a carbazole ring. Additionally, in an embodiment, -Ar¹-N(Ar²)(X¹) in Chemical Formula 1 (or Chemical Formula 1-1) may have a structure represented by any one of Chemical Formulas (7-1) to (7-3). For example, -Ar¹-N(Ar²)(X¹) in Chemical Formula 1 (or Chemical Formula 1-1) may have a structure represented by Chemical Formula (7-2).

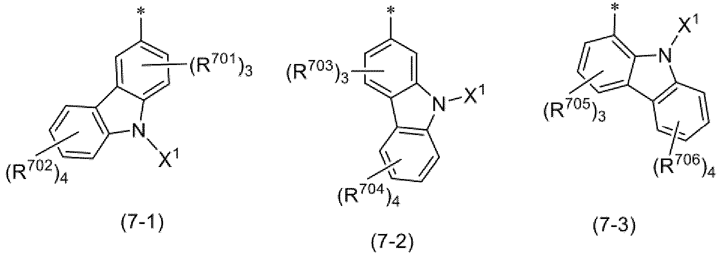

In Chemical Formulas (7-1) to (7-3),
R⁷⁰¹ to R⁷⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1 (Chemical Formula 1-1), and * binds to L¹.

R⁷⁰¹ to R⁷⁰⁶ present in one benzene ring may be the same or different. R⁷⁰¹ to R⁷⁰⁶ present in different benzene rings may be the same or different.

The alkyl group as R⁷⁰¹ to R⁷⁰⁶ may be either linear or branched, and examples thereof include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R⁷⁰¹ to R⁷⁰⁶, for example, a cycloalkyl group having 3 to 16 carbon atoms may be exemplified. As a specific example, among the substituents described for the above "substituted," the same specific examples as those given for the cycloalkyl group may be exemplified.

The alkoxy group as R⁷⁰¹ to R⁷⁰⁶ may be either linear or branched, and examples thereof may include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R⁷⁰¹ to R⁷⁰⁶, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R⁷⁰¹ to R⁷⁰⁶, for example, an aryl group having 6 to 30 ring-forming atoms (carbon atoms) may be exemplified. As a specific example, among the substituents described for the above "substituted," the same specific examples as those given for the aryl group may be exemplified.

Examples of halogen atoms as R⁷⁰¹ to R⁷⁰⁶ may include a fluorine atom, a chlorine atom, a bromine atom, or an iodine atom.

In Chemical Formulas (7-1) to (7-3), R⁷⁰¹ to R⁷⁰⁶ may each independently be a hydrogen atom or a substituted or unsubstituted alkyl group, for example, a hydrogen atom. In Chemical Formulas (7-1) to (7-3), exemplary forms of X¹ are referred to in the description of X¹.

From the viewpoint of improving durability (e.g., luminescence life-span) and luminous efficiency with a better balance, in Chemical Formula 1 (or Chemical Formula 1-1), Ar¹ may form a ring with Ar², and -L¹-Ar¹-N(Ar²)(X¹) may be any one of the groups represented by Chemical Formulas (5-1) to (5-3). In an embodiment, -L¹-Ar¹-N(Ar²)(X¹) in Chemical Formula 1 (or Chemical Formula 1-1) may have a structure represented by Chemical Formula (5-2).

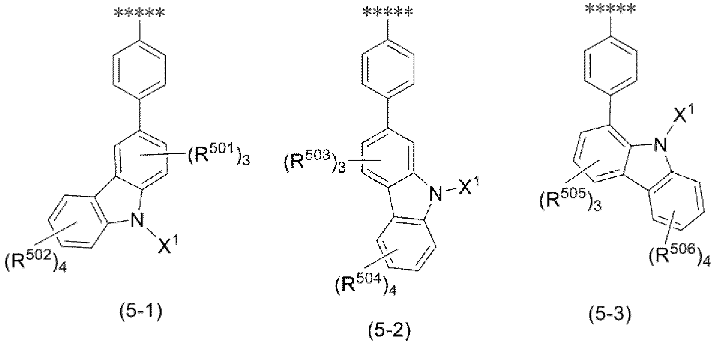

In Chemical Formulas (5-1) to (5-3),
R⁵⁰¹ to R⁵⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1 (or Chemical Formula 1-1), and
***** binds to a nitrogen atom.

R⁵⁰¹ to R⁵⁰⁶ present in one benzene ring may be the same or different. R⁵⁰¹ to R⁵⁰⁶ present in different benzene rings may be the same or different.

Each substituent as R⁵⁰¹ to R⁵⁰⁶ may be applied to the same substituents as the examples given for R⁷⁰¹ to R⁷⁰⁶ in Chemical Formulas (7-1) to (7-3). R⁵⁰¹ to R⁵⁰⁶ may each independently be a hydrogen atom, or a substituted or unsubstituted alkyl group, for example, a hydrogen atom. In Chemical Formulas (5-1) to (5-3), exemplary forms of X¹ may be referred to in the description of X¹.

In Chemical Formula 1-1, R¹¹ to R¹⁴ and R²¹ to R²⁴ may each independently represent a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be bonded with each other to form a ring.

R¹¹ to R¹⁴ and R²¹ to R²⁴ may be the same or different.

The alkyl groups as R¹¹ to R¹⁴ and R²¹ to R²⁴ may be either linear or branched, and examples thereof may include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R¹¹ to R¹⁴ and R²¹ to R²⁴, for example, a cycloalkyl group having 3 to 16 carbon atoms may be exemplified. As a specific example, among the substituents described for the above "substituted," the same specific examples as those given for the cycloalkyl group may be exemplified.

The alkoxy groups as R¹¹ to R¹⁴ and R²¹ to R²⁴ may be either linear or branched, and examples thereof include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R¹¹ to R¹⁴ and R²¹ to R²⁴, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R¹¹ to R¹⁴ and R²¹ to R²⁴, for example, an aryl group having 6 to 30 ring-forming atoms may be exemplified. As a specific example, among the substituents described for the above "substituted," the same specific examples as those given for the aryl group may be exemplified.

Examples of halogen atoms as R¹¹ to R¹⁴ and R²¹ to R²⁴ may include a fluorine atom, a chlorine atom, a bromine atom, or an iodine atom.

Additionally, R¹¹ and R²¹ may be bonded with each other to form a ring. The ring structure formed by R¹¹ and R²¹ is not particularly limited, but for example, there is a form in which R¹¹ and R²¹ are bonded with each other to form a carbazole ring.

From the viewpoint of obtaining higher durability (e.g., luminescence life-span) or better luminous efficiency, R¹¹ to R¹⁴ and R²¹ to R²⁴ may each independently be a hydrogen atom or a linear or branched alkyl group having 1 to 5 carbon atoms. Additionally, R¹¹ to R¹⁴ and R²¹ to R²⁴ may each independently be a hydrogen atom or a linear or branched alkyl group having 1 to 3 carbon atoms. R¹¹ to R¹⁴ and R²¹ to R²⁴ may all be, for example, hydrogen atoms.

The structural unit (A) according to an embodiment may be selected from Chemical Formulas (A-1) to (A-3).

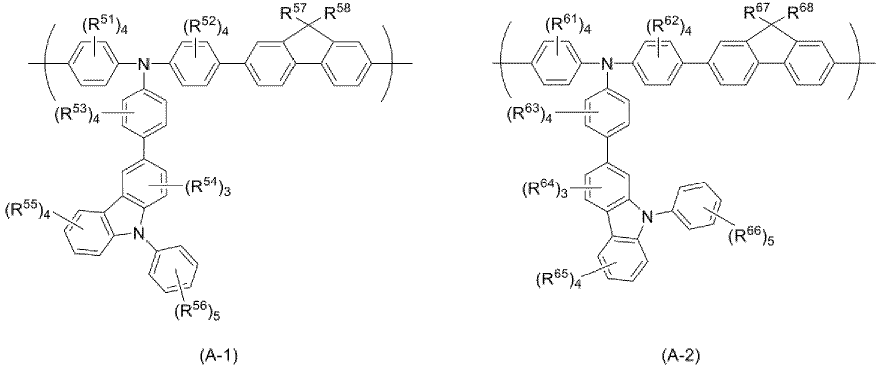

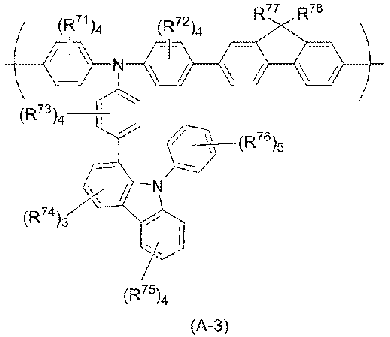

In Chemical Formulas (A-1) to (A-3), R⁵⁷, R⁵⁸, R⁶⁷, R⁶⁸, R⁷⁷, and R⁷⁸ may each independently represent a substituent (a) or a substituent (b), and R⁵¹ to R⁵⁶, R⁶¹ to R⁶⁶, and R⁷¹ to R⁷⁶ may each independently represent a hydrogen atom or a linear or branched alkyl group having 1 to 12 carbon atoms;

For example, in Chemical Formulas (A-1) to (A-3), R⁵⁷, R⁵⁸, R⁶⁷, R⁶⁸, R⁷⁷, and R⁷⁸ may each independently represent a substituent (a) or a substituent (b), and R⁵¹ to R⁵⁶, R⁶¹ to R⁶⁶, and R⁷¹ to R⁷⁶ may each independently represent a hydrogen atom or a linear or branched alkyl group having 2 to 10 carbon atoms;
for example, in Chemical Formulas (A-1) to (A-3), R⁵⁷, R⁵⁸, R⁶⁷, R⁶⁸, R⁷⁷, and R⁷⁸ may each independently represent a substituent (a) or a substituent (b), R⁵¹ to R⁵⁵, R⁶¹ to R^{65,} and R⁷¹ to R⁷⁵ may each independently represent a hydrogen atom, and R⁵⁶, R⁶⁶, and R⁷⁶ may each independently represent a linear or branched alkyl group having 4 to 8 carbon atoms.

R⁵¹ to R⁵⁶, R⁶¹ to R⁶⁶ and R⁷¹ to R⁷⁶ present in one benzene ring may be the same or different. R⁵¹ to R⁵⁶, R⁶¹ to R⁶⁶ and R⁷¹ to R⁷⁶ present in different benzene rings may be the same or different.

For each of the above-mentioned forms, exemplary forms of the substituent (a) and the substituent (b) may be referred to in the description of the substituent (a) and the substituent (b). As an example, in each of the above forms, the substituent (a) and the substituent (b) included in Chemical Formulas (A-1) to (A-3) may be the substituent (i) (substituent (i-1) or substituent (i-2)).

The structural unit (A) may be a structural unit represented by Chemical Formula (A-2), among the above, and exemplary forms of each substituent in the structural unit are as described above.

### Structural unit (B

According to an embodiment, a polymeric compound in accordance with an embodiment, may further include, in addition to the structural unit (A) represented by Chemical Formula 1, a structural unit (B) represented by Chemical Formula 2:

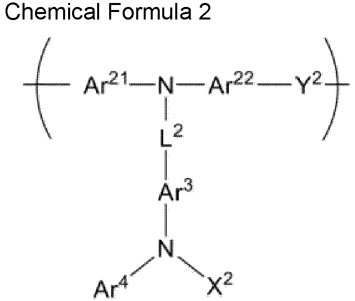

In Chemical Formula 2,
Ar²¹ and Ar²² are each independently a substituted or unsubstituted aromatic hydrocarbon group having 6 to 25 ring-forming atoms,
Ar²¹ and Ar²² are optionally bonded with each other to form a ring,
L² is a substituted or unsubstituted aromatic hydrocarbon group having 6 to 25 ring-forming atoms, or a substituted or unsubstituted heteroaromatic group having 5 to 25 ring-forming atoms,
Ar³ is a substituted or unsubstituted aromatic hydrocarbon group having 6 to 25 ring-forming atoms,
Ar⁴ is a substituted or unsubstituted aromatic hydrocarbon group having 6 to 25 ring-forming atoms, or a substituted or unsubstituted heteroaromatic group having 5 to 25 ring-forming atoms, and Ar⁴ may form a ring with Ar³,
X² is a substituted or unsubstituted aromatic hydrocarbon group having 6 to 25 ring-forming atoms, or a substituted or unsubstituted heteroaromatic group having 5 to 25 ring-forming atoms,
Y² is an aromatic hydrocarbon group having 6 to 25 ring-forming atoms, substituted or unsubstituted with an alkyl group having 1 to 14 carbon atoms, and
Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.

The structural unit (B) may be present as two or more units in the polymeric compounds, that is, the structural unit (B) represented by Chemical Formula 2 may be a repeating unit. Accordingly, the polymeric compound according to an embodiment may have a repeating unit (repeating unit (A)) represented by Chemical Formula 1 (for example, Chemical Formula 1-1) and a repeating unit (repeating unit (B)) represented by Chemical Formula 2.

The structural unit (B) represented by Chemical Formula 2 is at times simply referred to as "structural unit (B)". As with structural unit A, structural unit (B) represented by Chemical Formula 2, includes portion unit X', and 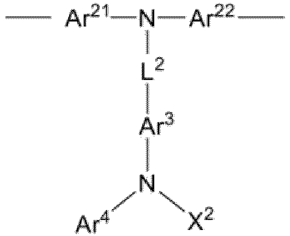 a portion unit Y².

In addition to the structural unit (A) represented by Chemical Formula 1, by further including a structural unit (B) represented by Chemical Formula 2, the polymeric compound according to an embodiment may have excellent hole injection properties for quantum dots and may further improve the durability (luminescence life-span) and luminous efficiency of the electroluminescence device. Moreover, high current efficiency and low driving voltage may be achieved. If a polymeric compound according to an embodiment does include a structural unit (B), the structural unit (B) may include only one type of structural unit (B), or may include two or more different types of structural unit (B). The plurality of structural units (B) may exist in a block form, a random form, an alternating form, or a periodic form.

In Chemical Formula 2, Y² differs from Y' in Chemical Formula 1 in that it does not have a thiol group-containing alkyl group having 1 to 14 carbon atoms (substituent (a)) and a thiol group-containing alkoxyalkyl group having 2 to 14 carbon atoms (substituent (b)). In Chemical Formula 2, the definitions of L², Ar³, Ar⁴, Ar²¹, and Ar²² are the same as the definitions of L¹, Ar¹, Ar², Ar²¹, and Ar²² of Chemical Formula 1, respectively, except that each of them does not have substituent (a) and substituent (b) (or is not substituent (a) and substituent (b)). Therefore, for L², Ar³, Ar⁴, Ar²¹, and Ar²², the term "substituted", unless specifically limited, means a form substituted with a substituent other than substituent (a) and substituent (b).

In Chemical Formula 2, Ar²¹ and Ar²² may each independently represent a substituted or unsubstituted aromatic hydrocarbon group having 6 to 25 ring-forming atoms. Ar²¹ and Ar²² may be the same or different. Here, as an aromatic hydrocarbon group having 6 to 25 ring-forming atoms, specifically, the same aromatic hydrocarbon groups as those described for Ar¹¹ and Ar¹² in Chemical Formula 1 may be exemplified.

The aromatic hydrocarbon group as Ar²¹ and Ar²² may be a group derived from a compound selected from benzene, biphenyl, terphenyl, and fluorene (for example, a group selected from a phenylene group, a biphenylene group, a terphenylene group, and a fluorenylene group), a group derived from a compound selected from benzene and fluorene (for example, a group selected from a phenylene group and a fluorenylene group), or, for example, a group derived from benzene (for example, a phenylene group).

In a polymeric compound according to an embodiment, the structural unit (B) may be represented by Chemical Formula 2-1:

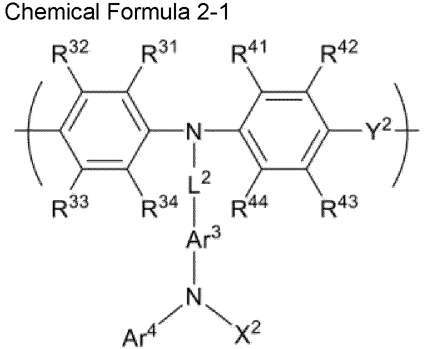

In Chemical Formula 2-1,
R³¹ to R³⁴ and R⁴¹ to R⁴⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be bonded with each other to form a ring,
L² may be a substituted or unsubstituted aromatic hydrocarbon group having 6 to 25 ring-forming atoms, or a substituted or unsubstituted heteroaromatic group having 5 to 25 ring-forming atoms,
Ar³ may be a substituted or unsubstituted aromatic hydrocarbon group having 6 to 25 ring-forming atoms,
Ar⁴ may be a substituted or unsubstituted aromatic hydrocarbon group having 6 to 25 ring-forming atoms, or a substituted or unsubstituted heteroaromatic having 5 to 25 ring-forming atoms, and Ar⁴ may form a ring with Ar³.
X² may be a substituted or unsubstituted aromatic hydrocarbon group having 6 to 25 ring-forming atoms, or a substituted or unsubstituted heteroaromatic group having 5 to 25 ring-forming atoms,
Y² may be an aromatic hydrocarbon group having 6 to 25 ring-forming atoms, substituted or unsubstituted with an alkyl group having 1 to 14 carbon atoms, and
R³¹ to R³⁴, R⁴¹ to R⁴⁴, L², Ar³, Ar⁴, and X² do not have a thiol group-containing alkyl group having 1 to 14 carbon atoms, and do not have a thiol group-containing alkoxyalkyl group having 2 to 14 carbon atoms.

In Chemical Formula 2 (Chemical Formula 2-1), Y² may represent an aromatic hydrocarbon group having 6 to 25 ring-forming atoms, substituted or unsubstituted with an alkyl group having 1 to 14 carbon atoms. As an aromatic hydrocarbon group having 6 to 25 ring-forming atoms, specifically, the same aromatic hydrocarbon group having 6 to 25 ring-forming atoms as described for Y' above may be exemplified.

Among these, the aromatic hydrocarbon group included in Y² may be a group derived from benzene or fluorene (e.g., a phenylene group or a fluorenylene group).

In an embodiment, for improving durability (e.g., luminescence life-span) and luminous efficiency with a better balance, in Chemical Formula 2 (Chemical Formula 2-1), Y² may be any one of the groups represented by Chemical Formulas (3'-1) to (3'-3):

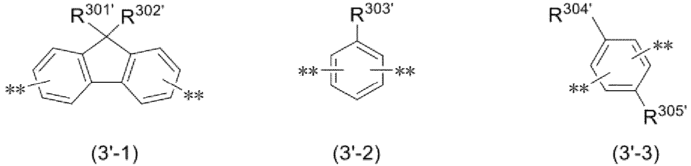

In Chemical Formulas (3'-1) to (3'-3), R^{301'} to R^{305'} may each independently be an alkyl group having 1 to 14 carbon atoms, unsubstituted or substituted with a substituent other than a thiol group (-SH), and ** represents a bonding site.

In Chemical Formulas (3'-1) and (3'-3), R301' and R^{301'} and R^{302'}, R^{304'} and R^{305'} may be the same or different. For example, R^{301'} and R^{302'}, R^{304'} and R^{305'} may be the same as each other.

The alkyl group having 1 to 14 carbon atoms as R^{301'} to R^{305'} is not particularly limited, but is a linear or branched alkyl group, and specific examples thereof include the same alkyl groups having 1 to 14 carbon atoms as those described for the substituent (a).

The alkyl group as R^{301'} to R^{305'} may have 1 to 12 carbon atoms, for example, 2 to 12 carbon atoms, 2 to 10 carbon atoms, or 4 to 10 carbon atoms, from the viewpoint of better balancing durability (e.g., luminescence life-span) and luminous efficiency, and may be, for example, an n-decyl group. For example, R^{301'} and R^{302'} may each independently be an alkyl group having a carbon number within the above range.

The alkyl group R^{301'} to R^{305'} may be linear. The alkyl groups as R^{301'} to R^{304'} may be unsubstituted.

Upon consideration of the film-forming property, etc., in Chemical Formula 2 (chemical formula 2-1), Y² may be a group represented by Chemical Formula (3'-1) (i.e., a fluorenylene group).

In Chemical Formula 2 (Chemical Formula 2-1), X² may represent a substituted or unsubstituted aromatic hydrocarbon group having 6 to 25 ring-forming atoms; or a substituted or unsubstituted heteroaromatic group having 5 to 25 ring-forming atoms.

As an aromatic hydrocarbon group having 6 to 25 ring-forming atoms, specifically, the same aromatic hydrocarbon group having 6 to 25 ring-forming atoms as described for X¹ above may be exemplified. As a heteroaromatic group having 5 to 25 ring-forming atoms, specifically, the same heteroaromatic group having 5 to 25 ring-forming atoms as described for X¹ may be exemplified.

Among these, X² may be a group derived from a compound selected from benzene, biphenyl, terphenyl, fluorene, or carbazole (for example, a group selected from a phenyl group, a biphenyl group, a terphenyl group, a fluorenyl group, or a carbazolyl group), for example, a group derived from a compound selected from benzene, biphenyl, terphenyl, or fluorene (for example, a group selected from a phenyl group, a biphenyl group, a terphenyl group, or a fluorenyl group), or for example, a group derived from benzene (for example, a phenyl group). X² may be a group derived from a compound selected from benzene, biphenyl, terphenyl, fluorene, or carbazole, which is substituted (substituted by a substituent other than substituent (a) and substituent (b)) or unsubstituted, a group derived from a compound selected from benzene, biphenyl, terphenyl, or fluorene, which is substituted (substituted by a substituent other than substituent (a) and substituent (b)) or unsubstituted, a group derived from a compound selected from benzene, biphenyl, terphenyl, or fluorene, which is unsubstituted or substituted by an alkyl group having 1 to 14 carbon atoms, or a group derived from benzene (for example, a phenyl group), which is unsubstituted or substituted by an alkyl group having 1 to 14 carbon atoms.

For improving durability, in an embodiment, in Chemical Formula 2 (or Chemical Formula 2-1), X² may be a group represented by Chemical Formula (6'-1).

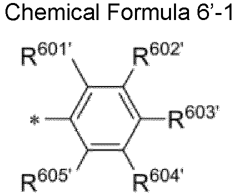

In Chemical Formula 6'-1,
R^{601'} to R^{605'} may each independently be a hydrogen atom, or an alkyl group having 1 to 14 carbon atoms, and
* binds to a nitrogen atom (a nitrogen atom bonded to Ar³).

Among R^{601'} to R^{605'}, at least one is an (unsubstituted) alkyl group having 1 to 14 carbon atoms, and the remainder may be hydrogen atoms. Among R^{601'} to R^{606'}, one may be an (unsubstituted) alkyl group having 1 to 14 carbon atoms, and the remaining four may be hydrogen atoms. R^{603'} may be an (unsubstituted) alkyl group having 1 to 14 carbon atoms, and R^{601'}, R^{602'}, R^{604'}, and R^{605'} may be hydrogen atoms, that is, the alkyl group may be at the para position (p position or 4 position) with respect to the bond (*) to the nitrogen atom (the nitrogen atom bonded to Ar³).

The alkyl group having 1 to 14 carbon atoms as R^{601'} to R^{605'} is not particularly limited, but may be a linear or branched alkyl group, and specific examples thereof may include the same alkyl groups having 1 to 14 carbon atoms as those described for the substituent (a).

The alkyl group as R^{601'} to R^{605'} may have 1 to 12 carbon atoms, for example, 2 to 10 carbon atoms, 4 to 8 carbon atoms, for example, be an n-hexyl group, from the viewpoint of improving durability (e.g., luminescence life-span) and luminous efficiency with a better balance. Additionally, R^{603'} may be an alkyl group having a carbon number within the above range.

The alkyl group as R^{601'} to R^{605'} may be linear from the viewpoint of improving durability.

In another embodiment, in Chemical Formula 2 (or Chemical Formula 2-1), X² may be any one of the groups represented by Chemical Formulas (8'-1) to (8'-3):

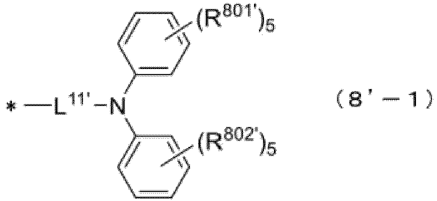

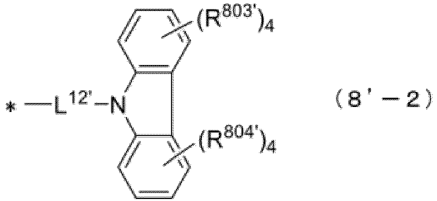

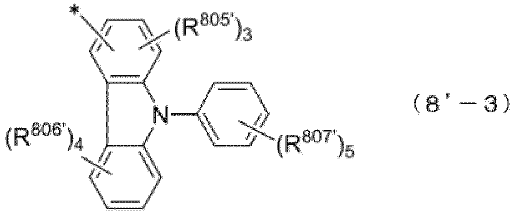

In Chemical Formulas (8'-1) to (8'-3),
L^{11'} and L^{12'} may each independently represent a substituted or unsubstituted aromatic hydrocarbon group having 6 to 12 ring-forming atoms,
R^{801'} to R^{807'} may each independently represent a hydrogen atom, a halogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aromatic hydrocarbon group having 6 to 25 ring-forming atoms, or a substituted or unsubstituted heteroaromatic group having 5 to 12 ring-forming atoms, and
* binds to a nitrogen atom (a nitrogen atom bonded to Ar³).

R^{801'} to R^{807'} present in one benzene ring may be the same or different. R^{801'} to R^{807'} present in different benzene rings may be the same or different.

Specific examples of the aromatic hydrocarbon group as L^{11'} and L^{12'} may include the same ones as L¹¹ and L¹². Specific examples of each substituent as R^{801'} to R^{807'} may include the same ones as R⁸⁰¹ to R⁸⁰⁷.

As described above, in Chemical Formula 2, the definitions of L², Ar³, Ar⁴, Ar²¹, and Ar²² are each the same as the definitions of L¹, Ar¹, Ar², Ar¹¹, and Ar¹² in Chemical Formula 1. In addition, in Chemical Formula 2-1, the definitions of L², Ar³, Ar⁴, R³¹ to R³⁴ and R⁴¹ to R⁴⁴ are each the same as the definitions of L', Ar¹, Ar², R¹¹ to R¹⁴ and R²¹ to R²⁴ in Chemical Formula 1-1. Also, the exemplary forms are each the same.

In Chemical Formula 2 (or Chemical Formula 2-1), L² may represent a substituted or unsubstituted aromatic hydrocarbon group having 6 to 25 ring-forming atoms; or a substituted or unsubstituted heteroaromatic group having 5 to 25 ring-forming atoms.

As an aromatic hydrocarbon group, examples thereof may include the same as the aromatic hydrocarbon group having 6 to 25 ring-forming atoms and the heteroaromatic group having 5 to 25 ring-forming atoms described for L¹.

Among these, L² may be a group derived from a compound selected from substituted or unsubstituted benzene, biphenyl, terphenyl, tetraphenyl or fluorene, for example, a group derived from substituted or unsubstituted benzene or biphenyl (a substituted or unsubstituted phenylene group or biphenylene group).

If L² is a substituted aromatic hydrocarbon group, the substituent may be an alkyl group or a phenyl group, for example, an alkyl group, or a methyl group, an ethyl group, an n-propyl group, or an isopropyl group, for example, a methyl group or an ethyl group, for example, a methyl group, that is, L² may be a group derived from benzene or biphenyl, which is unsubstituted or substituted with a methyl group, an ethyl group, an n-propyl group or an isopropyl group. For example, L² may be a group derived from benzene or biphenyl, substituted or unsubstituted with a methyl group or an ethyl group. For example, L² may be a group derived from benzene, substituted or unsubstituted with one or two methyl groups, or biphenyl, substituted or unsubstituted with one or two methyl groups. For example, L² may be a benzene-derived group, substituted or unsubstituted with one or two methyl groups. For example, L² may be an unsubstituted benzene-derived group (o-, *m-,* or p-phenylene group), for example, a p-phenylene group. As such, L² may improve the durability (e.g., luminescence life-span) and luminous efficiency of LED (e.g., QLED) with a better balance.

In Chemical Formula 2 (or Chemical Formula 2-1), L² may be any one of the groups represented by Chemical Formulas (4'-1) to (4'-24):

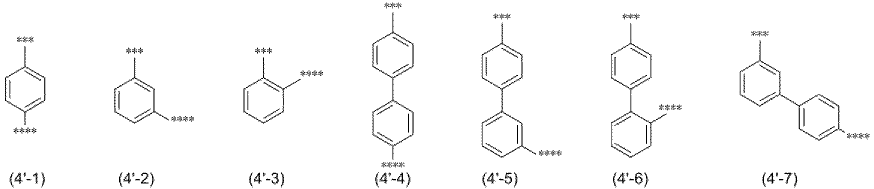

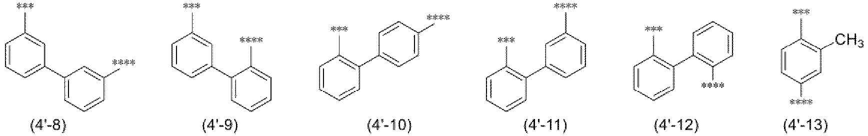

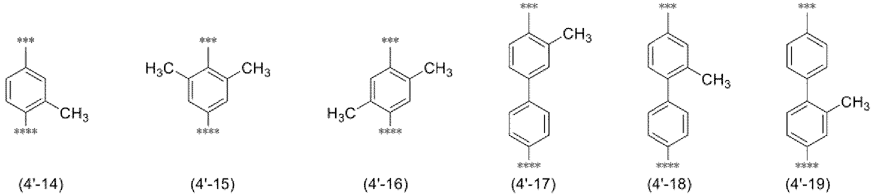

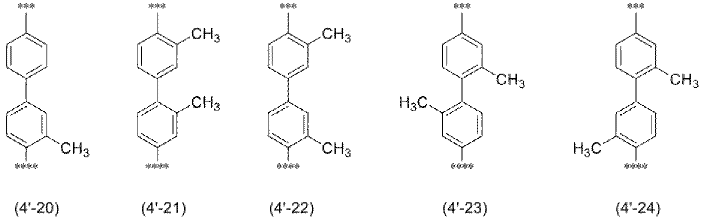

In Chemical Formulas (4'-1) to (4'-24), *** bonds to a nitrogen atom, and **** bonds to Ar³.

L² may be any one of the groups represented by Chemical Formulas (4'-1) to (4'-3) and (4'-13) to (4'-16) (i.e., a substituted or unsubstituted phenylene group). L² may be any one of the groups represented by Chemical Formulas (4'-1) and (4'-13) to (4'-16) (i.e., a substituted or unsubstituted p-phenylene group), for example, may be a group represented by Chemical Formula (4'-1) (i.e., an unsubstituted p-phenylene group). As such, L² may achieve higher hole injection properties (and consequently higher durability) or better luminous efficiency.

In Chemical Formula 2 (or Chemical Formula 2-1), Ar³ may represent a substituted or unsubstituted aromatic hydrocarbon group having 6 to 25 ring-forming atoms. At this time, Ar³ may also form a ring with Ar⁴.

The aromatic hydrocarbon group as Ar³ is not particularly limited. Specific examples of Ar³ may include the same ones as those derived from aromatic hydrocarbons having 6 to 25 ring-forming atoms described for the above L¹.

Among these, Ar³ may be a group derived from a compound selected from substituted or unsubstituted benzene, biphenyl or fluorene, may be a substituted or unsubstituted group derived from benzene or biphenyl, or may be a substituted or unsubstituted group derived from benzene (for example, when Ar³ and Ar⁴ do not form a ring, Ar³ may be, for example, an o-, *m-,* or p-phenylene group, and when Ar³ and Ar⁴ form a ring, Ar³ may be, for example, a 1,3,4-phenylylene group). Ar³ may form a ring with Ar⁴ and may be a substituted or unsubstituted 1,3,4-phenylylene group as such Ar³ may achieve higher hole injection properties (and consequently higher durability) and good film forming properties. Additionally, durability and luminous efficiency may be improved with a good balance.

The substituent that may exist when any one of the hydrogen atoms of Ar³ is substituted is not particularly limited, and the same substituents as those described for the above "substituted" may be applied. In an embodiment, Ar³ may be unsubstituted.

In Chemical Formula 2 (or Chemical Formula 2-1), Ar⁴ may represent a substituted or unsubstituted aromatic hydrocarbon group having 6 to 25 ring-forming atoms, or a substituted or unsubstituted heteroaromatic group having 5 to 25 ring-forming atoms. Ar⁴ may also form a ring with Ar³.

The aromatic hydrocarbon group and heteroaromatic group as Ar⁴ are not particularly limited. Specific examples of the aromatic hydrocarbon group as Ar⁴ may include a group derived from an aromatic hydrocarbon having 6 to 25 ring-forming atoms as described for L¹. Likewise, the heteroaromatic group as Ar⁴ may be exemplified by a group derived from a heteroaromatic compound having 5 to 25 ring-forming atoms as described for L¹ above.

Ar⁴ may be a group derived from a compound selected from substituted or unsubstituted benzene, biphenyl or fluorene, may be a substituted or unsubstituted group derived from benzene or biphenyl, may be a substituted or unsubstituted group derived from benzene (for example, when Ar³ and Ar⁴ do not form a ring, Ar⁴ may be, for example, a phenyl group, and when Ar³ and Ar⁴ form a ring, Ar⁴ may be, for example, an o-, *m-,* or p-phenylene group), or may be, for example, a substituted or unsubstituted o-phenylene group. If Ar⁴ forms a ring with Ar³ one may improve durability and luminous efficiency with a better balance.

The substituent that may exist when any one of the hydrogen atoms of Ar⁴ is substituted is not particularly limited, and the same substituents as those described for the above "substituted" may be applied. Ar⁴ may be unsubstituted.

As described above, Ar³ and Ar⁴ may be joined to form a ring. In this way, by forming a ring with Ar³ and Ar⁴, higher hole injection properties may be obtained, durability (e.g., luminescence life-span) may be further improved, and good film forming properties may be achieved.

If Ar³ and Ar⁴ form a ring, the ring structure formed by Ar³ and Ar⁴ is not particularly limited, but Ar³ and Ar⁴ may be bonded with each other to form a carbazole ring. In an embodiment, -Ar³-N(Ar⁴)(X²) in Chemical Formula 2 (or Chemical Formula 2-1) may have a structure represented by any one of Chemical Formulas (7'-1) to (7'-3). In an embodiment, -Ar³-N(Ar⁴)(X²) in Chemical Formula 2 (or Chemical Formula 2-1) may have a structure represented by Chemical Formula (7'-2):

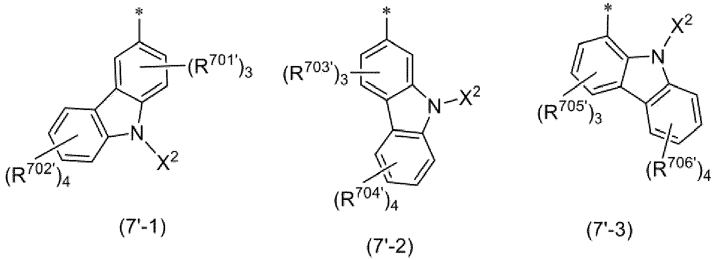

In Chemical Formulas (7'-1) to (7'-3),
R^{701'} to R^{706'} may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X² may be the same as defined in Chemical Formula 2 (Chemical Formula 2-1), and * binds to L².

R^{701'} to R^{706'} present in one benzene ring may be the same or different. R^{701'} to R^{706'} present in different benzene rings may be the same or different.

The alkyl group as R^{701'} to R^{706'} may be either linear or branched, and examples thereof may include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R^{701'} to R^{706'}, for example, a cycloalkyl group having 3 to 16 carbon atoms may be exemplified. As a specific example, among the substituents described for the above "substituted," the same specific examples as those given for the cycloalkyl group may be exemplified.

The alkoxy group as R^{701'} to R^{706'} may be either linear or branched, and examples thereof may include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R^{701'} to R^{706'}, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R^{701'} to R^{706'}, for example, an aryl group having 6 to 30 ring-forming atoms may be exemplified. As a specific example, among the substituents described for the above "substituted," the same specific examples as those given for the aryl group may be exemplified.

As halogen atoms as R^{701'} to R^{706'}, a fluorine atom, a chlorine atom, a bromine atom, or an iodine atom may be exemplified.

In Chemical Formulas (7'-1) to (7'-3), R^{701'} to R^{706'} may each independently be a hydrogen atom, or a substituted or unsubstituted alkyl group, or for example, a hydrogen atom. In Chemical Formulas (7'-1) to (7'-3), exemplary forms of X² may be referred to in the description of X².

From the viewpoint of improving durability (e.g., luminescence life-span) and luminous efficiency with a better balance, in Chemical Formula 2 (or Chemical Formula 2-1), Ar³ may form a ring with Ar⁴, and -L²-Ar³-N(Ar⁴)(X²) may be any one of the groups represented by Chemical Formulas (5'-1) to (5'-3). In an embodiment, -L²-Ar³-N(Ar⁴)(X²) in Chemical Formula 2 (or Chemical Formula 2-1) may have a structure represented by Chemical Formula (5'-2):

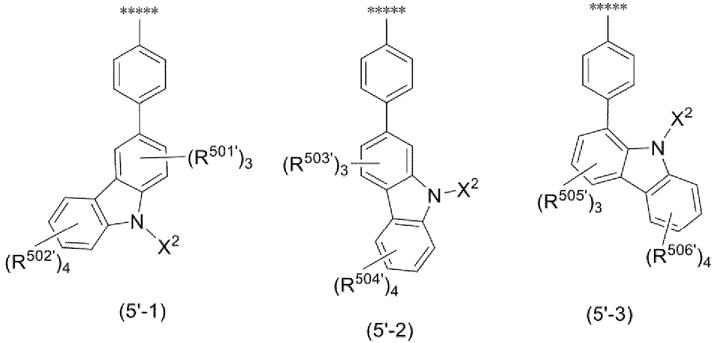

In Chemical Formulas (5'-1) to (5'-3),
R^{501'} to R^{506'} may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X² may be the same as defined in Chemical Formula 2 (Chemical Formula 2-1), and ***** is bonded to a nitrogen atom.

R^{501'} to R^{506'} present in one benzene ring may be the same or different. R^{501'} to R^{506'} present in different benzene rings may be the same or different.

Each substituent as R^{501'} to R^{506'} may be applied to the same substituent as the example given for R^{701'} to R^{706'} in Chemical Formulas (7'-1) to (7'-3). R^{501'} to R^{506'} may each independently be a hydrogen atom, or a substituted or unsubstituted alkyl group, or for example, a hydrogen atom. In Chemical Formulas (5'-1) to (5'-3), exemplary forms of X² may be referred to in the description of X².

In Chemical Formula 2-1, R³¹ to R³⁴ and R⁴¹ to R⁴⁴ may each independently represent a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be bonded with each other to form a ring.

R³¹ to R³⁴ and R⁴¹ to R⁴⁴ may be the same or different.

The alkyl groups as R³¹ to R³⁴ and R⁴¹ to R⁴⁴ may be either linear or branched, and examples thereof include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R³¹ to R³⁴ and R⁴¹ to R⁴⁴, for example, a cycloalkyl group having 3 to 16 carbon atoms may be exemplified. As a specific example, among the substituents described for the above "substituted," the same specific examples as those given for the cycloalkyl group may be exemplified.

The alkoxy groups as R³¹ to R³⁴ and R⁴¹ to R⁴⁴ may be either linear or branched, and examples thereof include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R³¹ to R³⁴ and R⁴¹ to R⁴⁴, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R³¹ to R³⁴ and R⁴¹ to R⁴⁴, for example, an aryl group having 6 to 30 ring-forming atoms may be exemplified. As a specific example, among the substituents described for the above "substituted," the same specific examples as those given for the aryl group may be exemplified.

As halogen atoms as R³¹ to R³⁴ and R⁴¹ to R⁴⁴, a fluorine atom, a chlorine atom, a bromine atom, and an iodine atom may be exemplified.

Additionally, R³¹ and R⁴¹ may be bonded with each other to form a ring. At this time, the ring structure formed by R³¹ and R⁴¹ is not particularly limited, but for example, there is a form in which R³¹ and R⁴¹ are bonded with each other to form a carbazole ring.

R³¹ to R³⁴ and R⁴¹ to R⁴⁴ may each independently be a hydrogen atom or a linear or branched alkyl group having 1 to 5 carbon atoms. As such, higher durability (e.g., luminescence life-span) or better luminous efficiency may be achieved. R³¹ to R³⁴ and R⁴¹ to R⁴⁴ may each independently be a hydrogen atom or a linear or branched alkyl group having 1 to 3 carbon atoms. R³¹ to R³⁴ and R⁴¹ to R⁴⁴ may all be, for example, hydrogen atoms.

The structural unit (B) represented by Chemical Formula 2 described above may have the same structure and substituent as the structural unit (A) represented by Chemical Formula 1, except for the part including the substituent (a) or the substituent (b) (i.e., Y¹). Accordingly, Ar²¹ in Chemical Formula 2 is the same as Ar¹¹ in Chemical Formula 1, Ar²² in Chemical Formula 2 is the same as Ar¹² in Chemical Formula 1, L² in Chemical Formula 2 is the same as L¹ in Chemical Formula 1, Ar³ in Chemical Formula 2 is the same as Ar¹ in Chemical Formula 1, Ar⁴ in Chemical Formula 2 is the same as Ar² in Chemical Formula 1, and X² in Chemical Formula 2 is the same as X¹ in Chemical Formula 1.
. Likewise, R¹¹ in Chemical Formula 1-1 may be the same as R³¹ in Chemical Formula 2-1, R¹² in Chemical Formula 1-1 may be the same as R³² in Chemical Formula 2-1, R¹³ in Chemical Formula 1-1 may be the same as R³³ in Chemical Formula 2-1, R¹⁴ in Chemical Formula 1-1 may be the same as R³⁴ in Chemical Formula 2-1, R²¹ in Chemical Formula 1-1 may be the same as R⁴¹ in Chemical Formula 2-1, R²² in Chemical Formula 1-1 may be the same as R⁴² in Chemical Formula 2-1, R²³ in Chemical Formula 1-1 may be the same as R⁴³ in Chemical Formula 2-1, R²⁴ in Chemical Formula 1-1 may be the same as R⁴⁴ in Chemical Formula 2-1, L¹ in Chemical Formula 1-1 may be the same as L² in Chemical Formula 2-1, Ar¹ in Chemical Formula 1-1 may be the same as Ar³ in Chemical Formula 2-1, Ar² in Chemical Formula 1-1 may be the same as Ar⁴ in Chemical Formula 2-1, and X¹ in Chemical Formula 1-1 may be the same as X² in Chemical Formula 2-1.

And, in the above, for example, "Ar¹¹ in Chemical Formula 1 is the same as Ar²¹ in Chemical Formula 2" means that Ar¹¹ and Ar²¹ have the same structure. For example, if Ar¹¹ is an unsubstituted phenylene group, it indicates that Ar²¹ is also an unsubstituted phenylene group.

The structural unit (B) according to an embodiment may be selected from the following groups:

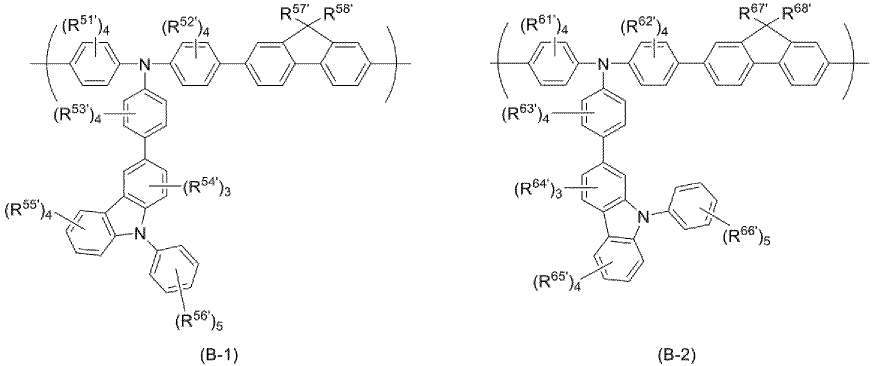

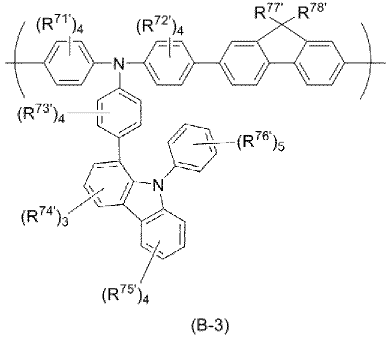

In Chemical Formulas (B-1) to (B-3), R^{57'}, R^{58'}, R^{67'}, R^{68'}, R^{77'}, and R^{78'} may each independently represent a linear or branched alkyl group having 1 to 14 carbon atoms, and R^{51'} to R^{56'}, R^{61'} to R^{66'}, and R^{71'} to R^{76'} may each independently represent a hydrogen atom or a linear or branched alkyl group having 1 to 12 carbon atoms; for example, in Chemical Formulas (B-1) to (B-3), R^{57'}, R^{58'}, R^{67'}, R^{68'}, R^{77'} and R^{78'} may each independently represent a linear or branched alkyl group having 2 to 12 carbon atoms, and R^{51'} to R^{56'}, R^{61'} to R^{66'}, and R^{71'} to R^{76'} may each independently represent a hydrogen atom or a linear or branched alkyl group having 2 to 10 carbon atoms; and for example, in Chemical Formulas (B-1) to (B-3), R^{57'}, R^{58'}, R^{67'}, R^{68'}, R^{77'} and R^{78'} may each independently represent a linear or branched alkyl group having 4 to 10 carbon atoms, R^{51'} to R^{55'}, R^{61'} to R^{65'} and R^{71'} to R^{75'} may each independently represent a hydrogen atom, and R^{56'}, R^{66'} and R^{76'} may each independently represent a linear or branched alkyl group having 4 to 8 carbon atoms.

R^{51'} to R^{56'}, R^{61'} to R^{66'} and R^{71'} to R^{76'} present in one benzene ring may be the same or different, respectively. R^{51'} to R^{56'}, R^{61'} to R^{66'} and R^{71'} to R^{76'} present in different benzene rings may be the same or different.

The structural unit (B) may be a structural unit represented by chemical formula (B-2) among the above, and the specific form of each substituent in the structural unit is as described above.

### Other structural units

The polymeric compound of an embodiment may further include a structural unit other than the structural unit (A), and optionally, the structural unit (B). In cases where another structural unit is included, the structural unit is not particularly limited as long as it does not inhibit the effect of the polymeric compound. The other structural unit may include those derived from compounds such as azulene, naphthalene, anthracene, phenanthrene, pyrene, etc. Hereinafter, the other structural unit is referred to as "structural units (C)".

### Composition of Polymeric Compound

The composition of structural units (A) to (C) in a polymeric compound according to an embodiment is not particularly limited. Considering a further good balance of the durability (luminescence life-span) and luminous efficiency of a layer formed using the obtained polymeric compound (e.g., a hole injection layer, a hole transport layer), the structural unit (A) may be included in an amount of, for example, about 1 mol% or more and less than about 100 mol%, for example, about 1 mol% or more and about 30 mol% or less, for example, about 5 mol% or more and about 20 mol% or less, or for example, about 8 mol% or more and about 15 mol% or less, based on a total number of moles of the structural units constituting the polymeric compound. When a polymeric compound includes two or more types of the structural units (A), the amount of the structural units (A) means a total amount of the structural units (A).

In an embodiment, the structural unit (A) is included in the polymeric compound in a ratio of less than about 100 mol% based on a total moles of the structural units. Considering an objective is to achieve good balance between the durability (luminescence life-span) and luminescence efficiency of a layer formed using the obtained polymeric compound (e.g., a hole injection layer, a hole transport layer), the structural unit (B) may be included in an amount of, for example, more than about 0 mol% and less than or equal to about 99 mol%, for example, more than about 70 mol% and less than or equal to about 99 mol%, for example, more than about 80 mol% and less than or equal to about 95 mol%, or, for example, more than about 85 mol% and less than or equal to about 92 mol%, based on a total number of moles of the structural units constituting the polymeric compound. When a polymeric compound contains two or more types of the structural units (B), the amount of the structural units (B) means a total amount of the structural units (B).

As described above, the polymeric compound according to an embodiment may further include another structural unit structural unit (C). The composition of the other structural unit structural units (C) is not particularly limited. Considering the effect of further improving the ease of film formation and film strength by the obtained polymeric compound, the structural unit (C) may be included in an amount of, for example, more than 0 mol% and less than or equal to about 10 mol% based on a total number of moles of the structural units constituting the polymeric compound. If a polymeric compound includes two or more types of structural units (C), the amount of the structural units (C) means a total amount of the structural units (C).

As an example, a structural unit (C) may be a structural unit having a crosslinking group. Here, "crosslinking group" means a group that produces a new bond by reacting (crosslinking) with a same or different group in a structural unit positioned nearby by heating or irradiation with active energy rays. By including a structural unit having a crosslinking group, a crosslinking reaction can occur by heating or irradiation with an active energy ray, making the polymeric compound insoluble in a solvent and forming a more solid film. As a result, the producibility and durability of electroluminescence devices may further be improved.

The crosslinking group is not particularly limited as long as it is a group that can induce a crosslinking reaction by heat or active energy rays, but examples may include a bicyclo[4.2.0]octa-1,3,5-trienyl group, a vinyl group, a hexenyl group, a styryl group, a (3-ethoxyethane-3-yl)methoxy group, etc.

Based on a total (sum) number of moles of structural units (A) and structural units (B), the molar ratio of structural unit (A) may be greater than or equal to about 1 mol% and less than about 30 mol%, or greater than or equal to about 5 mol% and less than or equal to about 20 mol%, or for example, greater than or equal to about 8 mol% and less than or equal to about 15 mol%. Similarly, the molar ratio of the structural unit (B) may be greater than about 70 mol% and less than or equal to about 99 mol%, greater than or equal to about 80 mol% and less than or equal to about 95 mol%, or greater than or equal to about 85 mol% and less than or equal to about 92 mol% (based on a total number of moles of the structural unit (A) and the structural unit (B)).

The molar ratio among the structural unit (A), the structural unit (B), and the structural unit (C) may appropriately be controlled by adjusting the molar ratio of the monomers that serve as raw materials. In addition, the molar ratio of each structural unit (A), structural unit (B), and structural unit (C) in a polymeric compound may be measured by using ¹H-NMR, ¹³C-NMR, mass spectrometry, liquid chromatography-mass spectrometry (LC-MS), Fourier transform infrared spectroscopy (FTIR), etc., or by combining these methods.

The polymer compounds described herein provide good balance between the durability (e.g., luminescence life-span) and luminous efficiency of a device. In particular, if the polymer compound is used to form a layer a hole injection layer or a hole transport layer. The polymeric compound may include only the structural unit (A) and the structural unit (B) (i.e., the total ratio of the structural unit (A) and the structural unit (B) to the total structural units of the polymeric compound is 100 mol%).

The weight average molecular weight (Mw) of the polymeric compound according to an embodiment is not particularly limited. The weight average molecular weight (Mw) may be, for example, greater than or equal to about 5,000 Da and less than or equal to about 1,000,000 Da, for example, greater than or equal to about 8,000 Da and less than or equal to about 1,000,000 Da, greater than or equal to about 10,000 Da and less than or equal to about 800,000 Da, or for example, greater than or equal to about 50,000 Da and less than or equal to about 500,000 Da. With such a weight average molecular weight, it is possible to form a layer with a uniform film thickness by appropriately controlling the viscosity of the coating solution for forming a layer (e.g., a hole injection layer, a hole transport layer) using a polymeric compound.

In addition, the number average molecular weight (Mn) of the polymeric compound is not particularly limited. The number average molecular weight (Mn) may be, for example, greater than or equal to about 4,000 Da and less than or equal to about 300,000 Da , for example, greater than or equal to about 6,000 Da and less than or equal to about 250,000 Da, greater than or equal to about 10,000 Da and less than or equal to about 200,000 Da, or for example, greater than or equal to about 20,000 Da and less than or equal to about 150,000 Da. With such a number-average molecular weight, it is possible to form a layer with a uniform film thickness by appropriately controlling the viscosity of the coating solution for forming a layer (e.g., a hole injection layer, a hole transport layer) using a polymeric compound. In addition, the polydispersity (weight average molecular weight/number average molecular weight) of the polymeric compound according to an embodiment may be, for example, greater than or equal to about 1.1 and less than or equal to about 5.0, for example, greater than or equal to about 1.5 and less than or equal to about 4.0, or for example, greater than or equal to about 2.0 and less than or equal to about 3.5.

The measurement of the number average molecular weight (Mn) and the weight average molecular weight (Mw) is not particularly limited, and may be measured by using a known method or by appropriately modifying a known method. In this specification, the number average molecular weight (Mn) and weight average molecular weight (Mw) adopt values measured by the following methods. The polydispersity (Mw/Mn) of the polymer is calculated by dividing the weight average molecular weight (Mw) by the number average molecular weight (Mn) measured by the following method. Measurement of Number Average Molecular Weight (Mn) and Weight Average Molecular Weight (Mw)

The number average molecular weight (Mn) and weight average molecular weight (Mw) of the polymeric material is measured by SEC (Size Exclusion Chromatography) using polystyrene as a standard material under the following conditions:
SEC Measurement Condition
Analysis equipment (SEC): Shimadzu Corporation, Prominence (registered trademark)
Column: Polymer Laboratories, PLgel MIXED-B
Column temperature: 40 °C
Flow rate: 1.0 mL/min
Injection amount of sample solution: 20 µL (concentration of polymer: about 0.05 mass%)
Eluent: tetrahydrofuran (THF)
Detector (UV-VIS detector): Shimadzu Corporation, SPD-10AV
Standard sample: polystyrene.

The terminal end of the main chain of the polymeric compound according to the present embodiment is not particularly limited and is appropriately defined depending on the type of raw material used, but is usually a hydrogen atom.

The polymeric compound of the present embodiment may be synthesized by using a known organic synthesis method. The specific synthesis method of the polymeric compound of the present embodiment may be easily understood by a person of an ordinary skill in the art referring to the examples to be described later.

For example, the polymeric compound according to an embodiment may be prepared by a copolymerization reaction using at least one monomer (I-x) represented by Chemical Formula I-X and at least one monomer (I-y) represented by Chemical Formula I-Y. If necessary, monomers of structural unit (B) according to an embodiment may be added. Specifically, the polymeric compound may be prepared by a copolymerization reaction using at least one monomer (II-x) represented by Chemical Formula II-X and at least one monomer (II-y) represented by Chemical Formula II-Y (i.e., monomers constituting structural unit (B) according to an embodiment) in addition to at least one monomer (I-x) represented by Chemical Formula I-X and at least one monomer (I-y) represented by Chemical Formula I-Y (i.e., monomers constituting structural unit (A) according to an embodiment). In the polymeric compound, when X in structural unit (A) and X' in structural unit (B) have the same structure, the polymeric compound according to an embodiment may also be prepared by copolymerization reaction using at least one monomer (I-x) represented by Chemical Formula I-X, at least one monomer (I-y) represented by Chemical Formula I-Y, and at least one monomer (II-y) represented by Chemical Formula II-Y.

If necessary, other monomers corresponding structural unit (C) may be added. By appropriately controlling the molar ratio of each monomer, i.e., the molar ratio of structural units (A), (B), and (C) in the polymeric compound may be controlled.

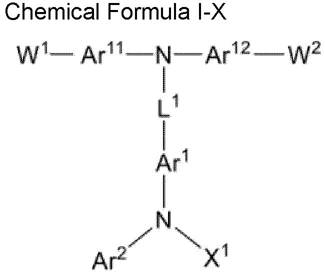

Chemical Formula I-Y W³-Y¹-W⁴

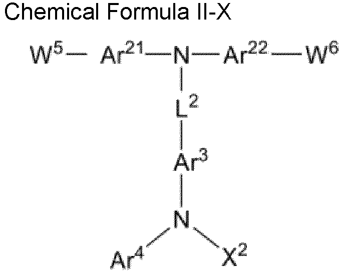

Chemical Formula II-Y W⁷-Y²-W⁸

Alternatively, a polymeric compound according to an embodiment may be produced by a polymerization reaction using one or more monomers represented by Chemical Formula 1'. If necessary, a monomer corresponding to the structural unit (B) according to an embodiment may also be added. Specifically, when a polymeric compound according to an embodiment includes a structural unit (A) and a structural unit (B), the compound can be produced by a copolymerization reaction using at least one monomer represented by Chemical Formula 1' and at least one monomer represented by Chemical Formula 2'. If necessary, another monomer corresponding to the (structural unit (C) may be added.

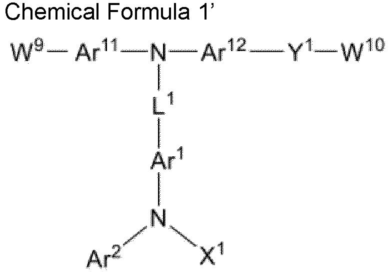

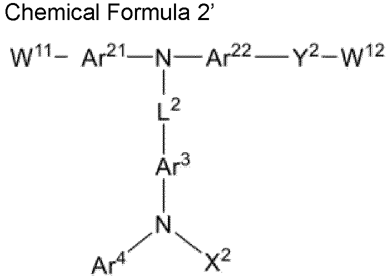

In an embodiment, the monomer used for polymerization of a polymeric compound may be synthesized by appropriately combining known synthetic reactions, and its structure can also be confirmed by a known method (e.g., NMR, LC-MS, etc.).

In Chemical Formula I-X, Chemical Formula I-Y, Chemical Formula II-X, Chemical Formula II-Y, Chemical Formula 1', and Chemical Formula 2', Ar¹¹, Ar¹², Ar²¹, Ar²², L¹, L², Ar¹, Ar², Ar³, Ar⁴, X¹, X², Y¹, and Y² are the same as defined in Chemical Formula 1 or Chemical Formula 2, and W¹ to W¹² are each independently a halogen atom (fluorine atom, chlorine atom, bromine atom, iodine atom, for example, bromine atom) or a group having the following structure. In the structure below, R^{A} to R^{D} are each independently an alkyl group having 1 to 3 carbon atoms. R^{A} to R^{D} may be a methyl group.

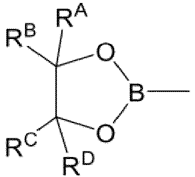

W¹ and W² in Chemical Formula I-X, W³ and W⁴ in Chemical Formula I-Y, W⁵ and W⁶ in Chemical Formula II-X, W⁷ and W⁸ in Chemical Formula II-Y, W⁹ and W¹⁰ in Chemical Formula 1', and W¹¹ and W¹² in Chemical Formula 2' may be the same or different, respectively. However, in order to suppress self-polymerization of monomers (I-x), W¹ and W² in Chemical Formula I-X may be atoms or groups that do not react with each other. Similarly, in order to inhibit self-polymerization of monomers (I-y), W³ and W⁴ in Chemical Formula I-Y may be atoms or groups that do not react with each other. Similarly, in order to inhibit self-polymerization between monomers (II-x) or monomers (II-y), W⁵ and W⁶ in Chemical Formula II-X and W⁷ and W⁸ in Chemical Formula II-Y may be atoms or groups that do not react with each other, respectively. Similarly, in order to suppress self-polymerization between monomers represented by Chemical Formula 1' or between monomers represented by Chemical Formula 2', W⁹ and W¹⁰ in Chemical Formula 1' and W¹¹ and W¹² in Chemical Formula 2' may be atoms or groups that do not react with each other, respectively. For example, W¹ and W² in Chemical Formula I-X, W² and W⁴ in Chemical Formula I-Y, W⁵ and W⁶ in Chemical Formula II-X, and W⁷ and W⁸ in Chemical Formula II-Y may each be the same. For example, W⁹ and W¹⁰ in Chemical Formula 1' may be different. Likewise, for example, W¹¹ and W¹² in Chemical Formula 2' may be different.

### Material for Electroluminescence Device

The polymeric compound according to an embodiment may be advantageously used as a material for an electroluminescence device. The polymeric compound according to an embodiment may provide a material (an organic layer, e.g., a hole transport layer) for an electroluminescence device to provide the device with excellent durability (luminescence life-span) and high luminous efficiency. Accordingly, use of the polymeric compound as a material for an electroluminescence device is provided.

The polymeric compound according to an embodiment may have a HOMO level exceeding about 5.20 eV. Accordingly, the polymeric compound according to an embodiment may also be advantageously used in a quantum dot electroluminescence device (e.g., as present in a hole transport layer thereof).

The glass transition temperature (Tg) of the polymeric compound is not particularly limited, but may be about 75 °C or higher, about 90 °C or higher, or about 100 °C or higher. Also, the upper limit is not particularly limited, but may be about 200 °C or less, for example, about 180 °C or less, for example, about 150 °C or less.

When the glass transition temperature (Tg) of the polymer is within the above range, it is desirable for device manufacturing, and a device with improved properties may be obtained. The glass transition temperature (Tg) of a polymer may be measured using a differential scanning calorimeter (DSC) (manufactured by Seiko Instruments, Inc., product name: DSC6000). The details of the measurement method are described in the examples.

### Electroluminescence Device

As described above, the polymeric compound may be advantageously used in an electroluminescence device. The electroluminescence device may include a pair of electrodes, and at least one layer of an organic film between the pair of electrodes, the at least one layer of an organic film includes the polymeric compound, or a material including the polymeric compound, for an electroluminescence device. The electroluminescence device in accordance with an embodiment may exhibit excellent luminous efficiency at low driving voltages. The electroluminescence device including a first electrode, a second electrode, and at least one layer of an organic film between the first electrode and the second electrode, where the at least one layer of the organic film includes a polymeric compound according to an embodiment. The electroluminescence device may further include a light emitting layer between the electrodes, where the light emitting layer includes a light-emitting material capable of emitting light from triplet excitons.

An embodiment includes method for manufacturing an electroluminescence device including a pair of electrodes and at least one layer of an organic film disposed between the electrodes and including a polymeric compound according to an embodiment, where the at least one layer of an organic film is formed by a coating method. Accordingly, an embodiment provides an electroluminescence device in which at least one layer of the organic film is formed by a coating method.

The polymeric compound and the electroluminescence device material (EL device material) according to an embodiment (hereinafter collectively referred to as "polymeric compound/EL device material"), As described, the polymeric compound may have excellent solubility in organic solvents. Accordingly, the polymeric compound/EL device material according to an embodiment may be advantageously used in manufacture of a device (e.g., a thin film) by a coating method (wet process). Accordingly, a liquid composition including a polymeric compound and a solvent or dispersion medium is provided. The liquid composition may further contain a known dispersant.

As described above, the material for an electroluminescence device according to an embodiment may advantageously be used in the manufacture of an EL device (e.g., a thin film) by a coating method (wet process). In view of the above, the present embodiment provides a thin film including a polymeric compound according to an embodiment.

The material for an EL device according to the present embodiment may have excellent hole injection properties and hole mobility. Accordingly, the material may advantageously be used in formation of any organic film, such as a hole injection material, a hole transport material, or a light emitting material (host). In particular, the material may advantageously be used as a hole injection material or a hole transport material, or may advantageously be used as a hole transport material.

An embodiment provides a composition including a polymeric compound and at least one material selected from a hole transport material, an electron transport material, and a light emitting material. The light emitting material included in the composition is not particularly limited but may contain at least one of semiconductor nanocrystal particles (semiconductor inorganic nanoparticles) and perovskite-type compounds (perovskite-type halides).

An electroluminescence device according to an embodiment will be described in detail with reference to the Figure. As shown in the Figure, the EL device 100 according to an embodiment comprises a substrate 110, a first electrode 120 on the substrate 110, a hole injection layer 130 on the first electrode 120, a hole transport layer 140 on the hole injection layer 130, an emitting layer 150 on the hole transport layer 140, an electron transport layer 160 on the emitting layer 150, an electron injection layer 170 on the electron transport layer 160, and a second electrode 180 on the electron injection layer 170.

The polymeric compound according to an embodiment may be included in, for example, one organic film (organic layer) between the first electrode 120 and the second electrode 180. Specifically, the polymeric compound may be included in a hole injection layer 130 as a hole injection material, a hole transport layer 140 as a hole transport material, or in a light emitting layer 150 as a light emitting material (host). The polymeric compound may be included in the hole injection layer 130 as a hole injection material or in the hole transport layer 140 as a hole transport material. For example, the polymeric compound may be included in the hole transport layer 140 as a hole transport material, that is, in an embodiment, the organic film including the polymeric compound may be present in a hole transport layer, a hole injection layer, or a light emitting layer. In an embodiment, the hole transport layer may consist of the polymeric compound, or the hole injection layer may consist of the polymeric compound.

An organic film including a polymeric compound/EL device material may be formed by a coating method (solution coating method). For example, the organic film may be formed using a solution coating method such as a spin coat method, a casting method, a micro gravure coat method, a gravure coat method, a bar coat method, a roll coat method, a wire bar coat method, a dip coat method, a spray coat method, a screen printing method, a flexographic printing method, an offset printing method, or an ink jet printing method.

A solvent that can dissolve the polymeric compound/EL device material may be used to provide the solution for the coating method, and may be appropriately selected depending on the type of polymeric compound used. Examples thereof may include toluene, xylene, ethylbenzene, diethylbenzene, mesitylene, propylbenzene, cyclohexylbenzene, dimethoxybenzene, anisole, ethoxytoluene, phenoxytoluene, isopropylbiphenyl, dimethylanisole, phenyl acetate, phenyl propionate, methyl benzoate, ethyl benzoate, or cyclohexane, etc. An amount of solvent used is not particularly limited, but considering ease of application, etc., the amount is such that the concentration of the polymeric compound may be, for example, greater than or equal to about 0.1 mass% and less than or equal to about 10 mass% or less, or for example, greater than or equal to about 0.5 mass% and less than or equal to about 5 mass%.

There is no particular limitation on the method for forming a film other than an organic film including a polymeric compound/EL device material. A layer other than an organic film including a polymeric compound/EL device material according to an embodiment may be formed by, for example, a vacuum deposition method or a solution coating method.

The substrate 110 may be a substrate used as a general EL device. For example, the substrate 110 may be a semiconductor substrate such as, for example, a glass substrate, a silicon substrate, or a transparent plastic substrate.

The first electrode 120 is formed on the substrate 110. The first electrode 120 may be, for example, an anode, and may be formed by a metal, an alloy, a conductive compound, or the like having a large work function. For example, the first electrode 120 may be formed as a transparent electrode using indium tin oxide (In₂O₃-SnO₂: ITO), indium zinc oxide (In₂O₃-ZnO), tin oxide (SnO₂), or zinc oxide (ZnO), etc., which has excellent transparency and conductivity. The first electrode 120 may be formed as a reflective electrode by laminating magnesium (Mg), aluminum (Al), etc. on the transparent conductive film. After forming the first electrode 120 on the substrate 110, if necessary, cleaning and UV-ozone treatment may be performed.

The hole injection layer 130 may be formed on the first electrode 120. The hole injection layer 130 may be a layer that facilitates the injection of holes from the first electrode 120, and specifically, may be formed to have a thickness (dry film thickness; the same applies hereinafter) of, for example, about 10 nm to about 1000 nm, or for example, about 20 nm to about 50 nm.

The hole injection layer 130 may be formed using a known hole injection material. The known hole injection materials forming the hole injection layer 130 may include, for example, poly(ether ketone)-containg triphenylamine (TPAPEK), 4-isopropyl-4'-methyldiphenyliodonium tetrakis(pentafluorophenyl)borate (PPBI), N,N'-diphenyl-N,N'-bis-[4-(phenyl-m-tolyl-amino)-phenyl]-biphenyl-4,4'-diamine (DNTPD), copper phthalocyanine, 4,4',4"-tris(3-methylphenylphenylamino)triphenylamine (m-MTDATA), N,N'-di(1-naphthyl)-N,N'-diphenylbenzidine (NPB), 4,4',4"-tris(diphenylamino)triphenylamine (TDATA), 4,4',4"-tris(N,N-2-naphthylphenylamino)triphenylamine (2-TNATA), polyaniline/dodecylbenzenesulphonic acid, poly(3,4-ethylenedioxythiophene)/poly(4-styrenesulfonate): PEDOT/PSS, or polyaniline/10-camphorsulfonic acid.

The hole transport layer 140 may be formed on the hole injection layer 130. The hole transport layer 140 may be a layer having a function of transporting holes, and may be formed with a thickness of, for example, about 10 nm to about 150 nm, for example, about 20 nm to about 50 nm. The hole transport layer 140 may be formed by a solution coating method using a polymeric compound according to an embodiment. As demonstrated, the durability (luminescence life-span) of the EL device 100 may be extended by the presence of the polymeric compound in the hole transport layer. Moreover, it al also demonstrated that an improvement in the current efficiency of the EL device 100 and/or reduction in the driving voltage is also achieved. Moreover, because the hole transport layer may be formed by a solution coating method, a large-area film may be efficiently formed.

When another organic film of the EL device 100 includes a polymeric compound according to an embodiment, the hole transport layer 140 may be formed of a known hole transport material. The known hole transport materials may include, for example, a carbazole derivative such as 1,1-bis[(di-4-tolylamino)phenyl]cyclohexane (TAPC), N-phenylcarbazole and polyvinylcarbazole, N,N'-bis(3-methylphenyl)-N,N'-diphenyl-[1,1-biphenyl]-4,4'-diamine (TPD), 4,4',4"-tris(N-carbazolyl)triphenylamine (TCTA), or N,N'-di(1-naphthyl)-N,N'-diphenylbenzidine (NPB), etc.

The light emitting layer 150 may be formed on the hole transport layer 140. The light emitting layer 150 may be a layer that emits light by fluorescence, phosphorescence, etc., and may be formed using a vacuum deposition method, spin coating method, inkjet printing method, etc. The light emitting layer 150 may be formed with a thickness of, for example, greater than or equal to about 10 nm and less than or equal to about 60 nm, or for example, greater than or equal to about 20 nm and less than or equal to about 50 nm. As the light emitting material of the light emitting layer 150, any known light emitting material may be used. The light emitting material included in the light emitting layer 150 may be a light emitting material capable of light emission from triplet excitons (i.e., phosphorescence). In this case, the life-span and luminous efficiency of the EL device 100 may be further improved.

The light emitting layer 150 is not particularly limited and may have a known configuration. For example, the light emitting layer includes at least one of semiconductor nanocrystal particles and a perovskite-type compound. That is, in an embodiment, the organic film may have a light emitting layer including at least one of semiconductor nanocrystal particles and a perovskite-type compound. When the emitting layer includes semiconductor nanocrystal particles, the EL device may be a quantum dot electroluminescence device (QLED), a quantum dot light emitting device, or a quantum dot light emitting diode. In addition, when the emitting layer includes a perovskite compound (perovskite halide), the EL device is a perovskite electroluminescence device (PeLED) or a perovskite light emitting device.

In the form of a light emitting layer including semiconductor nanocrystal particles (QLED), the light emitting layer is a single layer or multiple layers of a plurality of semiconductor nanocrystal particles (quantum dots). Semiconductor nanocrystal particles (quantum dots) are particles of a certain size that have a quantum confinement effect. The diameter of semiconductor nanocrystal particles (quantum dots) is not particularly limited, but may be approximately about 1 nm to about 20 nm.

The semiconductor nanocrystal particles (quantum dots) arranged in the light emitting layer may be synthesized by a wet chemical process, an organometallic chemical vapor deposition process, a molecular beam epitaxy process, or other similar processes. Among these, the wet chemical process is a method of growing particles by adding precursor materials to an organic solvent.

In a wet chemical process, when a crystal grows, an organic solvent is naturally distributed to the surface of the quantum dot crystal and acts as a dispersant, thereby controlling a growth of the crystal. Accordingly, in wet chemical processes, the growth of semiconductor nanocrystal particles may be controlled easily and at low cost compared to vapor deposition methods such as metal organic chemical vapor deposition (MOCVD) or molecular beam epitaxy (MBE).

Semiconductor nanocrystal particles (quantum dots) may control the energy band gap by controlling their size, whereby light of various wavelengths may be obtained from the light emitting layer (quantum dot light emitting layer). By using multiple quantum dots of different sizes, it is possible to create a display that emits (or emits light) light of multiple wavelengths. The size of the quantum dots may be selected to emit red, green, or blue light, enabling color displays to be constructed. Additionally, the size of the quantum dots may be combined to emit white light with various colors.

As the semiconductor nanocrystal particles (quantum dots), a semiconductor material selected from a Group II-VI semiconductor compound; a Group III-V semiconductor compound; a Group IV-VI group semiconductor compound; a Group IV element or compound; or a combination thereof may be used.

The Group II-VI semiconductor compound is not particularly limited, and examples thereof may include a binary compound selected from CdSe, CdTe, ZnS, ZnSe, ZnTe, ZnO, HgS, HgSe, HgTe, and a mixture thereof; a ternary compound selected from CdSeS, CdSeTe, CdSTe, ZnSeS, ZnTeSe, ZnSTe, HgSeS, HgSeTe, HgSTe, CdZnS, CdZnSe, CdZnTe, CdHgS, CdHgSe, CdHgTe, HgZnS, HgZnSe, HgZnTe, or a mixture thereof; and a quaternary compound selected from CdZnSeS, CdZnSeTe, CdZnSTe, CdHgSeS, CdHgSeTe, CdHgSTe, HgZnSeS, HgZnSeTe, HgZnSTe, or a mixture thereof.

The Group III-V semiconductor compound is not particularly limited, and examples thereof may include a binary compound selected from GaN, GaP, GaAs, GaSb, AIN, AlP, AlAs, AlSb, InN, InP, InAs, InSb, or a mixture thereof; a ternary compound selected from GaNP, GaNAs, GaNSb, GaPAs, GaPSb, AINP, AlNAs, AlNSb, AlPAs, AlPSb, InNP, InNAs, InNSb, InPAs, InPSb, or a mixture thereof; and a quaternary compound selected from GaAlNP, GaAINAs, GaAINSb, GaAlPAs, GaAlPSb, GalnNP, GalnNAs, GaInNSb, GalnPAs, GalnPSb, InAlNP, InAlNAs, InAlNSb, InAlPAs, InAlPSb, or a mixture thereof.

The Group IV-VI semiconductor compound is not particularly limited, and examples thereof may include a binary compound selected from SnS, SnSe, SnTe, PbS, PbSe, PbTe, or a mixture thereof; a ternary compound selected from SnSeS, SnSeTe, SnSTe, PbSeS, PbSeTe, PbSTe, SnPbS, SnPbSe, SnPbTe, or a mixture thereof; and a quaternary compound selected from SnPbSSe, SnPbSeTe, SnPbSTe, or a mixture thereof.

The Group IV element or compound is not particularly limited, and examples thereof may include a single elemental selected from Si, Ge, or a mixture thereof; ot a binary elemental compound selected from SiC, SiGe, or a mixture thereof.

The semiconductor nanocrystal particles (quantum dots) may have a homogeneous single structure or a core-shell dual structure. The core and shell may include different materials. The material constituting each of core and shell may be composed of different semiconductor compounds. The energy bandgap of the shell material may be larger than the energy bandgap of the core material. For example, the core-shell structures may be ZnTeSe/ZnSe/ZnS, InP/ZnSe/ZnS, CdSe/ZnS, InP/ZnS, etc.

A process for making a quantum dot having a core (CdSe)/shell (ZnS) structure is described. First, a core (CdSe) precursor material such as (CH₃)₂Cd (dimethylcadmium) and TOPSe (trioctylphosphine selenide) is injected into an organic solvent using TOPO (trioctylphosphine oxide) as a surfactant to form a crystal. At this time, after maintaining the crystal at a high temperature for a certain period of time so that it grows to a certain size, a precursor material for the shell (ZnS) is injected to form a shell on the surface of the already formed core. This allows the production of TOPO-capped CdSe/ZnS quantum dots.

In a form (PeLED) in which the light emitting layer includes a perovskite-type compound (perovskite-type halide), the light emitting layer 150 may include a compound having a perovskite-type crystal structure (perovskite-type compound). The perovskite-type compound may include, for example, organic-inorganic hybrid materials or inorganic materials having a perovskite-type crystal structure represented by a general formula: ApMqXr.

In the above general formula, A may be at least one cation selected from a cation of an alkali metal element and an organic cation, M may be a cation of at least one metal element selected from a Group 14 element such as Ge, Sn, or Pb; a Group 15 element such as Sb or Bi; or a transition metal such as Cu, Ni, Co, Fe, Mn, Cr, Pd, Cd, or Ag, X may be at least one anion selected from a halide ion such as CI, Br, or I; cyanide, thiocyanate, isothiocyanate, or sulfide, p may represent an integer of 1 or more and 4 or less, q may represent 1 or 2, and r may represent an integer of 3 or more and 9 or less.

The A may include, for example, an alkali metal ion such as Li, Na, K, Rb, or Cs; or an organic cation such as an ammonium ion, a methylammonium ion, a formamidinium ion, a guanidium ion, an imidazolium ion, a pyridinium ion, or a pyridinium ion.

Specific examples of the perovskite compound may include, for example, the following compounds: CsPbI₃, CsSnI₃, CsPbBr₃, CsSnBr₃, CsPbCl₃, CsSnCl₃, RbPbI₃, RbSnI₃, RbPbBr₃, RbSnBr₃, RbPbCl₃, or RbSnCl₃, etc.

The perovskite compound may be obtained by known methods. The perovskite compound may be obtained by any one of the following methods: wet synthesis, dry synthesis by milling, and *in situ* synthesis.

The average particle diameter of the perovskite compound is not particularly limited, and may be, for example, greater than or equal to about 1 nm and less than or equal to about 100 nm, greater than or equal to about 1 nm and less than or equal to about 50 nm, or, for example, greater than or equal to about 1 nm and less than or equal to about 30 nm.

The perovskite-type compound may have a ligand on its surface. By coordinating appropriate ligands to the perovskite compound, the photoluminescence quantum yield may be improved. Examples of such a ligand may include, but are not particularly limited to, a crosslinking ligand compound such as an organic ammonium ion, an organic acid compound having two or more unsaturated bonds, or an organic base compound.

The method for forming the light emitting layer is not particularly limited. The light emitting layer may be formed by coating a coating solution including at least one of semiconductor nanocrystal particles and a perovskite-type compound (solution coating method). As a solvent constituting the coating solution, a solvent that does not dissolve the material in the hole transport layer, for example, a hole transport material, for example, a polymeric compound, may be selected.

The electron transport layer 160 may be formed on the light emitting layer 150. The electron transport layer 160 may be a layer that has the function of transporting electrons and may be formed by using a vacuum deposition method, spin coating method, inkjet method, or the like. The electron transport layer 160 may be formed to have a thickness of, for example, greater than or equal to about 15 nm and less than or equal to about 50 nm.

The electron transport layer 160 may be formed of a known electron transport material. Examples of known electron transport materials may include (8-quinolinolato)lithium (lithium quinolate, Liq), tris(8-quinolinolato)aluminium (Alq₃), or a compound having a nitrogen-containing aromatic ring. Examples of the compound having a nitrogen-containing aromatic ring may include a compound including a pyridine ring, such as, for example, 1,3,5-tri[(3-pyridyl)-phen-3-yl]benzene, a compound including a triazine ring, such as, for example, 2,4,6-tris(3'-(pyridin-3-yl)biphenyl-3-yl)-1,3,5-triazine, a compound including an imidazole ring, such as, for example, 2-(4-(N-phenylbenzimidazol-1-yl-phenyl)-9,10-dinaphthylanthracene or 1,3,5-tris(N-phenyl-benzimidazol-2-yl)benzene (TPBI). The electron transport material may be used alone or as a mixture of two or more types.

The electron injection layer 170 may be formed on the electron transport layer 160. The electron injection layer 170 may be a layer that has the function of facilitating the injection of electrons from the second electrode 180. The electron injection layer 170 may be formed by using a vacuum deposition method or the like. The electron injection layer 170 may be formed to have a thickness of, for example, greater than or equal to about 0.1 nm and less than or equal to about 5 nm, or for example, greater than or equal to about 0.3 nm and less than or equal to about 2 nm. Any known material may be used as a material for forming the electron injection layer 170. For example, the electron injection layer 170 may be formed by a lithium compound such as, for example, (8-quinolinato)lithium (lithium quinolate, Liq), lithium fluoride (LiF), sodium chloride (NaCl), cesium fluoride (CsF), lithium oxide (Li₂O), or barium oxide (BaO).

The second electrode 180 may be formed on the electron injection layer 170. The second electrode 180 may be formed by using a vacuum deposition method or the like. The second electrode 180 may be, for example, a cathode, and may be formed by a metal, alloy, or conductive compound having a small work function. For example, the second electrode 180 may be formed as a reflective electrode using a metal, such as, for example, lithium (Li), magnesium (Mg), aluminum (Al), calcium (Ca), or an alloy, such as, for example, aluminum-lithium (Al-Li), magnesium-indium (Mg-In), or magnesium-silver (Mg-Ag). The second electrode 180 may be formed with a thickness of, for example, from about 10 nm to about 200 nm, for example, from about 50 nm to about 150 nm. Alternatively, the second electrode 180 may be formed as a transparent electrode by a thin film of the metal material having a thickness of 20 nm or less, a transparent conductive film, such as, for example, indium tin oxide (In₂O₃-SnO₂) or indium zinc oxide (In₂O₃-ZnO).

As described above, as an example of an electroluminescence device according to an embodiment, an EL device 100 according to the present embodiment has been described. The EL device 100 according to the present embodiment may improve durability (luminescence life-span) and luminous efficiency (current efficiency) with a good balance by including an organic film (e.g., a hole transport layer or a hole injection layer) including a polymeric compound according to an embodiment.

The stacked structure of the EL device 100 according to an embodiment is not limited to the above example. The EL device 100 according to an embodiment may be formed in another known stacked structure. For example, the EL device 100 may omit one or more of the hole injection layer 130, the hole transport layer 140, the electron transport layer 160, or the electron injection layer 170, and may additionally include another layer. Additionally, each layer of the EL device 100 may be formed as a single layer or as multiple layers.

For example, the EL device 100 may further include a hole blocking layer between the hole transport layer 140 and the light emitting layer 150 to prevent electrons or holes from diffusing into the electron transport layer 160. And, the hole blocking layer may be formed by, for example, an oxadiazole derivative, a triazole derivative, or a phenanthroline derivative.

In addition, the polymeric compound according to an embodiment may be applied to electroluminescence devices other than the QLED or PeLED. Other electroluminescence devices to which the polymeric compound according to an embodiment may be applied include, but are not particularly limited to, organic electroluminescence devices.

An embodiment may include the following aspects and forms.
1. A polymeric compound comprising a structural unit (A) represented by Chemical Formula 1: 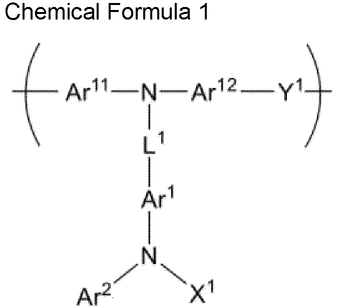 In Chemical Formula 1,
   Ar¹¹ and Ar¹² may each independently be a substituted or unsubstituted aromatic hydrocarbon group having 6 to 25 ring-forming atoms,
   Ar¹¹ and Ar¹² may optionally be linked to each other to form a ring,
   L¹ may be a substituted or unsubstituted aromatic hydrocarbon group having 6 to 25 ring-forming atoms, or a substituted or unsubstituted heteroaromatic group having 5 to 25 ring-forming atoms,
   Ar¹ may be a substituted or unsubstituted aromatic hydrocarbon group having 6 to 25 ring-forming atoms,
   Ar² may be a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
   X¹ may be a substituted or unsubstituted aromatic hydrocarbon group having 6 to 25 ring-forming atoms, or a substituted or unsubstituted heteroaromatic group having 5 to 25 ring-forming atoms, and
   Y' may be a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms.
2. The polymeric compound described in 1 above, wherein the structural unit (A) may be represented by Chemical Formula 1-1: 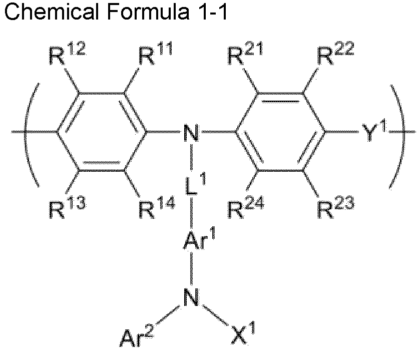 In Chemical Formula 1-1,
   R¹¹ to R¹⁴ and R²¹ to R²⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be bonded with each other to form a ring, and
   L¹, Ar¹, Ar², X¹, and Y' are the same as defined in Chemical Formula 1.
3. A polymeric compound comprising a structural unit (B) represented by Chemical Formula 2: 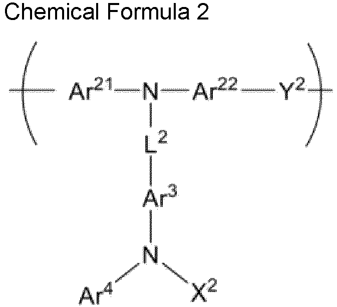 In Chemical Formula 2,
   Ar²¹ and Ar²² may each independently be a substituted or unsubstituted aromatic hydrocarbon group having 6 to 25 ring-forming atoms,
   Ar²¹ and Ar²² may optionally be linked to each other to form a ring,
   L² may be a substituted or unsubstituted aromatic hydrocarbon group having 6 to 25 ring-forming atoms, or a substituted or unsubstituted heteroaromatic group having 5 to 25 ring-forming atoms,
   Ar³ may be a substituted or unsubstituted aromatic hydrocarbon group having 6 to 25 ring-forming atoms,
   Ar⁴ may be a substituted or unsubstituted aromatic hydrocarbon group having 6 to 25 ring-forming atoms, or a substituted or unsubstituted heteroaromatic group having 5 to 25 ring-forming atoms, and Ar⁴ may form a ring with Ar³,
   X² may be a substituted or unsubstituted aromatic hydrocarbon group having 6 to 25 ring-forming atoms, or a substituted or unsubstituted heteroaromatic group having 5 to 25 ring-forming atoms,
   Y² may be an aromatic hydrocarbon group having 6 to 25 ring-forming atoms, substituted or unsubstituted with an alkyl group having 1 to 14 carbon atoms, and
   Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.
4. The polymeric compound described in 3 above, wherein the structural unit (B) may be represented by Chemical Formula 2-1: 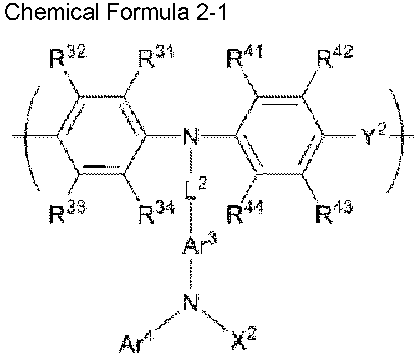 In Chemical Formula 2-1,
   R³¹ to R³⁴ and R⁴¹ to R⁴⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be bonded with each other to form a ring,
   L², Ar³, Ar⁴, X², and Y² may be the same as defined in Chemical Formula 2, and
   R³¹ to R³⁴, R⁴¹ to R⁴⁴, L², Ar³, Ar⁴, and X² do not have a thiol group-containing alkyl group having 1 to 14 carbon atoms, and do not have a thiol group-containing alkoxyalkyl group having 2 to 14 carbon atoms.
5. The polymeric compound described in 3 or 4 above, wherein a molar ratio of the structural unit (A) may be greater than or equal to about 1 mol% and less than about 30 mol% (when the total molar ratios of the structural unit (A) and the structural unit (B) is 100 mol%).
6. The polymeric compound described in any one of 3 to 5 above, wherein Ar¹¹ in Chemical Formula 1 may be the same as Ar²¹ in Chemical Formula 2,
   Ar¹² in Chemical Formula 1 may be the same as Ar²² in Chemical Formula 2,
   L¹ in Chemical Formula 1 may be the same as L² in Chemical Formula 2,
   Ar¹ in Chemical Formula 1 may be the same as Ar³ in Chemical Formula 2,
   Ar² in Chemical Formula 1 may be the same as Ar⁴ in Chemical Formula 2, and
   X¹ in Chemical Formula 1 may be the same as X² in Chemical Formula 2.
7. The polymeric compound described in any one of 4 or 5 above, wherein R¹¹ in Chemical Formula 1-1 may be the same as R³¹ in Chemical Formula 2-1, R¹² in Chemical Formula 1-1 may be the same as R³² in Chemical Formula 2-1, R¹³ in Chemical Formula 1-1 may be the same as R³³ in Chemical Formula 2-1, R¹⁴ in Chemical Formula 1-1 may be the same as R³⁴ in Chemical Formula 2-1, R²¹ in Chemical Formula 1-1 may be the same as R⁴¹ in Chemical Formula 2-1, R²² in Chemical Formula 1-1 may be the same as R⁴² in Chemical Formula 2-1, R²³ in Chemical Formula 1-1 may be the same as R⁴³ in Chemical Formula 2-1, R²⁴ in Chemical Formula 1-1 may be the same as R⁴⁴ in Chemical Formula 2-1, L¹ in Chemical Formula 1-1 is the same as L² in Chemical Formula 2-1, Ar¹ in Chemical Formula 1-1 may be the same as Ar³ in Chemical Formula 2-1, Ar² in Chemical Formula 1-1 may be the same as Ar⁴ in Chemical Formula 2-1, and X¹ in Chemical Formula 1-1 may be the same as X² in Chemical Formula 2-1.
8. The polymeric compound described in any one of 1 to 6 above, wherein the Y' in Chemical Formula 1 may be an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms, and wherein the thiol group-containing alkoxyalkyl group substituted to the aromatic hydrocarbon group having 6 to 25 ring-forming atoms may have a structure represented by Chemical Formula i-1:

   Chemical Formula i-1 *-Z¹-O-Z²-SH

   In Chemical Formula i-1,
   Z¹ may represent an alkylene group having 1 to 14 carbon atoms, substituted or unsubstituted with a thiol group,
   Z² may represent an alkylene group having 1 to 13 carbon atoms, substituted or unsubstituted with a thiol group,
   a sum of the carbon number of the alkylene group represented by Z¹ and the carbon number of the alkylene group represented by Z² may be an integer of 14 or less, and
   * is bonded to a ring carbon of the aromatic hydrocarbon group having 6 to 25 ring-forming atoms.
9. The polymeric compound described in any one of 1 to 6 above, wherein the Y' in Chemical Formula 1 may be an aromatic hydrocarbon group having 6 to 25 ring-forming atoms substituted with a thiol group-containing alkyl group having 1 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms, and wherein the thiol group-containing alkyl group substituted to the aromatic hydrocarbon group having 6 to 25 ring-forming atoms may have a structure represented by Chemical Formula i-2:

   Chemical Formula i-2 *-Z¹-SH

   In Chemical Formula i-2,
   Z¹ may represent an alkylene group having 1 to 14 carbon atoms, substituted or unsubstituted with a thiol group, and
   * is bonded to a ring carbon of the aromatic hydrocarbon group having 6 to 25 ring-forming atoms.
10. The polymeric compound described in any one of 1 to 6above, wherein the Y' in Chemical Formula 1 may be an aromatic hydrocarbon group having 6 to 25 ring-forming atoms, substituted with a thiol group-containing alkoxyalkyl group having 2 to 14 carbon atoms.
11. The polymeric compound described in any one of 1 to 7 above, wherein the thiol group-containing alkoxyalkyl group may have two or more thiol groups.
12. The polymeric compound described in any one of 1 to 7 above, wherein Y' in Chemical Formula 1 may be an aromatic hydrocarbon group having 6 to 25 ring-forming atoms, substituted with a thiol group-containing alkyl group having 1 to 10 carbon atoms.
13. The polymeric compound described in any one of 1 to 11 above, wherein in Chemical Formula 1, Y' may be one of the groups represented by Chemical Formulas (3-1) to (3-6): 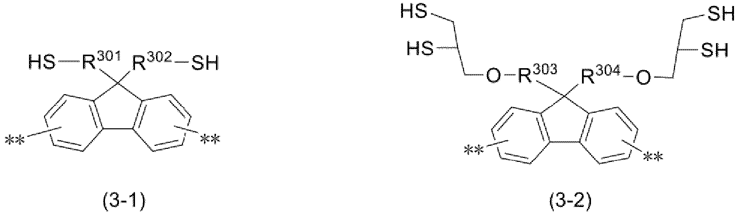 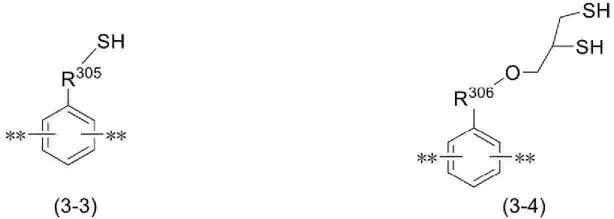 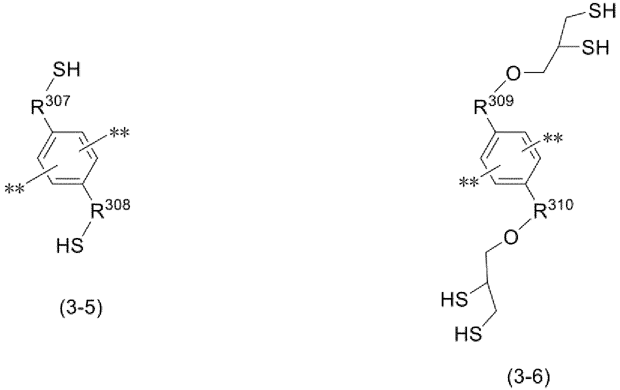 In Chemical Formulas (3-1) to (3-6),
   R³⁰¹, R³⁰², R³⁰⁵, R³⁰⁷, and R³⁰⁸ may each independently be a substituted or unsubstituted alkylene group having 1 to 14 carbon atoms,
   R³⁰³, R³⁰⁴, R³⁰⁶, R³⁰⁹, and R³¹⁰ may each independently be a substituted or unsubstituted alkylene group having 1 to 11 carbon atoms, and
   ** indicates a binding site.
14. The polymeric compound described in 12 above, wherein Y' in Chemical Formula 1 may be a group represented by Chemical Formula (3-1) or (3-2).
15. The polymeric compound described in any one of 1 to 13 above, wherein in Chemical Formula 1, L¹ may be any one of the groups represented by Chemical Formulas (4-1) to (4-24): 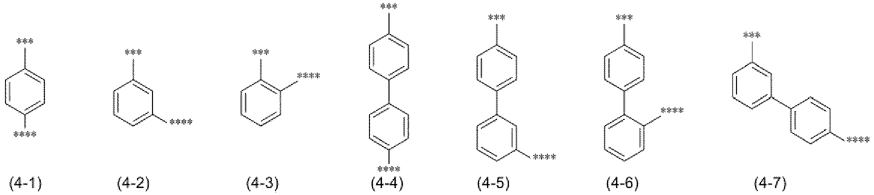 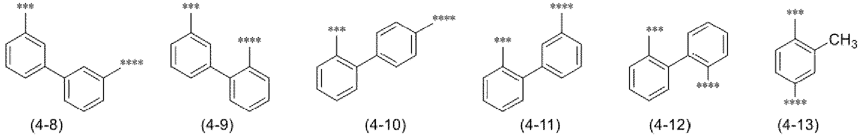 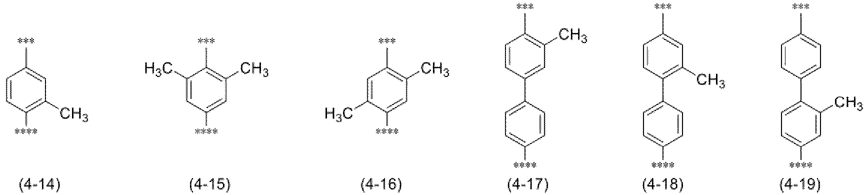 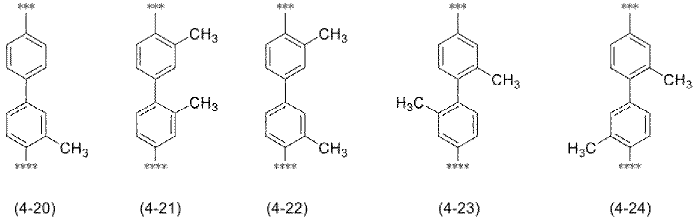 In Chemical Formulas (4-1) to (4-24),
   *** binds to the nitrogen atom, and **** binds to Ar¹.
16. The polymeric compound described in any one of 1 to 14 above, wherein in Chemical Formula 1, -L¹-Ar¹-N(Ar²)(X¹) may be any one of the groups represented by Chemical Formulas (5-1) to (5-3): 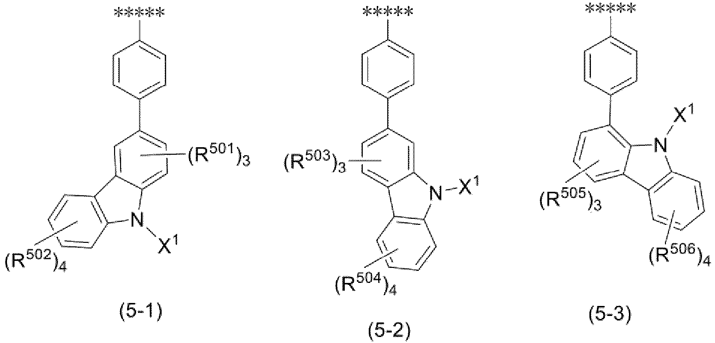 In Chemical Formulas (5-1) to (5-3),
   R⁵⁰¹ to R⁵⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
   X¹ may be the same as defined in Chemical Formula 1, and
   ***** binds to a nitrogen atom.
17. An electroluminescence device material comprising a polymeric compound described in any one of 1 to 16 above.
18. A liquid composition comprising the polymeric compound as described in any one of 1 to 16 above and at least a solvent.
19. An electroluminescence device, comprising a first electrode, a second electrode, and at least one layer of an organic film between the first electrode and the second electrode,
   wherein the at least one layer of the organic film may comprise the polymeric compound described in any one of 1 to 16.
20. The electroluminescence device described in 19 above, wherein the at least one of the organic film including the polymeric compound may be a hole transport layer or a hole injection layer.
21. The electroluminescence device described in 19 or 20 above, wherein the organic film may have a light emitting layer including at least one of a semiconductor nanoparticle and a perovskite compound.

### Examples

The present disclosure is described in more detail using the following examples and comparative examples. However, the technical range of the present disclosure is not limited to the following examples. In the following examples, unless specifically described, each operation was performed at room temperature (25 °C). In addition, unless specifically stated, "%" and "a part" mean "mass%" and "a part by mass", respectively. In addition, in the chemical formulas below, the description of "CₘH₂ₘ₊₁ (m is an integer)" indicating an alkyl group indicates a linear alkyl group unless specifically limited.

### Synthesis Example 1: Synthesis of Compound M-1

Compound M-1 is synthesized according to Reaction Scheme 1.

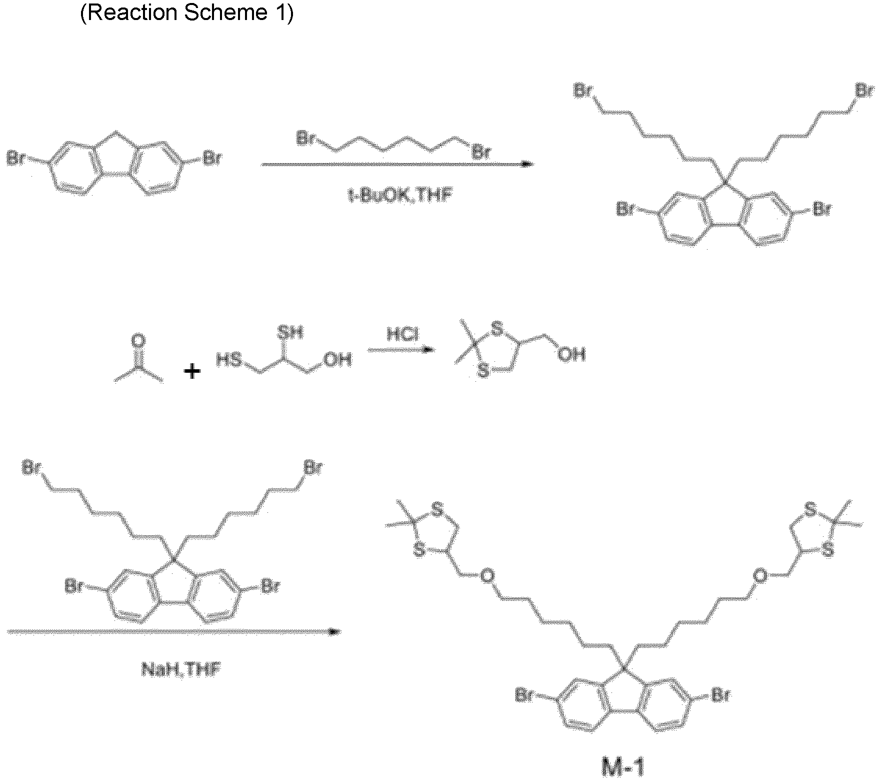

Specifically, 2,7-dibromofluorene (26.4 g) and tetrahydrofuran (THF) (400 mL) were added to a 1 L-four-necked (reaction) flask and stirred at 0 °C under a nitrogen atmosphere. Subsequently, tert-butoxy potassium (t-BuOK, 27.0 g) was added thereto, and stirred at 0 °C for 10 minutes. A solution prepared by dissolving 1,6-dibromohexane (414 g) in THF (180 mL) was slowly added dropwise to the reaction flask and stirred at 0 °C for 30 minutes. After adding 200 mL of water to the reaction flask and following removal of the solvent under reduced pressure, extraction of the product was performed with ethyl acetate. After separating an aqueous layer, the organic layer was dried with magnesium sulfate. After removing the volatile organics and unreacted 1,6-dibromohexane under reduced pressure, the solid was washed with hexane to obtain 2,7-dibromo-9,9-bis(6-bromohexyl)-9H-fluorene (40.9 g).

In a 200 mL-four-necked (reaction) flask, 2,3-dimercapto-1-propanol (25.0 g) and acetone (100 mL) were added, one drop of 10N-HCl was added thereto, and stirred at room temperature for 12 hours. 25 g of magnesium sulfate was added thereto, and stirred for 1 hour. The magnesium sulfate was filtered off and the acetone was removed under reduced pressure to obtain (2,2-dimethyl-1,3-dithiolan-4-yl)methanol (31.6 g).

(2,2-dimethyl-1,3-dithiolan-4-yl)methanol (3.10 g), 2,7-dibromo-9,9-bis(6-bromohexyl)-9H-fluorene (5.83 g), and THF (38 mL) were charged into a 50 mL-four-necked (reaction) flask, and stirred under a nitrogen atmosphere at 0 °C. 64%-NaH (1.05 g) was added thereto and stirred for 30 minutes, and then, further be stirred at room temperature for 3 days. Additional NaH (0.3 g) was then added to the reaction flask, and the reaction mixture was additionally stirred for 1 hour. Subsequently, the temperature of the reaction mixture was reduced to 0 °C and stirred as methanol was added to quench the reaction. After removing volatile organics under reduced pressure, extraction of the product residue was performed with ethyl acetate. A collected organic layer was washed with water, separated, and dried with magnesium sulfate. After removing solvent under reduced pressure, the product residue was purified through column chromatography (silica gel, hexane/dichloromethane) to obtain Compound M-1 (1.07 g).

### Synthesis Example 2: Synthesis of Compound M-2

Compound M-2 is synthesized according to Reaction Scheme 2.

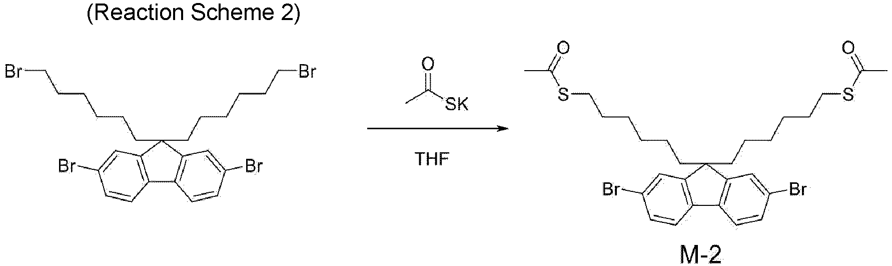

Specifically, 2,7-dibromo-9,9-bis(6-bromohexyl)-9H-fluorene (10.6 g) obtained in the same manner as in Synthesis Example 1, potassium thioacetate (5.28 g), and THF (154 mL) were charged into a 300 mL-four-necked flask and stirred under a nitrogen atmosphere at 60 °C for 3 hours. The resulting mixture was cooled to room temperature, and ion-exchange water (100 mL) was added to the mixture to separate an organic layer. The aqueous layer was extracted with dichloromethane (100 mL×3), combined with the organic layer, washed with saturated brine (100 mL×3), separated from the aqueous layer, and dried with magnesium sulfate. After removing the volatile organics under reduced pressure, the product residue was purified through column chromatography (silica gel, hexane/toluene) to obtain Compound M-2 (7.84 g).

### Synthesis Example 3: Synthesis of Compound C-1

Compound C-1 is synthesized according to Reaction Scheme 3.

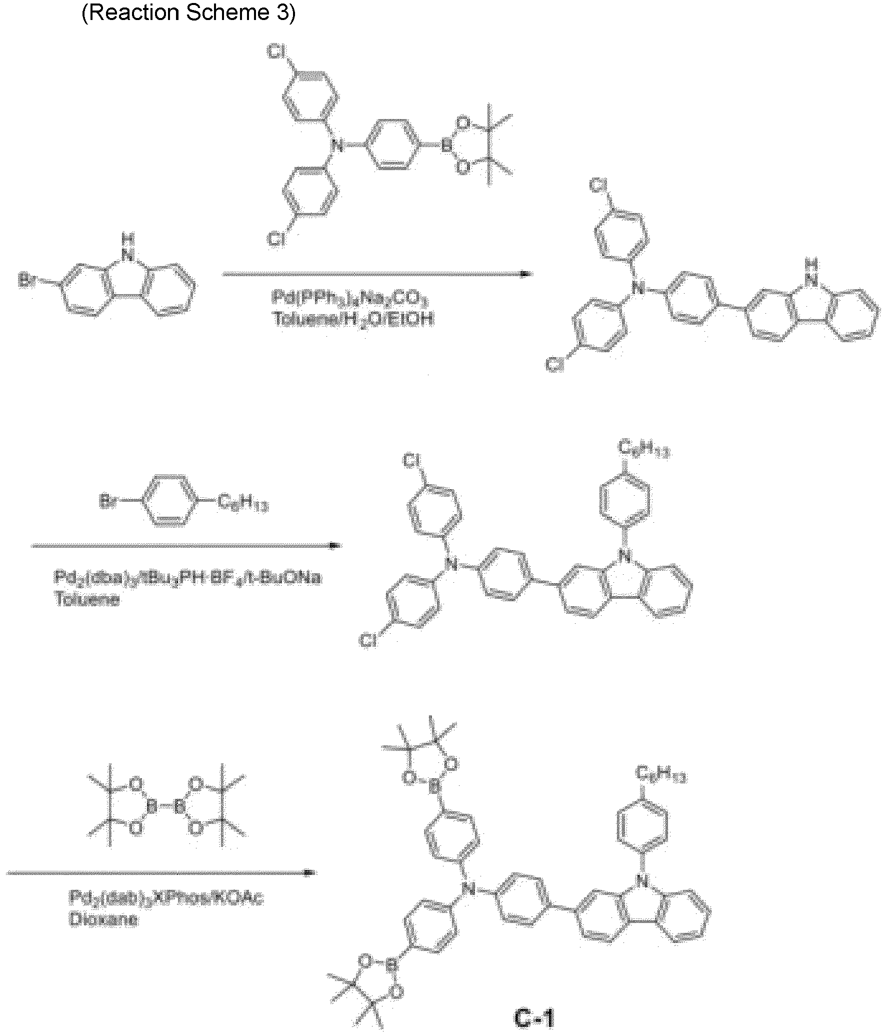

Specifically, 2-bromocarbazole (20.0 g), 4-chloro-N-(4-chlorophenyl)-N-(4-(4,4,5,5-tetramethyl-1,3,2-dioxaborane-2-yl)phenyl)aniline (10.0 g), sodium carbonate (4.84 g), tetrakis(triphenylphosphine)palladium (0) (Pd(PPh₃)₄, 1.31 g), toluene (80 mL), ethanol (30 mL), and water (30 mL) were charged into a 100 mL-four-necked (reaction) flask, and stirred at 100 °C (a bath temperature) for 3 hours. After cooling to room temperature, an aqueous layer was separated and removed, and the organic layer was washed with water (100 mL×2), separated, and dried with magnesium sulfate. After removing organic volatiles under a reduced pressure, toluene (200 mL) was added to the residue, refluxed at 60 °C for 1 hour, and a solid was filtered, collected and dried to obtain N-(4-(9-carbazole-2-yl)phenyl)-4-chloro-N-(4-chlorophenyl)aniline (6.08 g).

Subsequently, the obtained N-(4-(9-carbazole-2-yl)phenyl)-4-chloro-N-(4-chlorophenyl)aniline (6.00 g), 1-bromo-4-hexylbenzene (3.00 g), tris(dibenzylideneacetone)dipalladium (Pd₂(dba)₃, 0.580 g), tri-tert-butylphosphoniumtetrafluoroborate (t-Bu₃PH·BF₄, 0.276 g), sodium tert-butoxide (t-BuONa, 2.43 g), and toluene (60 mL) were charged into a four-necked flask substituted with argon and heated at 110 °C for 7 hours. After cooling to room temperature, impurities were filtered out with Celite. After distilling solvent under reduced pressure, the product residue was purified through column chromatography to obtain 4-chloro-N-(4-chlorophenyl)-N-(4-(9-(4-hexylphenyl)-9-carbazole-2-yl)phenyl)aniline (1.60 g).

The obtained 4-chloro-N-(4-chlorophenyl)-N-(4-(9-(4-hexylphenyl)-9-carbazole-2-yl)phenyl)aniline (1.60 g), bispinacol diborate (1.90 g), potassium acetate (KOAc,1.47g), tris(dibenzylideneacetone)dipalladium (Pd₂(dba)₃, 0.114 g), Xphos (0.177 g), and 1,4-dioxane (16 mL) were charged into a 50 mL-3-neck flask and stirred under a nitrogen atmosphere at a bath temperature of 100 °C for 3 hours. After cooling to room temperature, insoluble matters were removed with Cellite as a filter agent. After removing solvent under a reduced pressure, the product residue was combined with a mixed solvent of toluene (20 mL), hexane (40 mL), and activated carbon (2.0 g) was added, and refluxed for 30 minutes. After removing insoluble matters by using Celite as a filter agent and distilling solvent under reduced pressure, the residue was recrystallized with toluene/acetonitrile to obtain Compound C-1 (1.85 g).

### Example 1-1: Synthesis of Polymeric Compound P-1

Under a nitrogen atmosphere, Compound M-1 (0.141 g) according to Synthesis Example 1, Compound C-1 (1.438 g) according to Synthesis Example 3, 2,7-dibromo-9,9-di-n-decylfluorene (hereinafter, also described as "Compound D-1," 0.941 g), dichlorobis[di-tert-butyl(p-dimethylaminophenyl)phosphine]palladium (II) (12.1 mg), toluene (50 mL), and a 20 mass% tetraethylammonium hydroxide aqueous solution (9.01 g) were added to a four-necked flask, and stirred at 85 °C for 2 hours. Subsequently, phenylboronic acid (211 mg), bis(triphenylphosphine)palladium(II) dichloride (73.6 mg), and a 20 mass% tetraethylammonium hydroxide aqueous solution (9.01 g) were added to the flask, and stirred at 85 °C for 6 hours. Then, sodium N,N-diethyldithiocarbamate trihydrate (5.91 g) dissolved in ion-exchange water (50 mL) was added to the flask, and stirred at 85 °C for 6 hours. Under the nitrogen atmosphere, after separating an organic layer and an aqueous layer, the organic layer was sequentially washed with ion-exchange water (50 mL×2), a saturated NH₄Cl aqueous solution (50 mL×5), and ion-exchange water (50 mL×2).

Upon addition of methanol to the washed organic layer the solid obtained was washed with methanol, filtered, and vacuum-dried. The dried solid was dissolved in toluene (20 mL), activated alumina (9.0 g) and Celite (4.5 g) were added to the toluene solution, and stirred at 90 °C for 1 hour, and the solid was filtered. Upon addition of methanol to the filtrate a solid precipitated, filtered and vacuum-dried. The obtained solid was dissolved in toluene (50 mL), an ion exchange resin (a mixture of 0.5 parts by weight of a cation exchange resin and 0.5 parts by weight of an anion exchange resin, 10 g) was added to the toluene solution, and stirred at room temperature for 12 hours. The ion exchange resin was filtered off, and a solid re-precipitated with methanol, and vacuum-dried to obtain a P-1 precursor (0.747 g).

Subsequently, P-1 precursor (0.730 g), a Dess-Martin reagent (648 mg), toluene (28 mL), and ion-exchange water (7 mL) were charged into a 2-necked flask, and stirred under a nitrogen atmosphere at room temperature for 12 hours. An organic layer was separated and added dropwise to methanol to precipitate a solid, which was vacuum-dried. The obtained solid was dissolved in toluene (50 mL), and an anion exchange resin (10 g) was added and stirred for 12 hours. The ion exchange resin was filtered off, the filtrate was added dropwise to methanol to precipitate a solid. The solid was filtered, dissolved in toluene, and the solution was added dropwise to methanol to precipitate a solid, which was filtered and dried to obtain Polymeric Compound P-1 (0.634 g). Polymeric Compound P-1 was measured with respect to a weight average molecular weight (Mw) and polydispersity (Mw/Mn) by SEC. As a result, Mw was 202,000 Da (Dalton), and Mw/Mn was 3.34.

Polymeric Compound P-1 was determined from an input ratio of monomers to have the following structural unit.

### (Polymeric Compound P-1)

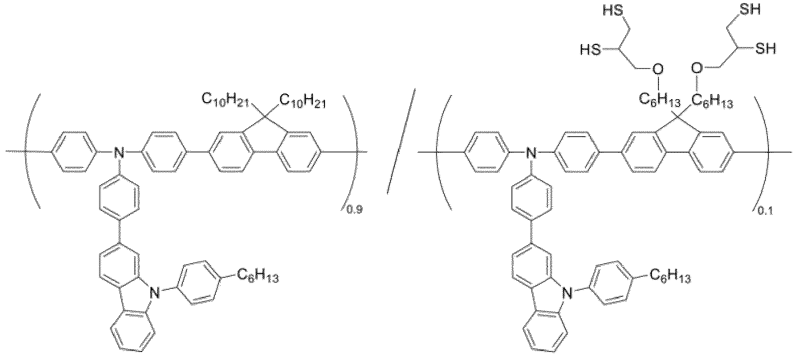

### Example 1-2: Synthesis of Polymeric Compound P-2

Under a nitrogen atmosphere, Monomer M-2 (0.111 g) according to Synthesis Example 2, Compound C-1 (1.434 g) according to Synthesis Example 3, 2,7-dibromo-9,9-di-n-decylfluorene (Compound D-1, 0.939 g), dichlorobis[di-tert-butyl(p-dimethylaminophenyl)phosphine]palladium(II) (12.3 mg), toluene (54 mL), and a 20 mass% tetraethylammonium hydroxide aqueous solution (8.99 g) were charged into a four-necked flask, and stirred at 85 °C for 2 hours. Subsequently, phenylboronic acid (211 mg), bis(triphenylphosphine)palladium(ll) dichloride (73.6 mg), and a 20 mass% tetraethylammoniumhydroxide aqueous solution (9.01 g) were added to the flask, and stirred at 85 °C for 6 hours. Then, a solution prepared by dissolving sodium N,N-diethyldithiocarbamate trihydrate (5.89 g) in ion-exchange water (50 mL) was added to the flask, and stirred at 85 °C for 6 hours. Under the nitrogen atmosphere, after separating an organic layer from the aqueous layer, the organic layer was sequentially washed with ion exchange water (50 mL×2), a saturated NH₄Cl aqueous solution (50 mL×5), and ion exchange water (50 mL×2).

Upon addition of methanol to the washed organic layer the solid obtained was washed with methanol, filtered, and vacuum-dried. The dried solid was dissolved in toluene (20 mL), activated alumina (9.0 g) and Celite (4.5 g) were added, stirred at 90 °C for 1 hour, and filtered. Upon addition of methanol to the filtrate therefrom a solid formed, which was filtered and vacuum-dried. The obtained solid was dissolved in toluene (50 mL), an ion exchange resin (a mixture of 0.5 parts by mass of a cation exchange resin and 0.5 parts by mass of an anion exchange resin, 10 g) was added and stirred at room temperature for 12 hours. The ion exchange resin was filtered off, a solid reprecipitated with methanol was obtained and vacuum-dried to obtain P-2 precursor (0.785 g).

Subsequently, P-2 precursor (0.730 g), a Dess-Martin reagent (365 mg), toluene (20 mL), and ion-exchange water (20 mL) were charged into a 2-neck flask, and stirred under a nitrogen atmosphere at room temperature for 12 hours. An organic layer obtained therefrom was added dropwise to methanol to precipitate a solid, which was filtered and vacuum-dried. The obtained solid was dissolved in toluene (50 mL), 10 g of an anion exchange resin was added thereto, and stirred for 12 hours. The ion exchange resin was filtered and the filtrate was added dropwise to methanol to precipitate a solid that was then dissolved in toluene. The solution was added dropwise to methanol to precipitate a solid, which was filtered and dried to obtain Polymeric Compound P-2 (0.491 g). Polymeric Compound P-2 was measured with respect to a weight average molecular weight (Mw) and polydispersity (Mw/Mn) by SEC. As a result, Mw was 277,000 Da, and Mw/Mn was 2.56.

Polymeric Compound P-2 was determined from an input ratio of monomers to have the following structural unit.

### (Polymeric Compound P-2)

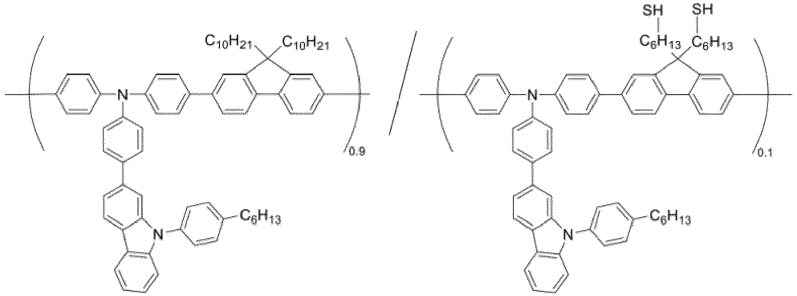

### Comparative Example 1-1: Synthesis of Polymeric Compound CP-1

As Polymeric Compound CP-1, poly[(9,9-dioctylfluoren-2,7-diyl)-co-(4,4'-(N-(4-sec-butylphenyl)diphenylamine)] (TFB, Luminescence Technology Corp.) having the following structural unit was prepared. TFB (Polymeric Compound CP-1) was measured with respect to a weight average molecular weight (Mw) and polydispersity (Mw/Mn) by SEC. As a result, Mw was 320,000 Da, and Mw/Mn was 3.70.

### (Polymeric Compound CP-1)

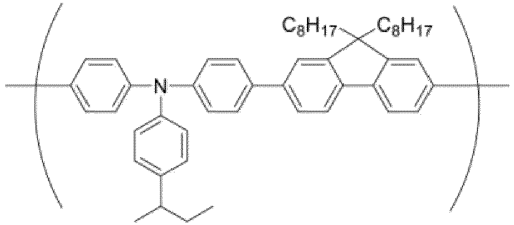

### Comparative Example 1-2: Synthesis of Polymeric Compound CP-2

Under an argon atmosphere, Compound C-1 (1.64 g) according to Synthesis Example 3, 2,7-dibromo-9,9-di-n-hexylfluorene (hereinafter, also described as "Compound D-2") (0.983 g), palladium acetate (4.5 mg), tris(2-methoxyphenyl)phosphine (42.2 mg), toluene (54 mL), and a 20 mass% tetraethylammonium hydroxide aqueous solution (10.2 g) were charged into a four-necked flask, and stirred at 85 °C for 6 hours. Subsequently, phenylboronic acid (241 mg), tetrakis(triphenylphosphino)palladium (84.1 mg), and a 20 mass% tetraethylammoniumhydroxide aqueous solution (10.2 g) were added to the flask, and stirred for 3 hours. Then, sodium N,N-diethyldithiocarbamate trihydrate (6.75 g) dissolved in 50 mL of ion-exchange water was added to the flask, and stirred at 85 °C for 2 hours. An organic layer was separated from an aqueous layer, and sequentially washed with water, a 3 mass% acetic acid aqueous solution, and water. The separated organic layer was added to a chromatography column charged with silica gel/alumina and the collected solution was partially reduced under vacuum. The obtained liquid was added dropwise to methanol to precipitate a solid that was then dissolved in toluene. Subsequently, this solution was added dropwise to methanol to precipitate a solid, which was filtered and dried to obtain Polymeric Compound CP-2 (0.930 g). Polymeric Compound CP-2 was measured with respect to a weight average molecular weight (Mw) and polydispersity (Mw/Mn) by SEC. As a result, Mw was 104,000 Da, and Mw/Mn was 2.04.

Polymeric Compound CP-2 is determined from an input ratio of monomers to have the following structural unit.

### (Polymeric Compound CP-2)

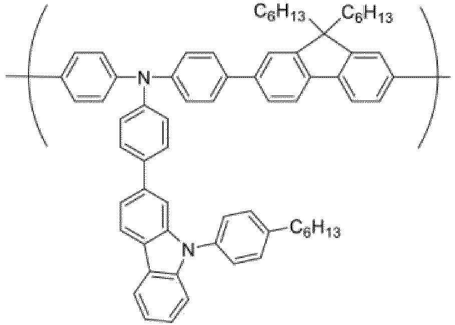

### Comparative Example 1-3: Synthesis of Polymeric Compound CP-3

Under a nitrogen atmosphere, Compound C-1 (1.49 g) according to Synthesis Example 3, 2,7-dibromo-9,9-di-n-decylfluorene (Compound D-1, 0.97 g), palladium acetate (3.6mg), tris(2-methoxyphenyl)phosphine (33.9 mg), toluene (54 mL), and a 20 mass% tetraethylammonium hydroxide aqueous solution (8.27 g) were charged into a four-necked flask, and stirred at 85 °C for 6 hours. Subsequently, phenylboronic acid (194 mg), bis(triphenylphosphine)palladium(II)dichloride (67.6 mg), a 20 mass% tetraethylammonium hydroxide aqueous solution (8.27 g), and sodium carbamate trihydrate (5.42 g) were added to the flask, and stirred at 85 °C for 2 hours. Afterward, an organic layer was separated from an aqueous layer, and washed with water. The washed organic layer was purified through column chromatography (a filling material: silica gel/alumina, an eluent: toluene), reprecipitated with toluene/methanol, and vacuum-dried to obtain Polymeric Compound CP-3 (1.17 g). Polymeric Compound CP-3 was measured with respect to a weight average molecular weight (Mw) and polydispersity (Mw/Mn) by SEC. As a result, Mw was 73,000 Da, and Mw/Mn was 1.40.

Polymeric Compound CP-3 obtained in this way was determined from an input ratio of monomers to have the following structural unit.

### Polymeric Compound CP-3

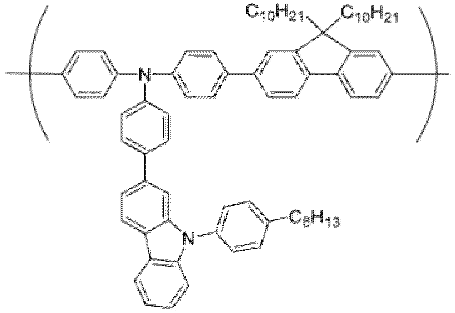

### Evaluation of Characteristics of Each Polymeric Compound

Polymeric Compounds P-1 and P-2 according to Examples 1-1 and 1-2 and Polymeric Compounds CP-1 to CP-3 according to Comparative Examples 1-1 to 1-3 were measured with respect to a glass transition temperature (Tg) (°C) in the following method. The results are shown in Table 1.

### Glass Transition Temperature (Tg)

The glass transition temperature (Tg) of each sample of the polymeric compounds was measured using differential scanning calorimetry (DSC) (Tradename: DSC6000, Seiko Instrument Inc.) by increasing a temperature to 300 °C at an increasing rate of 10 °C/min and maintaining the temperature at 300 °C for 10 minutes, decreasing the temperature to 25 °C at a decreasing rate of 10 °C/min and maintaining the temperature for 10 minutes, and then increasing the temperature to 300 °C for 10 minutes and measuring. After the measurement, the samples were cooled to room temperature (25 °C) at 10 °C/min.

**Table 1**

| | Polymeric compound (polymer) | Monomer input ratio (mol%) | Mw (Da) (Mw/Mn) | Tg (°C) |
|---|---|---|---|---|
| Ex. 1-1 | P-1 | C-1/ M-1/ D-1 (50/ 5/ 45) | 202,000 (3.34) | 126 |
| Ex. 1-2 | P-2 | C-1/ M-2/ D-1 (50/ 5/ 45) | 277,000 (2.56) | 126 |
| Comp. Ex. 1-1 | CP-1 (TFB) | - | 320,000 (3.70) | 156 |
| Comp. Ex. 1-2 | CP-2 | C-1/ D-2 (50/ 50) | 104,000 (2.04) | 184 |
| Comp. Ex. 1-3 | CP-3 | C-1/ D-1 (50/ 50) | 73,000 (1.40) | 128 |

### Example 2-1: Manufacturing of Quantum Dot Electroluminescence Device 1

As a first electrode (an anode), an ITO-attached glass substrate, on which indium tin oxide (ITO) was patterned to have a film thickness of 150 nm, was used. This ITO-attached glass substrate was sequentially washed with a neutral detergent, deionized water, water, and isopropylalcohol, and treated with UV-ozone. Subsequently, on this ITO-attached glass substrate, poly(3,4-ethylenedioxythiophene)/poly(4-styrenesulfonate)(PEDOT/PSS) (Sigma-Aldrich Co., Ltd.) was spin-coated to have a dry film thickness of 30 nm, and dried. As a result, a hole injection layer with a thickness (dry film thickness) of 30 nm was formed on the ITO-attached glass substrate.

On the hole injection layer, a toluene solution including 1.0 mass% of Polymeric Compound P-1 according to Example 1-1 (a hole transport material) was spin-coated to have a dry film thickness of 30 nm, and heat-treated at 230 °C for 60 minutes to form a hole transport layer. As a result, the hole transport layer with a thickness (dry film thickness) of 30 nm was formed on the hole injection layer.

A quantum dot dispersion was prepared by dispersing blue quantum dots of ZnTeSe/ZnSe/ZnS (core/shell/shell; an average diameter of about 10 nm) to be 1.0 mass% in cyclohexane. The hole transport layer, particularly, Polymeric Compound P-1, does not dissolve in the cyclohexane. The quantum dot dispersion was spin-coated on the hole transport layer to have a dry film thickness of 30 nm, and dried. As a result, a quantum dot light emitting layer having the thickness (dry film thickness) of 30 nm was formed on the hole transport layer. The light emitted by the quantum dot dispersion upon irradiation of ultraviolet rays has a central wavelength of 462 nm and a full width at half maximum (FWHM) of 30 nm.

The quantum dot light emitting layer was completely dried. On this quantum dot light emitting layer, (8-quinolinolato)lithium (lithium quinolate, Liq₈) and 1,3,5-tris(N-phenylbenzimidazole-2-yl)benzene (TPBI) (Sigma-Aldrich Co., Ltd.) as an electron transport material were co-deposited by using a vacuum deposition device. As a result, an electron transport layer with a thickness of 36 nm was formed on the quantum dot light emitting layer.

On the electron transport layer, (8-quinolinolato)lithium (lithium quinolate, Liq₈) was deposited by using the vacuum deposition device. As a result, a 0.5 nm-thick electron injection layer was formed on the electron transport layer.

On the electron injection layer, aluminum (Al) was deposited by using the vacuum deposition device. As a result, a 100 nm-thick second electrode (a cathode) was formed on the electron injection layer. In this way, Quantum Dot Electroluminescence Device 1 was obtained.

### Example 2-2: Manufacturing of Quantum Dot Electroluminescence Device 2

Quantum Dot Electroluminescence Device 2 was manufactured in the same manner as in Example 2-1, except that Polymeric Compound P-2 of Example 1-2 was used instead of Polymeric Compound P-1 of Example 2-1.

### Comparative Example 2-1: Manufacturing of Comparative Quantum Dot Electroluminescence Device 1

Comparative Quantum Dot Electroluminescence Device 1 was manufactured in the same manner as in Example 2-1, except that Polymeric Compound CP-1 of Comparative Example 1-1 was used instead of Polymeric Compound P-1 of Example 2-1.

### Comparative Example 2-2: Manufacturing of Comparative Quantum Dot Electroluminescence Device 2

Comparative Quantum Dot Electroluminescence Device 2 was manufactured in the same manner as in Example 2-1, except that Polymeric Compound CP-2 of Comparative Example 1-2 was used instead of Polymeric Compound P-1 of Example 2-1.

### Comparative Example 2-3: Manufacturing of Comparative Quantum Dot Electroluminescence Device 3

Comparative Quantum Dot Electroluminescence Device 3 was manufactured in the same manner as in Example 2-1, except that Polymeric Compound CP-3 of Comparative Example 1-3 was used instead of Polymeric Compound P-1 of Example 2-1.

### Evaluation of Electroluminescence Devices

Electroluminescence Devices 1 and 2 of Examples 2-1 and 2-2 and Comparative Electroluminescence Devices 1 to 3 of Comparative Examples 2-1 to 2-3 were evaluated with respect to luminous efficiency (EQE) and durability (LT50) in the following method. The results are shown in Table 2.

### Luminous efficiency (External Quantum Efficiency (EQE))

When a voltage was applied to each of the quantum dot electroluminescence devices, as a current began to flow at a predetermined voltage, the quantum dot electroluminescence devices emitted light. The voltage was slowly increased for each device by using a DC constant voltage power supply (a source meter, Keyence Corp.) to measure a current at this point, and in addition, a luminance meter (SR-3, Topcom Technology Cp., Ltd.) was used to measure luminance of the devices at the light emission. Herein, the luminance measurement was stopped at the point where the luminance started to attenuate.

In addition, a spectral radiance luminance spectrum measured by the luminance meter, assuming that Lambertian radiation was performed, was used to calculate maximum external quantum efficiency (EQEₘₐₓ) (%), which was used to evaluate the luminous efficiency.

A DC constant voltage power supply (a source meter, Keyence Corp.) was used to apply a predetermined voltage to each of the quantum dot electroluminescence devices resulting in light emission. Luminance of each device was measured by using a luminance meter (SR-3, Topcom) by slowly increasing the applied current. The device was then operated by maintaining the current constant when the luminance reached 650 nit (cd/m²). Over time the luminance of the device decreases and the amount of time taken to reach 50% of the initial luminance of the device was measured as "LT50 (hr).

**Table 2**

| | Polymeric Compound | Structural Unit (A): (B) | EQE max (%) | LT50 (hr) |
|---|---|---|---|---|
| Example 2-1 | P-1 | 10: 90 | 12.9 | 53.9 |
| Example 2-2 | P-2 | 10: 90 | 14.1 | 32.6 |
| Comparative Example 2-1 | CP-1 (TFB) | - | 9.2 | 12.0 |
| Comparative Example 2-2 | CP-2 | - | 9.5 | 18.9 |
| Comparative Example 2-3 | CP-3 | - | 8.7 | 37.0 |

Referring to the results of Table 2, Quantum Dot Electroluminescence Devices 1 and 2 of the examples, compared with Comparative Quantum Dot Electroluminescence Device 1 to 3 in the absence of polymeric compound according to an embodiment, confirmed that durability (significantly long luminescence life-span) and luminous efficiency were well balanced and compatible in the Device 1 and 2 Examples.

Comparative Quantum Dot Electroluminescence Device 3 includes a polymeric compound that includes only structural unit (B) with no thiol group (Comparative Example 2-3). Quantum Dot Electroluminescence Devices 1 and 2 include a structural unit (A) including a thiol group in addition to structural unit (B) (Examples 2-1 and 2-2). Examples 2-1 and 2-2 exhibited increased luminous efficiency (EQEₘₐₓ) and a satisfactory luminescence life-span (LT50). The quantum dot electroluminescence devices exhibit a sufficiently long luminescence life-span (LT50) and excellent luminous efficiency (EQEₘₐₓ), achieving satisfactory luminescence performance (balance between luminous efficiency and luminescence life-span) under operating conditions.

Although Comparative Examples 2-2 and 2-3 exhibit relatively excellent luminescence life-span (LT50), the two comparative devices exhibit a decrease in luminous efficiency (EQEₘₐₓ) of less than 10%. Accordingly, the quantum dot electroluminescence device according to an embodiment exhibited very excellent effect in terms of luminescence performance (balance between luminous efficiency and luminescence life-span) under operating conditions.

Although the above has been described with reference to embodiments, the present disclosure is not limited to specific embodiments, and various modifications and changes are possible within the scope of the invention described in the claims.

### <Description of symbols>

- 100: electroluminescence device (EL device)
- 110: substrate
- 120: first electrode
- 130: hole injection layer
- 140: hole transport layer
- 150: light emitting layer
- 160: electron transport layer
- 170: electron injection layer
- 180: second electrode

## Claims

1. A polymeric compound comprising a structural unit (A) represented by Chemical Formula 1: 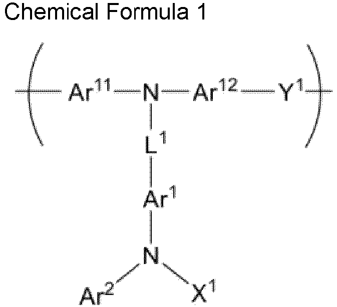 wherein, in Chemical Formula 1,
Ar¹¹ and Ar¹² are each independently a substituted or unsubstituted aromatic hydrocarbon group having 6 to 25 ring-forming atoms,
Ar¹¹ and Ar¹² are optionally linked to each other to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms,
Ar¹ and Ar² are optionally linked to each other to form a ring,
X¹ is a substituted or unsubstituted aromatic hydrocarbon group having 6 to 25 ring-forming atoms, or a substituted or unsubstituted heteroaromatic group having 5 to 25 ring-forming atoms, and
Y' is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms.

2. The polymeric compound of claim 1, wherein the structural unit (A) is represented by Chemical Formula 1-1: 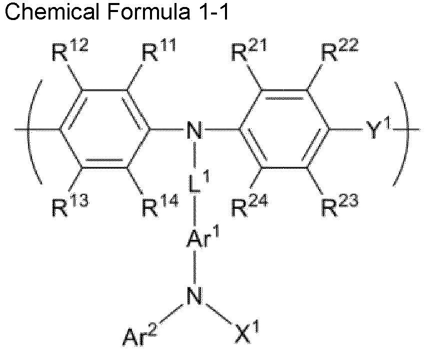 wherein, in Chemical Formula 1-1,
R¹¹ to R¹⁴ and R²¹ to R²⁴ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ are optionally bonded with each other to form a ring, and
L¹, Ar¹, Ar², X¹, and Y¹ are the same as defined in Chemical Formula 1.

3. The polymeric compound of claims 1 or 2, further comprising a structural unit (B) represented by Chemical Formula 2: 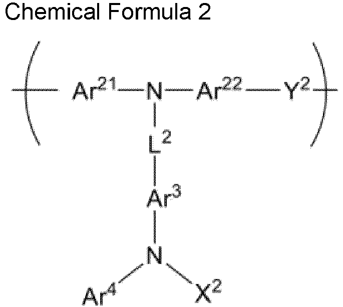 wherein, in Chemical Formula 2,
Ar²¹ and Ar²² are each independently a substituted or unsubstituted aromatic hydrocarbon group having 6 to 25 ring-forming atoms,
Ar²¹ and Ar²² are optionally linked to each other to form a ring,
L² is a substituted or unsubstituted aromatic hydrocarbon group having 6 to 25 ring-forming atoms, or a substituted or unsubstituted heteroaromatic group having 5 to 25 ring-forming atoms,
Ar³ is a substituted or unsubstituted aromatic hydrocarbon group having 6 to 25 ring-forming atoms,
Ar⁴ is a substituted or unsubstituted aromatic hydrocarbon group having 6 to 25 ring-forming atoms, or a substituted or unsubstituted hetetroaromatic group having 5 to 25 ring-forming atoms,
Ar³ and Ar⁴ are optionally linked to each other to form a ring,
X² is a substituted or unsubstituted aromatic hydrocarbon group having 6 to 25 ring-forming atoms, or a substituted or unsubstituted heteroaromatic group having 5 to 25 ring-forming atoms,
Y² is an aromatic hydrocarbon group having 6 to 25 ring-forming atoms unsubstituted or substituted with an alkyl group having 1 to 14 carbon atoms, and
Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.

4. The polymeric compound of claim 3, wherein the structural unit (B) is represented by Chemical Formula 2-1: 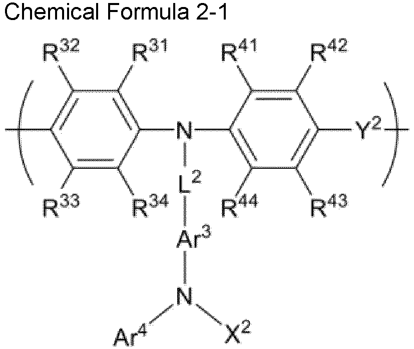 wherein, in Chemical Formula 2-1,
R³¹ to R³⁴ and R⁴¹ to R⁴⁴ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ are optionally bonded with each other to form a ring,
L², Ar³, Ar⁴, X², and Y² are the same as defined in Chemical Formula 2, and
R³¹ to R³⁴, R⁴¹ to R⁴⁴, L², Ar³, Ar⁴ and X² do not have a thiol group-containing alkyl group having 1 to 14 carbon atoms, and do not have a thiol group-containing alkoxyalkyl group having 2 to 14 carbon atoms.

5. The polymeric compound of claims 3 or 4, wherein the structural unit (A) is included in an amount of greater than or equal to 1 mol% and less than 30 mol% based on a total number of moles of the structural unit (A) and the structural unit (B) in the polymeric compound.

6. The polymeric compound of claims 3 or 5, wherein
Ar²¹ in Chemical Formula 2 is the same as Ar¹¹ in Chemical Formula 1,
Ar²² in Chemical Formula 2 is the same as Ar¹² in Chemical Formula 1,
L² in Chemical Formula 2 is the same as L¹ in Chemical Formula 1,
Ar³ in Chemical Formula 2 is the same as Ar¹ in Chemical Formula 1,
Ar⁴ in Chemical Formula 2 is the same as Ar² in Chemical Formula 1, and
X² in Chemical Formula 2 is the same as X¹ in Chemical Formula 1.

7. The polymeric compound of any of claims 1-6, wherein the Y' in Chemical Formula 1 is an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms, and wherein the thiol group-containing alkoxyalkyl group has a structure represented by Chemical Formula i-1:
Chemical Formula i-1 *-Z¹-O-Z²-SH
wherein, in Chemical Formula i-1,
Z¹ represents an alkylene group having 1 to 13 carbon atoms, substituted or unsubstituted with a thiol group,
Z² represents an alkylene group having 1 to 13 carbon atoms, substituted or unsubstituted with a thiol group,
a sum of the carbon number of the alkylene group represented by Z¹ and the carbon number of the alkylene group represented by Z² is an integer of 14 or less, and
* is bonded to a ring carbon of the aromatic hydrocarbon group having 6 to 25 ring-forming atoms.

8. The polymeric compound of any of claims 1-6, wherein the Y' in Chemical Formula 1 is an aromatic hydrocarbon group having 6 to 25 ring-forming atoms substituted with a thiol group-containing alkyl group having 1 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms, and wherein the thiol group-containing alkyl group has a structure represented by Chemical Formula i-2:
Chemical Formula i-2 *-Z¹-SH
wherein, in Chemical Formula i-2,
Z¹ represents an alkylene group having 1 to 14 carbon atoms, substituted or unsubstituted with a thiol group, and
* is bonded to a ring carbon of the aromatic hydrocarbon group having 6 to 25 ring-forming atoms.

9. The polymeric compound of any of claims 1-6, wherein the Y' in Chemical Formula 1 is an aromatic hydrocarbon group having 6 to 25 ring-forming atoms, substituted with a thiol group-containing alkoxyalkyl group having 2 to 14 carbon atoms;
preferably wherein the thiol group-containing alkoxyalkyl group has two or more thiol groups.

10. The polymeric compound of any of claims 1-6, wherein the Y' in Chemical Formula 1 is an aromatic hydrocarbon group having 6 to 25 ring-forming atoms, substituted with a thiol group-containing alkyl group having 1 to 10 carbon atoms.

11. The polymeric compound of any of claims 1-6, wherein the Y' in Chemical Formula 1 is one of the groups represented by Chemical Formulas (3-1) to (3-6): 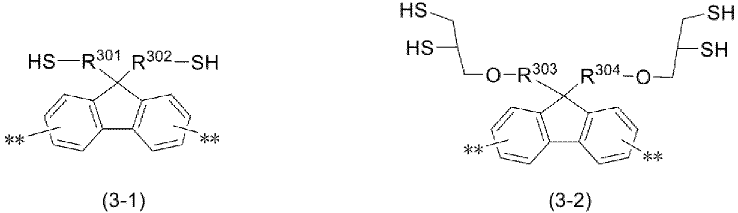 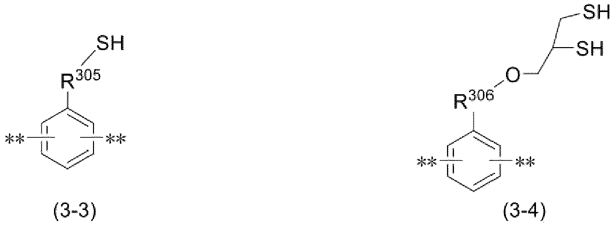 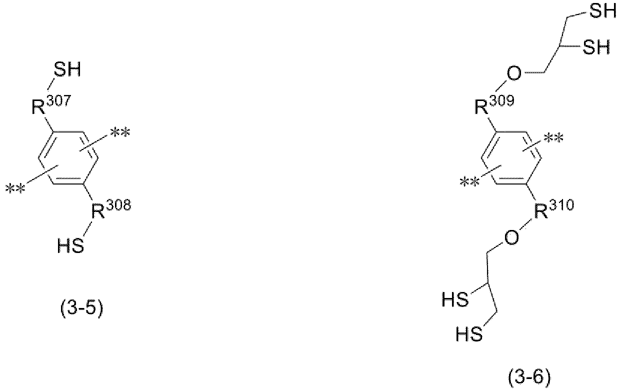 wherein, in Chemical Formulas 3-1 to 3-6,
R³⁰¹, R³⁰², R³⁰⁵, R³⁰⁷, and R³⁰⁸ are each independently a substituted or unsubstituted alkylene group having 1 to 14 carbon atoms,
R³⁰³, R³⁰⁴, R³⁰⁶, R³⁰⁹, and R³¹⁰ are each independently a substituted or unsubstituted alkylene group having 1 to 11 carbon atoms, and
** indicates a binding site;
preferably wherein Y' in Chemical Formula 1 is a group represented by Chemical Formula (3-1) or (3-2).

12. The polymeric compound of any of claims 1-11, wherein L¹ is any one of the groups represented by Chemical Formulas (4-1) to (4-24): 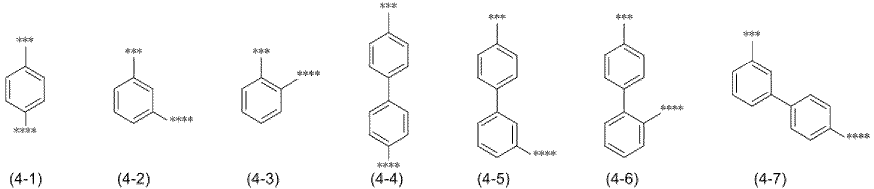 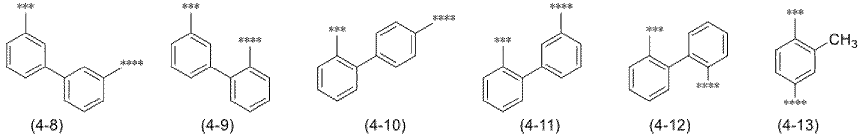 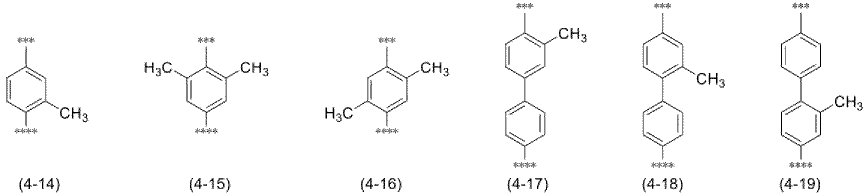 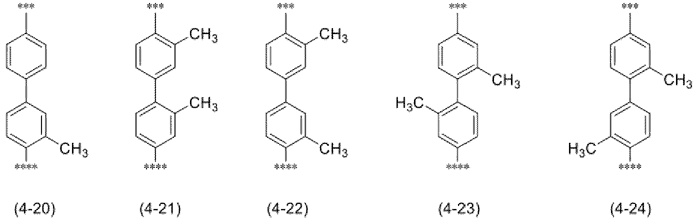 wherein, in Chemical Formulas 4-1 to 4-24,
*** indicates a position where it is bonded to the nitrogen atom, and
**** indicates a position where it is bonded to Ar¹; and/or
wherein in Chemical Formula 1,
-L¹-Ar¹-N(Ar²)(X¹) is any one of the groups represented by Chemical Formulas (5-1) to (5-3): 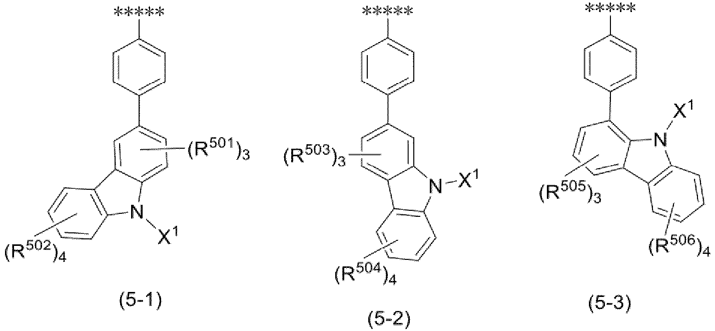 wherein, in Chemical Formulas (5-1) to (5-3),
R⁵⁰¹ to R⁵⁰⁶ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1, and
***** indicates a position where it is bonded to the nitrogen atom.

13. An electroluminescence device material comprising the polymeric compound of any of claims 1-12; or
a liquid composition comprising the polymeric compound of any of claims 1-12 and a solvent.

14. An electroluminescence device, comprising
a first electrode, a second electrode, and at least one layer of an organic film between the first electrode and the second electrode,
wherein the at least one layer of an organic film comprises the polymeric compound of any of claims 1-12;
preferably wherein the at least one layer of an organic film comprising the polymeric compound is a hole transport layer or a hole injection layer.

15. The electroluminescence device of claim 14, further comprising a light emitting layer including a semiconductor nanocrystal particle, a perovskite-type compound, or a combination thereof;
preferably wherein the light emitting layer and the at least one layer of an organic film comprising the polymeric compound are positioned adjacent to each other.
